# EUROPEAN PATENT APPLICATION

(11) **EP 4 801 242 A1**
(43) Date of publication of application: **02.09.2026**
(21) Application number: 24884031.6
(22) Date of filing: 11.07.2024
(51) Int. Cl.: H10K 39/10, H10K 30/40, H10K 30/50, H10K 71/12, H10K 85/50

(54) **PEROVSKITE-BASED LAMINATED SOLAR CELL AND PREPARATION METHOD THEREFOR, AND ELECTRIC DEVICE**

(30) Priority: 31.10.2023 CN 202311435187
(71) Applicant: Contemporary Amperex Technology Co., Limited, Ningde, Fujian 352100 (CN)
(72) Inventor: ZHANG, Zhiying, Ningde, Fujian 352100 (CN); ZHOU, Zichun, Ningde, Fujian 352100 (CN); HONG, Wanru, Ningde, Fujian 352100 (CN); SU, Shuojian, Ningde, Fujian 352100 (CN); CHEN, Guodong, Ningde, Fujian 352100 (CN); OUYANG, Chuying, Ningde, Fujian 352100 (CN)
(74) Representative: Gong, Jinping
(86) International application number: PCT/CN2024/104929
(87) International publication number: WO 2025/092023

(57) **Abstract**

The present application provides a perovskite-based laminated solar cell, comprising a first perovskite layer and a second perovskite layer which have different band gaps. The side surface of the first perovskite layer close to the second perovskite layer is a non-smooth surface in which recessed channels are formed, and ribs are formed between at least some of adjacent recessed channels. The laminated solar cell satisfies at least one of the following features: at least some of recessed channels have different widths in at least some of depth positions; and at least some of ribs have different widths in at least some of height positions.

## Description

### CROSS-REFERENCE TO RELATED APPLICATIONS

The present application claims priority to Chinese Patent Application No. CN2023114351873, filed on October 31, 2023 and entitled "PEROVSKITE-BASED TANDEM SOLAR CELL, PREPARATION METHOD, AND POWER CONSUMING APPARATUS", which is incorporated herein by reference in its entirety.

### TECHNICAL FIELD

The present application relates to the field of solar cell technologies, in particular, to a tandem solar cell, a preparation method, and a power consuming apparatus, and further to a perovskite-based tandem solar cell, a preparation method, and a power consuming apparatus.

### BACKGROUND

The statement herein merely provides background information related to the present application and does not necessarily constitute the related art.

Perovskite solar cells are apparatuses that convert solar energy into electrical energy by using a photoelectric conversion mechanism of perovskite-type crystalline materials. As the third-generation solar cells at present, the perovskite solar cells have multiple advantages such as high photoelectric conversion efficiency, simple manufacturing processes, and low production costs, and have been extensively studied in recent years. However, the improvement of photoelectric conversion efficiency of conventional single-junction perovskite solar cells is limited by theoretical limits. For tandem solar cells, absorption spectra of the solar cells may be expanded by superimposing semiconductors with different band gaps, thereby converting light energy into electrical energy to a greater extent. The tandem solar cells are an important way to overcome the Shockley-Queisser limit efficiency of single-junction cells and an important policy for improving the photoelectric conversion efficiency of solar cells in the future. For perovskite-based tandem solar cells, how to further improve a short-circuit current level of a device is one of the important research directions for improving device performance at present.

### SUMMARY

According to various embodiments and various examples of the present application, the present application provides a perovskite-based tandem solar cell, a preparation method, and a power consuming apparatus. The perovskite-based tandem solar cell includes a perovskite light-absorbing layer, which can provide a relatively high short-circuit current density and is additionally beneficial to improving photoelectric conversion efficiency.

According to a first aspect of the present application, a perovskite-based tandem solar cell is provided, including a first perovskite layer and a second perovskite layer with different band gaps. A surface of a side of the first perovskite layer close to the second perovskite layer is a non-smooth surface with grooves. Ridges are formed between at least some adjacent grooves. The tandem solar cell satisfies at least one of the following features: at least some of the grooves have different widths at at least some depth positions; and at least some of the ridges have different widths at at least some height positions.

In some embodiments, a perovskite-based tandem solar cell is provided. The perovskite-based tandem solar cell includes a first perovskite sub-cell, a carrier recombination layer, and a second perovskite sub-cell that are sequentially stacked. The first perovskite sub-cell includes a first perovskite layer. The second perovskite sub-cell includes a second perovskite layer. A band gap of the first perovskite layer is different from a band gap of the second perovskite layer.

A thickness direction of the first perovskite layer is denoted as a longitudinal direction.

A surface of a side of the first perovskite layer close to the carrier recombination layer is a non-smooth surface. The non-smooth surface is provided with grooves. Ridges are formed between at least some adjacent grooves.

The tandem solar cell satisfies at least one of the following features:
At least some of the grooves have different widths at at least some depth positions.

At least some of the ridges have different widths at at least some height positions.

By arranging perovskite light-absorbing layers with different band gaps in the tandem solar cell, photons in different wavelength ranges may be fully absorbed, thermal relaxation losses can be reduced, and the utilization rate of incident light can be improved. A non-smooth surface including grooves and ridges may be arranged on the surface of the side of the first perovskite layer close to the carrier recombination layer, so that the non-smooth surface and an adjacent surface of an adjacent structural layer form a strip-shaped concave-convex interface, which may be denoted as a first interface. When at least one of the two features "at least some of the grooves have different widths at at least some depth positions" and "at least some of the ridges have different widths at at least some height positions" is satisfied, at least some of the photons emitted to the first interface can undergo at least one of multiple refractions and multiple reflections at the first interface. For the photons emitted to the first interface, compared with the situation where photons only undergo a single reflection and/or refraction after contacting a conventional smooth interface, the non-smooth first interface in the present application may increase contact opportunities between the photons and the first interface, improve the probability of the photons being captured by the perovskite layers in the perovskite-based tandem solar cell, and enhance the light utilization efficiency. For photons that pass through the first perovskite layer without being absorbed and are emitted to the first interface, the probability of the photons entering the second perovskite layer can be increased, thereby increasing the number of photons in an absorbable wavelength range in the second perovskite layer. For photons that pass through the second perovskite layer still without being absorbed and are emitted to the first interface, the probability of entering the first perovskite layer can be increased, thereby increasing the number of photons in an absorbable wavelength range in the first perovskite layer. Therefore, the overall current level of the tandem solar cell can be improved, the short-circuit current density can be increased, and it is additionally beneficial to improving the photoelectric conversion efficiency.

Based on any suitable embodiment in the present application, in some further embodiments, morphologies of interfaces formed by different structural layers between the first perovskite layer and the second perovskite layer are substantially matched.

When the morphologies of the interfaces formed by different structural layers between the first perovskite layer and the second perovskite layer are substantially matched, the different structural layers respectively have uniform thicknesses. At this time, the surface of the side of the second perovskite layer close to the first perovskite layer may form a non-smooth surface with a similar morphology. Corresponding to a "concave-convex" interface on the surface of the first perovskite layer, a corresponding "convex-concave" interface (which may be denoted as the second interface) may be formed on the surface of the second perovskite layer. The second interface is also beneficial to increasing the number of photons in the absorbable wavelength ranges in the perovskite layers of the tandem solar cell and the light utilization efficiency, is beneficial to improving the overall current level of the tandem solar cell, and is also beneficial to enhancing the photoelectric conversion efficiency.

Based on any suitable embodiment in the present application, in some further embodiments, the tandem solar cell satisfies one or more of the following features:
A width of at least some of the ridges is 0.5 µm to 4 µm, further optionally 2 µm to 3.5 µm.

A half-height width of at least some of the ridges is 1 µm to 2.5 µm, optionally 1.5 µm to 2 µm.

A height of at least some of the ridges is greater than or equal to 100 nm, further optionally 100 nm to 250 nm.

Within at least some regions in the non-smooth surface, an average width of the ridges is 0.5 µm to 4 µm, further optionally 2 µm to 3.5 µm.

Within at least some regions in the non-smooth surface, an average half-height width of the ridges is 1 µm to 2.5 µm, optionally 1.5 µm to 2 µm.

Within at least some regions in the non-smooth surface, an average height of the ridges is 100 nm to 500 nm, optionally 100 nm to 250 nm.

Optionally, a projected area of at least some regions of the non-smooth surface along the longitudinal direction is greater than or equal to 0.1 mm², further optionally greater than or equal to 0.6 mm².

By adjusting one or more parameters among the width, half-height width, height of the ridges, and the average values of these parameters, the probability that photons emitted from the interior of the first perovskite layer toward the first interface are emitted after multiple reflections at a ridge interface of the first perovskite layer may be adjusted. Controlling one or more of the foregoing parameters within the foregoing ranges helps more photons be absorbed by the second perovskite layer and enhances the utilization efficiency of photons that pass through the first perovskite layer without being absorbed. These photons may include the photons in the absorbable wavelength range in the second perovskite layer, thereby better improving the short-circuit current density and, additionally, better improving the photoelectric conversion efficiency of the tandem solar cell. Photons emitted from the side of the first perovskite layer toward the first interface may come from external incident light.

Based on any suitable embodiment in the present application, in some further embodiments, the tandem solar cell satisfies one or more of the following features:

A width of at least some of the grooves is less than or equal to 1.2 µm, optionally 0.5 µm to 1 µm.

A half-height width of at least some of the grooves is less than or equal to 1 µm, optionally 0.2 µm to 0.7 µm.

A depth of at least some of the grooves is greater than or equal to 100 nm, further optionally 100 nm to 250 nm.

A depth-to-width ratio of at least some of the grooves is 0.03 to 0.5, further optionally 0.25 to 0.35.

Within at least some regions in the non-smooth surface, an average width of the grooves is 0.3 µm to 1 µm, optionally 0.5 µm to 1 µm.

Within at least some regions in the non-smooth surface, an average half-height width of the grooves is 0.2 µm to 0.7 µm, optionally 0.3 µm to 0.55 µm.

Within at least some regions in the non-smooth surface, an average depth of the grooves is 100 nm to 500 nm, optionally 100 nm to 250 nm.

Within at least some regions in the non-smooth surface, an average depth-to-width ratio of the grooves is 0.03 to 0.5, further optionally 0.25 to 0.35.

Optionally, a projected area of at least some regions of the non-smooth surface along the longitudinal direction is greater than or equal to 0.1 mm², further optionally greater than or equal to 0.6 mm².

By adjusting one or more parameters among the width, half-height width, depth, and depth-to-width ratio of the grooves, and the average values of these parameters, the probability that photons emitted from the side of the second perovskite layer toward the first interface enter the first perovskite layer at a groove interface of the first perovskite layer may be adjusted. Controlling one or more of the foregoing parameters within the foregoing ranges significantly increases an optical path of photons that are reflected by the interface of the second perovskite layer and remain unabsorbed in the first perovskite layer, and the photons may be more absorbed by the first perovskite layer. These photons may include the photons in the absorbable wavelength range in the first perovskite layer, thereby improving light utilization efficiency, which in turn better improves the overall current level and the photoelectric conversion efficiency of the tandem solar cell. Photons emitted from the side of the second perovskite layer toward the first interface may come from reflected light at the second electrode.

By comprehensively adjusting the width and length of the grooves, a proportion of a longitudinal projected area of the grooves in a longitudinal projected area of the first perovskite layer may be adjusted. A higher proportion indicates a more significant comprehensive improvement effect of the grooves on the overall current level and photoelectric conversion efficiency. The longitudinal projected area of the first perovskite layer may be numerically regarded as being substantially equal to a longitudinal projected area of the non-smooth surface. Therefore, the proportion of the longitudinal projected area of the grooves in the longitudinal projected area of the first perovskite layer is numerically substantially equal to a percentage of a sum of projected areas of the grooves along the longitudinal direction relative to a projected area of the non-smooth surface along the longitudinal direction.

Based on any suitable embodiment in the present application, in some further embodiments, the tandem solar cell satisfies one or more of the following features:

Within at least some regions in the non-smooth surface, an average spacing of the ridges is 1 µm to 20 µm, optionally 10 µm to 20 µm.

Within at least some regions in the non-smooth surface, an average spacing of the grooves is 1 µm to 20 µm, optionally 10 µm to 20 µm.

A half-height width of at least some of the ridges is greater than a half-height width of an adjacent groove.

Within at least some regions in the non-smooth surface, a ratio of the average half-height width of the ridges to the average half-height width of the grooves is 1 to 6, further optionally 4 to 5.

Within at least some regions in the non-smooth surface, a ratio of a sum of areas of half-height cross-sections of the ridges to a sum of areas of half-height cross-sections of the grooves is 1 to 36, further optionally 10 to 30.

Within at least some regions in the non-smooth surface, a percentage of a sum of projected areas of the grooves along the longitudinal direction relative to a projected area of the non-smooth surface along the longitudinal direction is 5% to 95%, further optionally 5% to 50%.

Optionally, a projected area of at least some regions of the non-smooth surface along the longitudinal direction is greater than or equal to 0.1 mm², further optionally greater than or equal to 0.6 mm².

By adjusting one or more parameters including the average spacing of the ridges, the average spacing of the grooves, the ratio of the average half-height width of the ridges to the average half-height width of the grooves, and the ratio of the sum of the areas of the half-height cross-sections of the ridges to the sum of the areas of the half-height cross-sections of the grooves, the density of the grooves and/or the ridges on the non-smooth surface of the first perovskite layer may be adjusted, and the unevenness of the non-smooth surface may be adjusted, thereby adjusting the degree of improvement in the photoelectric conversion effect. Controlling one or more of these parameters within the foregoing ranges allows a concave-convex morphology of the first interface to fully function, enabling the first perovskite layer and/or the second perovskite layer to absorb more photons, which is more beneficial to improving the short-circuit current density and, additionally, better improving the photoelectric conversion efficiency. When external incident light enters from the first electrode, controlling the half-height width of at least some of the ridges to be greater than the half-height width of adjacent grooves is beneficial for more photons that are not utilized by the first perovskite layer among photons initially emitted to the first interface to enter the second perovskite layer.

Based on any suitable embodiment in the present application, in some further embodiments, an opening width of at least some of the grooves is greater than a bottom width thereof.

Optionally, based on a proportion of the projected areas of the grooves along the longitudinal direction, an opening width of at least 50% of the grooves is greater than a bottom width thereof. Further optionally, an opening width of at least 80% of the grooves is greater than a bottom width thereof.

Optionally, based on a proportion of the projected areas of the grooves along the longitudinal direction, an opening width of at least some of the grooves is greater than a half-height width thereof, which in turn is greater than a bottom width thereof. Further optionally, an opening width of at least 50% of the grooves is greater than a half-height width thereof, which in turn is greater than a bottom width thereof. Still further optionally, an opening width of at least 80% of the grooves is greater than a half-height width thereof, which in turn is greater than a bottom width thereof.

When the grooves have an overall cross-section "wider at the top and narrower at the bottom", the opening width of the grooves is greater than the bottom width. Further, the opening width is greater than a half-height width thereof, which in turn is greater than a bottom width thereof, thereby being beneficial to increasing the number of photons entering the first perovskite layer, correspondingly improving light absorption, better improving the short-circuit current density, and being additionally beneficial to better improving the photoelectric conversion efficiency.

Based on any suitable embodiment in the present application, in some further embodiments, a bottom width of at least some of the ridges is greater than a top width thereof.

Optionally, based on a proportion of the projected areas of the ridges along the longitudinal direction, a bottom width of at least 50% of the ridges is greater than a top width thereof. Further optionally, a bottom width of at least 80% of the ridges is greater than a top width thereof.

Optionally, based on a proportion of the projected areas of the ridges along the longitudinal direction, a bottom width of at least some of the ridges is greater than a half-height width thereof, which in turn is greater than a top width thereof. Further optionally, a bottom width of at least 50% of the ridges is greater than a half-height width thereof, which in turn is greater than a top width thereof. Still further optionally, a bottom width of at least 80% of the ridges is greater than a half-height width thereof, which in turn is greater than a top width thereof.

When the ridges have an overall cross-section "narrower at the top and wider at the bottom", the bottom width of the ridges is greater than the top width. Further, the bottom width is greater than the half-height width, which in turn is greater than a top width thereof, thereby being beneficial to increasing the number of photons entering the second perovskite layer, correspondingly improving light absorption, better improving the short-circuit current density, and being additionally beneficial to better improving the photoelectric conversion efficiency.

Based on any suitable embodiment in the present application, in some further embodiments, the tandem solar cell satisfies one or more of the following features:
At least some of the grooves have a corner in an extending direction thereof.

At least some of the grooves have at least one segment of non-straight line in an extending direction thereof.

At least some of the grooves have an intersection node therebetween.

At least some of the ridges have a corner in an extending direction thereof.

At least some of the ridges have at least one segment of non-straight line in an extending direction thereof.

At least some of the ridges have an intersection node therebetween.

A deviation of a maximum width within an extending length of at least some of the grooves relative to an average width of the grooves does not exceed 30%.

A deviation of a maximum width within an extending length of at least some of the ridges relative to an average width of the ridges does not exceed 30%.

An extending length of at least some of the grooves is greater than or equal to 50 µm.

An extending length of at least some of the ridges is greater than or equal to 50 µm.

A length-to-width ratio of at least some of the grooves is greater than or equal to 2. Optionally, a length-to-width ratio of at least some of the grooves is greater than or equal to 5.

A length-to-width ratio of at least some of the grooves is 1 to 10, optionally 5 to 10.

A length-to-width ratio of at least some of the ridges is greater than or equal to 2. Optionally, a length-to-width ratio of at least some of the ridges is greater than or equal to 5.

A length-to-width ratio of at least some of the ridges is 1 to 20, optionally 10 to 20.

When at least some of the grooves have one or more of the following characteristics in the extending direction: (1) the grooves have a corner in the extending direction thereof; (2) the grooves have at least one segment of non-straight line in the extending direction thereof; and (3) the grooves have intersection nodes, the grooves are more likely to present a random distribution on the non-smooth surface of the first perovskite layer. This is beneficial to shortening a transport distance of photons between two consecutive contacts with the first interface at the grooves, improving the transport efficiency of photons, and thus better increasing the short-circuit current density and photoelectric conversion efficiency. The presence of intersection nodes between different grooves means that the extending directions of these grooves are non-parallel or not completely parallel, enabling different grooves to be communicated.

When at least some of the ridges have one or more of the following characteristics in the extending direction: (1) the ridges have a corner in the extending direction thereof; (2) the ridges have at least one segment of non-straight line in the extending direction thereof; and (3) the ridges have intersection nodes, the ridges are more likely to present a random distribution on the non-smooth surface of the first perovskite layer. This is beneficial to shortening a transport distance of photons between two consecutive contacts with the first interface at the ridge interface, improving the transport efficiency of photons, and thus better increasing the light short-circuit current density and electric conversion efficiency. The presence of intersection nodes between different ridges means that the extending directions of these ridges are non-parallel or not completely parallel, enabling different ridges to be connected.

When the grooves and the ridges respectively satisfy at least one of the foregoing features, it is beneficial to more effectively exerting the cooperation effect between the grooves and the ridges, while increasing the number of photons and light absorption in the first perovskite layer and the second perovskite layer, better improving the short-circuit current density and, additionally, better improving the photoelectric conversion efficiency.

Based on any suitable embodiment in the present application, in some further embodiments, the tandem solar cell satisfies one or more of the following features:

An angle between extending directions of at least some two adjacent grooves in an extending length region of at least 30 µm is less than or equal to 30°.

An angle between extending directions of at least some two adjacent ridges in an extending length region of at least 30 µm is less than or equal to 30°.

Based on any suitable embodiment in the present application, in some further embodiments, the tandem solar cell satisfies one or more of the following features:

An angle between extending directions of at least some two adjacent grooves in an extending length of at least 30 µm is less than or equal to 15°. Optionally, an angle between extending directions of at least some two adjacent grooves in an extending length of at least 50 µm is less than or equal to 15°. Further optionally, an angle between extending directions of at least some two adjacent grooves in an extending length of at least 80 µm is less than 15°.

An angle between extending directions of at least some two adjacent grooves in an extending length of at least 50 µm is less than or equal to 30°. Optionally, an angle between extending directions of at least some two adjacent grooves in an extending length of at least 80 µm is less than 30°.

An angle between extending directions of at least some two adjacent ridges in an extending length of at least 30 µm is less than or equal to 15°. Optionally, an angle between extending directions of at least some two adjacent ridges in an extending length of at least 50 µm is less than or equal to 15°. Further optionally, an angle between extending directions of at least some two adjacent ridges in an extending length of at least 80 µm is less than 15°.

An angle between extending directions of at least some two adjacent ridges in an extending length of at least 50 µm is less than or equal to 30°. Optionally, an angle between extending directions of at least some two adjacent ridges in an extending length of at least 80 µm is less than 30°.

By adjusting the angle between the extending directions of two adjacent grooves, the regularity of the grooves in the non-smooth surface of the first perovskite layer may be adjusted. A smaller angle reflects more consistent extending directions of the two adjacent grooves, and a better parallelism. A smaller angle between the extending directions indicates a larger extending length, a higher regularity of the grooves, and a better parallelism between the two adjacent grooves.

By adjusting the angle between the extending directions of two adjacent ridges, the regularity of the ridges in the non-smooth surface of the first perovskite layer may be adjusted. A smaller angle reflects more consistent extending directions of the two adjacent ridges, and a better parallelism. A smaller angle between the extending directions indicates a larger extending length, a higher regularity of the ridges, and a better parallelism between the two adjacent ridges.

When the grooves and the ridges respectively satisfy at least one of the foregoing features, the functions of both the grooves and the ridges may be effectively exerted.

Based on any suitable embodiment in the present application, in some further embodiments, the band gap of the first perovskite layer is greater than the band gap of the second perovskite layer.

Optionally, the band gap of the first perovskite layer is 1.2 eV to 2.4 eV, optionally 1.6 eV to 2.3 eV. The band gap of the second perovskite layer is 1.0 eV to 1.4 eV.

By adjusting the band gaps of the perovskite layers, the wavelength ranges of absorbable photons in the perovskite layers may be adjusted. When the band gaps of the first perovskite layer and the second perovskite layer are respectively controlled within the foregoing ranges, it is beneficial to better broadening the absorbable wavelength range of incident light. Combined with a special morphology of the first interface, the first perovskite layer and the second perovskite layer as a whole may achieve a higher total light absorption amount and light utilization rate, thereby better improving the photoelectric conversion efficiency and short-circuit current density.

Based on any suitable embodiment in the present application, in some further embodiments, the first perovskite layer includes a first perovskite-type metal halide. A halogen in the first perovskite-type metal halide includes bromine and iodine. Optionally, the halogen in the first perovskite-type metal halide is a combination of bromine and iodine.

Optionally, the second perovskite layer includes a second perovskite-type metal halide. A halogen in the second perovskite-type metal halide includes iodine. Further optionally, the halogen in the second perovskite-type metal halide is iodine.

According to the component design of the perovskite-type metal halide in the first perovskite layer, bromine and iodine may be incorporated into the perovskite precursor solution simultaneously. By adjusting an atomic molar ratio of the two elements, various parameters may be adjusted, including: size-related parameters of the grooves and the ridges (e.g., length, width, depth or height, depth-to-width ratio or height-to-width ratio, half-height width, half-height cross-section, and an average value of any of the foregoing parameters), distribution-related parameters (e.g., average spacing, proportion calculation of projected areas of the grooves or the ridges on the non-smooth surface, ratio of an average half-height width of the ridges to an average half-height width of the grooves, and ratio of a sum of areas of the half-height cross-sections of the ridges to a sum of areas of the half-height cross-sections of the grooves), thereby flexibly adjusting the enhancement effect of the concave-convex interface on short-circuit current density and photoelectric conversion efficiency.

Furthermore, by adjusting the halogen components of the perovskite-type metal halides in the first perovskite layer and the second perovskite layer, a band gap difference between two light-absorbing layers and the morphology of a first interface may be adjusted, thereby broadening the absorbable wavelength range of incident light, promoting more photons to enter the perovskite layers in the tandem solar cell through the first interface, and improving the comprehensive performance of short-circuit current density and photoelectric conversion efficiency.

Based on any suitable embodiment in the present application, in some further embodiments, an atomic molar ratio of bromine to iodine in the first perovskite-type metal halide is (3-y):y, where 0<y≤2. Optionally, 1≤y≤2.

According to the component design of the perovskite-type metal halide in the first perovskite layer, the atomic molar ratio of bromine to iodine in the perovskite precursor solution may be adjusted, thereby adjusting the comprehensive performance of the short-circuit current density and photoelectric conversion efficiency of the tandem solar cell. By adjusting the atomic molar ratio of bromine to iodine in the perovskite-type metal halide of the first perovskite layer within the foregoing range, the short-circuit current density of the tandem solar cell can be improved effectively, and the photoelectric conversion efficiency can be improved.

Based on any suitable embodiment in the present application, in some further embodiments, at least some perovskite grains in the first perovskite layer are through-type grains. Both ends of the through-type grains along the longitudinal direction are located on surfaces of two sides of the first perovskite layer respectively.

When the perovskite grains in the first perovskite layer include through-type grains along the thickness direction (i.e., the longitudinal direction) of the first perovskite layer, it means that these perovskite grains grow continuously in the longitudinal direction. There are few cracks in the longitudinal cross-section of the first perovskite layer, and the grains appear as large-sized grains that run through longitudinally. At this time, the through-type grains that run through the first perovskite layer along the longitudinal direction are beneficial to smoother and more efficient carrier transport, reducing non-radiative recombination caused by grain interfaces, and improving the short-circuit current density and photoelectric conversion efficiency of a device.

Based on any suitable embodiment in the present application, in some further embodiments, a lateral dimension of at least some of the through-type grains is greater than or equal to 400 nm, where a lateral direction is orthogonal to the longitudinal direction. The lateral dimension of the through-type grains refers to a maximum dimension among dimensions in all directions of the grains in a lateral cross-section.

Optionally, a lateral dimension of at least some of the through-type grains is greater than or equal to 400 nm, optionally greater than or equal to 500 nm.

Optionally, an average lateral dimension of the through-type grains is 300 nm to 2 µm, optionally 400 nm to 1 µm, and further optionally 500 nm to 800 nm.

By controlling the lateral dimension of the through-type grains, the number of interfaces between the perovskite grains may be adjusted. A larger lateral dimension indicates fewer through-seams between grains, which in turn results in fewer defects and higher quality of the perovskite layers. When the lateral dimension of the through-type grains is controlled within the foregoing range, it is beneficial to fully exerting the promoting effect of the aforementioned through-type grains.

Based on any suitable embodiment in the present application, in some further embodiments, within at least some width regions of the longitudinal cross-section of the first perovskite layer, an area percentage of the through-type grains relative to the longitudinal cross-section is greater than or equal to 80%, optionally greater than or equal to 90%.

Optionally, at least some width regions of the longitudinal cross-section of the first perovskite layer correspond to a width region of at least 10 µm.

By controlling the area percentage of the through-type grains in the longitudinal cross-section of the first perovskite layer, the effect exertion of the through-type grains may be adjusted. When the area percentage of the through-type grains relative to the longitudinal cross-section of the first perovskite layer is controlled within the foregoing range, it is beneficial to more fully exerting the advantages of the through-type grains, and more beneficial to the improvement of carrier transport and photoelectric conversion efficiency.

Based on any suitable embodiment in the present application, in some further embodiments, in the longitudinal cross-section of the first perovskite layer, an area percentage of the through-type grains with a lateral dimension greater than or equal to 400 nm relative to the longitudinal cross-section is greater than or equal to 80%, optionally greater than or equal to 90%.

By controlling the area ratio of large-sized through-type grains in the longitudinal cross-section of the first perovskite layer, the effect exertion of the through-type grains may be adjusted. When the area percentage of through-type grains with a certain lateral dimension relative to the longitudinal cross-section of the first perovskite layer is controlled within the foregoing range, it is beneficial to more fully exerting the advantages of the through-type grains, and more beneficial to the improvement of carrier transport and photoelectric conversion efficiency.

Based on any suitable embodiment in the present application, in some further embodiments, the tandem solar cell satisfies one or more of the following features:
Both a first carrier transport layer and a third carrier transport layer are electron transport layers, and both a second carrier transport layer and a fourth carrier transport layer are hole transport layers. Alternatively, both the first carrier transport layer and the third carrier transport layer are hole transport layers, and both the second carrier transport layer and the fourth carrier transport layer are electron transport layers.

The tandem solar cell further includes a first electrode and a second electrode. The first electrode is located on a side of the first perovskite sub-cell away from the carrier recombination layer. The second electrode is located on a side of the second perovskite sub-cell away from the carrier recombination layer. The first electrode is a transparent electrode.

At least one side of the first carrier transport layer includes a heterogeneous carrier blocking layer.

At least one side of the second carrier transport layer includes a heterogeneous carrier blocking layer.

At least one side of the third carrier transport layer includes a heterogeneous carrier blocking layer.

At least one side of the fourth carrier transport layer includes a heterogeneous carrier blocking layer.

Both the first perovskite sub-cell and the second perovskite sub-cell may be of an n-i-p type or a p-i-n type.

When the first electrode is a transparent electrode, incident light entering the tandem solar cell may enter from the side of the first electrode. At this time, when the incident light is first emitted to the first interface from the side of the first perovskite layer, the first interface is beneficial to exerting the aforementioned effect of improving the comprehensive performance of short-circuit current density and photoelectric conversion efficiency.

Furthermore, the heterogeneous carrier blocking layer may be arranged on at least one side of one or more carrier transport layers among the first carrier transport layer, the second carrier transport layer, the third carrier transport layer, and the fourth carrier transport layer, to block the transport of heterogeneous carriers, thereby helping to reduce the recombination probability of electrons-holes.

Based on any suitable embodiment in the present application, in some further embodiments, the first perovskite sub-cell and the second perovskite sub-cell form a two-terminal integrated structure.

Based on any suitable embodiment in the present application, in some further embodiments, the tandem solar cell is a two-terminal tandem solar cell.

Based on any suitable embodiment in the present application, in some further embodiments, the tandem solar cell is an all-perovskite tandem solar cell.

According to a second aspect of the present application, a preparation method for a perovskite-based tandem solar cell according to the first aspect of the present application is provided, including the following steps: sequentially stacking a first carrier transport layer, a first perovskite layer, a second carrier transport layer, a carrier recombination layer, a third carrier transport layer, a second perovskite layer, a fourth carrier transport layer, and a second electrode on a surface of one side of a first electrode, to obtain the perovskite-based tandem solar cell.

A method for stacking the first perovskite layer on a side of the first carrier transport layer away from the first electrode includes the following steps:
coating a precursor solution I of the first perovskite layer onto a surface of the side of the first carrier transport layer away from the first electrode, to form a coating layer I; and
performing vacuum flash evaporation treatment and annealing treatment on the coating layer I to form the first perovskite layer, with the non-smooth surface formed on the side of the first perovskite layer away from the first electrode.

The first perovskite layer is prepared via a vacuum flash evaporation process. The aforementioned groove and ridge morphologies may be formed on the surface of the side of the first perovskite layer close to the carrier recombination layer, thereby increasing the amount of photons in contact with the perovskite layers and light utilization efficiency, improving the short-circuit current density of the tandem solar cell, and also improving the photoelectric conversion efficiency. Furthermore, the formation of large-sized through-type grains may be promoted, and the carrier transport and the photoelectric conversion efficiency may be promoted.

Based on any suitable embodiment in the present application, in some further embodiments, the preparation method for the perovskite-based tandem solar cell satisfies one or more of the following features:
The vacuum flash evaporation treatment is performed under a negative pressure. The negative pressure is less than or equal to 100 Pa, optionally 50 Pa to 100 Pa.

A temperature for the vacuum flash evaporation treatment is -10°C to 100°C, optionally 0°C to 30°C, and further optionally 20°C to 30°C.

A duration of the vacuum flash evaporation treatment is 10 s to 100 s, optionally 10 s to 30 s, and further optionally 15 s to 25 s.

The annealing treatment is performed using a hot stage, optionally a hot stage at 30°C to 200°C, further optionally a hot stage at 90°C to 110°C, and still further optionally a hot stage at 98°C to 102°C.

An annealing duration of the annealing treatment is 30 s to 60 min, optionally 5 min to 20 min, and further optionally 14 min to 16 min.

Based on any suitable embodiment in the present application, in some further embodiments, the step of coating a precursor solution I of the first perovskite layer onto a surface of the side of the first carrier transport layer away from the first electrode includes:
spin-coating a portion of the precursor solution I onto the surface of the side of the first carrier transport layer away from the first electrode at a first rotational speed; and
increasing a rotational speed from the first rotational speed to a second rotational speed, and continuing to spin-coat another portion of the precursor solution I at the second rotational speed.

The second rotational speed is greater than the first rotational speed.

Based on any suitable embodiment in the present application, in some further embodiments, the preparation method for the perovskite-based tandem solar cell satisfies one or more of the following features:
The first rotational speed is 1000 rpm to 6000 rpm, optionally 1000 rpm to 2000 rpm. Spin-coating is performed at the first rotational speed for 8 s to 12 s.

In the step of increasing the rotational speed from the first rotational speed to the second rotational speed, an acceleration is 200 rpm/s to 2000 rpm/s, optionally 800 rpm/s to 1200 rpm/s.

The second rotational speed is 3000 rpm to 4500 rpm, optionally 3800 rpm to 4200 rpm. Spin-coating is performed at the second rotational speed for 18 s to 22 s.

By adjusting one or more parameters in the preparation process of the first perovskite layer, the surface morphology and/or grain size of the first perovskite layer may be adjusted as needed. This optimization of process parameters enables better improvement of the comprehensive performance of the tandem solar cell, including short-circuit current density and photoelectric conversion efficiency.

According to a third aspect of the present application, a power consuming apparatus is provided, including at least one of the perovskite-based tandem solar cell according to the first aspect of the present application and the perovskite-based tandem solar cell prepared using the preparation method for a perovskite-based tandem solar cell according to the second aspect of the present application.

Details of one or more embodiments and examples according to the present application are provided in the accompanying drawings and descriptions below. Other features, objects, and advantages of the present application will become apparent from the specification, the accompanying drawings, and the claims.

### BRIEF DESCRIPTION OF THE DRAWINGS

To better describe and illustrate embodiments, examples, or instances of those applications disclosed herein, reference may be made to one or more accompanying drawings. However, additional details or instances for describing the accompanying drawings should not be regarded as limitations to the scopes of any one of the applications disclosed, the embodiments, examples, or instances described for the present, and the most modes of these applications understood for the present. In addition, in all the accompanying drawings, same parts are indicated by the same reference numerals. In the accompanying drawings:
FIG. 1 is an optical microscope image of a non-smooth surface of a first perovskite layer in an embodiment of the present application;
FIG. 2 is a schematic diagram of a transport path of incident light at a non-smooth surface of a first perovskite layer in an embodiment of the present application;
FIG. 3 is an optical microscope image of a tandem solar cell from a glass substrate side in an embodiment of the present application, where a transparent electrode is arranged on a surface of the glass substrate close to a carrier recombination layer;
FIG. 4 is a scanning electron microscope (SEM) image of a longitudinal cross-section of a tandem solar cell prepared by a vacuum flash evaporation method in an embodiment of the present application;
FIG. 5 is an SEM image of a longitudinal cross-section of a tandem solar cell prepared by a vacuum flash evaporation method in an embodiment of the present application;
FIG. 6 is an SEM image of a lateral cross-section of a wide-band gap perovskite layer prepared by a vacuum flash evaporation method in an embodiment of the present application;
FIG. 7 is a schematic diagram of a transport path of incident light at an interface between a wide-band gap perovskite layer and an intermediate interconnection layer in a comparative example of the present application, where the wide-band gap perovskite layer in this comparative example is prepared by an anti-solvent method;
FIG. 8 is an optical microscope image of an all-perovskite tandem solar cell from a glass substrate side in a comparative example of the present application, where a transparent electrode is arranged on a surface of the glass substrate close to a carrier recombination layer;
FIG. 9 is an SEM image of a longitudinal cross-section of a tandem solar cell prepared by an anti-solvent method in a comparative example of the present application;
FIG. 10 is a schematic diagram of a tandem solar cell in an embodiment of the present application, including a first perovskite sub-cell, a carrier recombination layer, and a second perovskite sub-cell that are sequentially stacked;

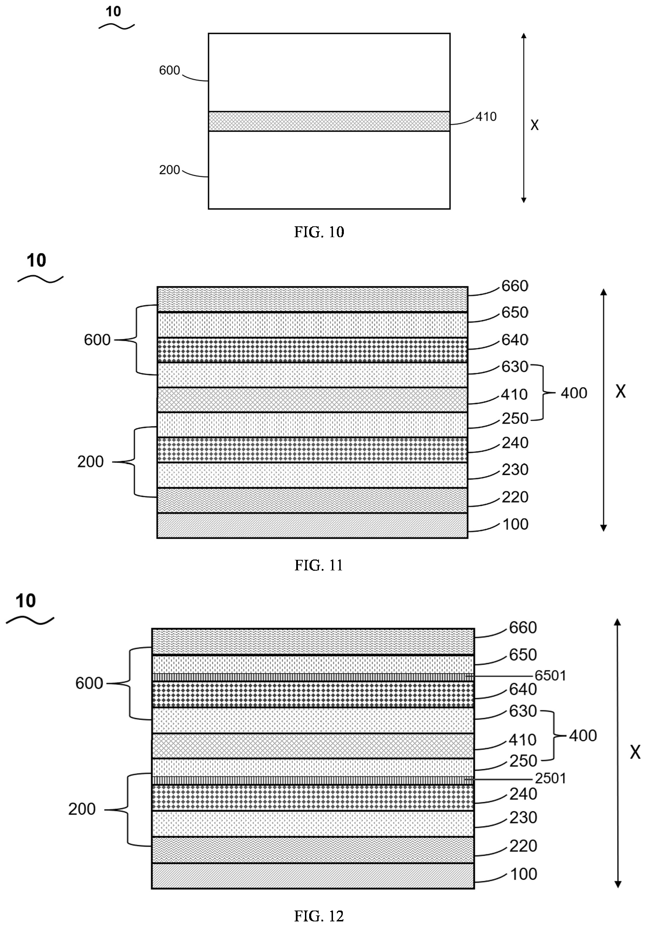

FIG. 11 is a schematic diagram of a tandem solar cell in an embodiment of the present application, where the tandem solar cell includes a substrate layer, a first perovskite sub-cell, a carrier recombination layer, and a second perovskite sub-cell that are sequentially stacked, the first perovskite sub-cell includes a first electrode, a first carrier transport layer, a first perovskite layer, and a second carrier transport layer that are sequentially stacked, the second perovskite sub-cell includes a third carrier transport layer, a second perovskite layer, a fourth carrier transport layer, and a second electrode that are sequentially stacked, and the first electrode, the first carrier transport layer, the first perovskite layer, the second carrier transport layer, the carrier recombination layer, the third carrier transport layer, the second perovskite layer, the fourth carrier transport layer, and the second electrode are sequentially stacked;
FIG. 12 is a schematic diagram of a tandem solar cell in an embodiment of the present application, where the tandem solar cell includes a substrate layer, a first perovskite sub-cell, a carrier recombination layer, and a second perovskite sub-cell that are sequentially stacked, the first perovskite sub-cell includes a first electrode, a first carrier transport layer, a first perovskite layer, and a second carrier transport layer that are sequentially stacked, the second perovskite sub-cell includes a third carrier transport layer, a second perovskite layer, a fourth carrier transport layer, and a second electrode that are sequentially stacked, the first electrode, the first carrier transport layer, the first perovskite layer, the second carrier transport layer, the carrier recombination layer, the third carrier transport layer, the second perovskite layer, the fourth carrier transport layer, and the second electrode are sequentially stacked, both the fourth carrier transport layer and the second carrier transport layer are electron transport layers, both the third carrier transport layer and the first carrier transport layer are hole transport layers, the side of the fourth carrier transport layer close to the second perovskite layer includes a second hole-blocking layer, and the side of the second carrier transport layer close to the first perovskite layer includes a first hole-blocking layer; and
FIG. 13 is a schematic diagram of a power consuming apparatus using a tandem solar cell as a power generation device in one embodiment of the present application.

Description of Reference Numerals: 10: tandem solar cell; 100: substrate layer; 200: first perovskite sub-cell; 220: first electrode; 230: first carrier transport layer; 240: first perovskite layer; 250: second carrier transport layer; 2501: first hole-blocking layer; 400: intermediate interconnection layer; 410: carrier recombination layer; 600: second perovskite sub-cell; 630: third carrier transport layer; 640: second perovskite layer; 650: fourth carrier transport layer; 6501: second hole-blocking layer; 660: second electrode; 6: power consuming apparatus; double-headed arrow X: thickness direction of first perovskite layer; 900: intermediate interconnection layer with smooth interfaces on both sides; and 920, 940: two perovskite layers on both sides of the intermediate interconnection layer.

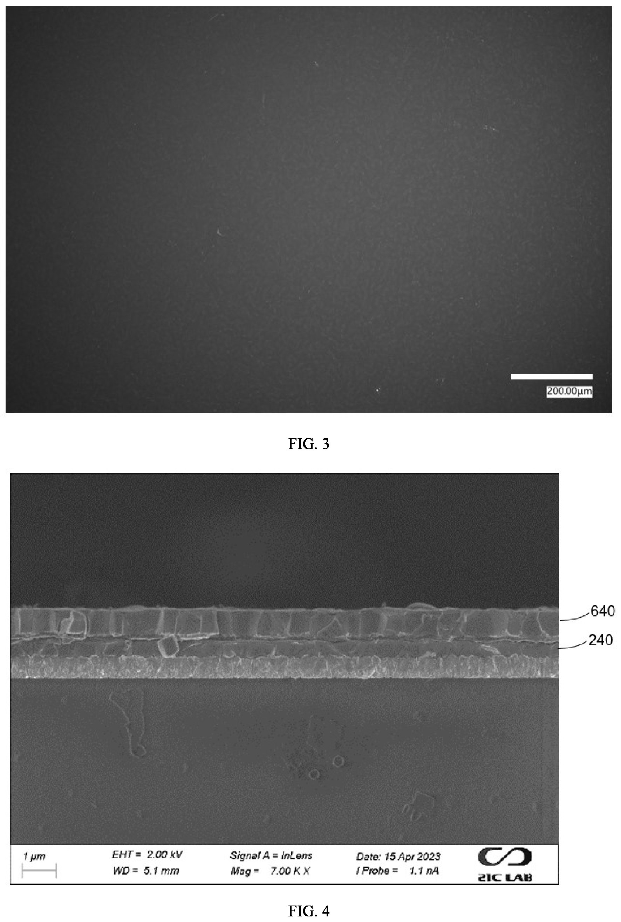

In FIGS. 4, 5, 6, and 9, EHT corresponds to an accelerating voltage, WD corresponds to a working distance, Mag corresponds to a magnification factor, Signal A corresponds to a detector model, Date corresponds to a test date, and Iprobe corresponds to a probe current.

### DETAILED DESCRIPTION

Hereinafter, some embodiments and examples of a tandem solar cell, a preparation method, and a power consuming apparatus of the present application are described in detail with appropriate reference to the accompanying drawings. However, there will be cases where unnecessary detailed descriptions are omitted. For example, there are cases where detailed descriptions of well-known matters and repeated descriptions of actually identical structures are omitted. This is to avoid unnecessary redundancy in the following descriptions and to facilitate the understanding by those skilled in the art. Furthermore, the accompanying drawings and subsequent descriptions are provided for those skilled in the art to fully understand the present application, and are not intended to limit the subject matter recited in the claims.

A "range" disclosed in the present application is defined in a form of a lower limit and an upper limit. A given range is defined by selecting a lower limit and an upper limit. The selected lower limit and upper limit define boundaries of a particular range. A range defined in this manner may be inclusive or exclusive of the end values. Any end value may be independently inclusive or exclusive and may be arbitrarily combined. To be specific, any lower limit may be combined with any upper limit to form a range. For example, if ranges of 60 to 120 and 80 to 110 are listed for a particular parameter, it is to be understood that ranges of 60 to 110 and 80 to 120 are also contemplated. Furthermore, if minimum range values 1 and 2 and maximum range values 3, 4 and 5 are listed, the following ranges are all contemplated: 1 to 3, 1 to 4, 1 to 5, 2 to 3, 2 to 4 and 2 to 5. In the present application, unless otherwise specified, the numerical value range "a-b" represents an abbreviated representation of any combination of real numbers between a and b, where a and b are both real numbers. For example, the numerical range "0 to 5" represents that all real numbers between 0 and 5 are listed herein, and "0 to 5" is merely the abbreviated representation of the combination of these numbers. In addition, when a parameter is expressed as an integer greater than or equal to 2, it is equivalent to listing that the parameter is an integer such as 2, 3, 4, 5, 6, 7, 8, 9, 10, 11, or 12. For example, when a parameter is expressed as an integer selected from "2-10", it is equivalent to listing integers 2, 3, 4, 5, 6, 7, 8, 9, and 10.

In the present application, references to "a plurality of", "multiple", "a number of", "multiple times", and "several" etc., unless specifically defined otherwise, mean a quantity greater than 2 or equal to 2. For example, "one or more" means one or not less than two. It may be understood that when "any plurality of" items are involved, it means a combination of any appropriate plurality of items. In other words, the combination of "any plurality of" items is conducted in a manner that is non-conflicting and enables the implementation of the present application.

Unless otherwise specified, all embodiments and optional embodiments of the present application may be combined with each other to form new technical solutions.

Reference herein to "an example" means that a particular feature, structure, or characteristic described in connection with the example may be included in at least one example or embodiment of the present application. The appearances of the phrase in various places in the specification are not necessarily all referring to the same example, nor a separate or alternative example that is mutually exclusive of other examples. Those skilled in the art may explicitly or implicitly understand that the examples described herein may be combined with other examples. "Embodiments" mentioned herein are understood similarly.

Those skilled in the art will appreciate that, in methods of various embodiments or examples, a writing order of each step does not imply a strict execution order nor impose any limitation on an implementation process. The specific execution order of each step shall be determined based on the function and possible inherent logic thereof. Unless otherwise specified, all the steps in the present application may be performed in the order described or in a random order, and preferably in the order described. For example, a method M includes steps (a) and (b), indicating that the method M may include steps (a) and (b) that are sequentially performed, as well as steps (b) and (a) that are sequentially performed. For example, the method M may further include step (c), indicating that step (c) may be added to the method M in any ordinal position. For example, the method M may include steps (a), (b), and (c), steps (a), (c), and (b), steps (c), (a), and (b), or the like.

In the present application, for open-ended technical features or technical solutions described using terms such as "containing", "comprising", and "including", unless otherwise specified, additional members beyond the listed members are not excluded. It may be deemed to provide both closed-ended features or solutions consisting solely of the listed members and open-ended features or solutions that include additional members beyond the listed members. For example, if "A includes a1, a2, and a3", unless otherwise specified, other members may be included, and additional members may not be included. It may be deemed to provide both a feature or solution "A consists of a1, a2, and a3" or "A is selected from the group consisting of a1, a2, and a3", and a feature or solution "A includes not only a1, a2, and a3, but also other members".

In the present application, unless otherwise specified, A (e.g., B) indicates that B is a non-limiting instance of A. It may be understood that A is not limited to B.

In the present application, the terms "optionally", "optional", and "option" refer to either presence or absence. In other words, the terms refer to a choice between two mutually exclusive options: "present" or "absent". If there are multiple "options" in one technical solution, unless otherwise specified and there are no contradictions or mutual constraints, each "option" is independent. Unless otherwise specified, descriptions in the present application such as "optionally including" and "optionally comprising" shall be interpreted based on the example of "optionally including", which means "may include or may not include". As a non-limiting instance, "optional substance A" means that substance A is included or not included.

In the present application, unless otherwise stated, a feature or scheme corresponding to "and/or" includes any one of two or more relevant listed items, and also includes any and all combinations of the relevant listed items. The any and all combinations include combinations of any two relevant listed items, any more relevant listed items, or all relevant listed items. For example, "A and/or B" means the group consisting of A, B, and "a combination of A and B". "Including A and/or B" may mean "including A, including B, and including A and B", and may also mean "including A, including B, or including A and B", which can be properly understood according to the statement.

As used herein, terms such as "combination thereof", "any combination thereof", and "any combination manner thereof" include all suitable combination manners of any two or more of the listed items.

Herein, the term "suitable" in expressions such as "suitable combination manner", "suitable manner", and "any suitable manner" shall be determined based on the feasibility of implementing the technical solution of the present application.

Herein, "preferred", "better", "more preferably", "appropriately", "relatively good", and "relatively better" are merely intended to describe embodiments or examples with better effects, and should not be understood as a limitation on the protection scope of the present application. If there are multiple "preferred" in one technical solution, unless otherwise specified and there are no contradictions or mutual constraints, each "preferred" is independent.

In the present application, "further", "still further", "particularly", "for example", "such as", "instance", and "by way of example" are used for descriptive purposes and indicate differences in content, but should not be understood as limitations on the protection scope of the present application.

In the present application, in the "first aspect", "second aspect", "third aspect", "fourth aspect", and the like, the terms "first", "second", "third", "fourth", and the like are only used for descriptive purposes, and cannot be understood as indicating or implying relative importance or quantity, nor implicitly indicating the importance or quantity of the indicated technical features. Moreover, the "first", "second", "third", "fourth" and the like are merely used for the purpose of non-exhaustive description, and should not be understood as constituting a closed limitation on the quantity.

In the present application, the term "room temperature" generally refers to a range of 4°C to 35°C, and may refer to 20°C±5°C. In some examples of the present application, the room temperature refers to a range of 20°C to 30°C.

In the present application, when "numerical value" is involved, the meaning includes an exact value and reasonable approximate values. The definition of "numerical value" applies not only to discrete numerical points but also to endpoints of numerical ranges. In the present application, for any reference to a numerical value or numerical range, unless otherwise specified, it should be understood that the numerical value includes reasonable approximate values thereof, and the numerical range includes reasonable approximate values of two endpoints. Those skilled in the art will understand that an acceptable fluctuation range of the relevant approximate values should be included in the definition of the numerical value or numerical range. In the present application, unless otherwise stated, "N1" may be reasonably understood as "about N1", and "N1-N2" may be reasonably understood as "about N1 to about N2", where N1 and N2 are two unequal numerical values. For example, in some cases, due to one or more factors such as reasonable deviations allowed in the art and instrument control accuracy, it is reasonable to include approximate values within an approximate range into a scope defined by the numerical range. For example, "the temperature is 20°C to 30°C" may be understood as "about 20°C to about 30°C". Further, taking the endpoint "20°C" with an approximate value of ±1°C as an example, "about 20°C" includes approximate values such as 19°C and 19.5°C within the approximate range, which should also be included in the scope indicated by 20°C to 30°C. As a non-limiting instance, the percentage content "10%" may be reasonably understood as "about 10%". As another non-limiting instance, the percentage content "2% to 10%" may be reasonably understood as "about 2% to about 10%". As a further non-limiting instance, the percentage content "0%" includes at least "none", and may alternatively include a case of "below a detection limit".

In the present application, unless otherwise specified, references to "approximate value" include the exact value and approximate values within a reasonable fluctuation range based on the exact value. The reasonable fluctuation range may vary depending on the type of the exact value and the magnitude of the numerical value.

In the present application, with respect to the unit of a data range, if only the right end point is followed by the unit, it means that the units of the left end point and the right end point are the same. For example, both 3 to 5 h and 3-5 h indicate that the unit of both a left endpoint "3" and a right endpoint "5" is h (hour), and both have the same meaning as 3 h to 5 h. The aforementioned way of understanding applies not only to time units, but also to the unit descriptions of parameters such as temperature, size, and band gap.

The weight of relevant components mentioned in the specification of the examples of the present application may not only refer to the content of each component, but also represent the weight ratio relationship between the components. Therefore, the contents of relevant components scaled up or down according to the specification of the examples of the present application are embraced within the scope disclosed in the specification of the examples of the present application. Further, the mass involved in the specification of the examples of the present application may be mass units known in the chemical industry such as microgram (µg), milligram (mg), gram (g), and kilogram (kg).

In the present application, both "not less than" and "greater than or equal to" may be equivalently expressed as "≥". "Not more than" and "less than or equal to" may be equivalently expressed as "≤". "Greater than" may be equivalently expressed as ">". "Less than" may be equivalently expressed as "<". In the present application, unless otherwise specified, "not less than", "greater than or equal to", and "≥" may be deemed to further provide two solutions: "greater than" and "equal to". In the present application, unless otherwise specified, "not greater than", "less than or equal to", and "≤" may be deemed to further provide two solutions: "less than" and "equal to".

In the present application, regarding parameter units, unless otherwise specified, the temperature unit °C represents "degree Celsius". The time unit min represents "minute". The time unit s represents "second". The length unit mm represents "millimeter". µm represents "micrometer". nm represents "nanometer". The volume unit µL represents "microliter". The area unit mm² represents "square millimeter". The pressure unit Pa represents "pascal". The short-circuit current density unit mA/cm² represents "milliampere per square centimeter". The rotational speed unit rpm represents "revolutions per minute". The energy unit eV represents "electron volt".

In the present application, exemplary descriptions such as "in some embodiments (or examples)" and "in one embodiment (or example)" may cover, but are not limited to, the following meaning: these solutions may be combined with other solutions in an appropriate manner to form new technical solutions.

According to a first aspect, the present application provides a perovskite-based tandem solar cell. The perovskite-based tandem solar cell includes a perovskite light-absorbing layer, which can provide a relatively high short-circuit current density and is additionally beneficial to improving photoelectric conversion efficiency.

In some embodiments, a perovskite-based tandem solar cell is provided, including a first perovskite layer and a second perovskite layer with different band gaps. A surface of a side of the first perovskite layer close to the second perovskite layer is a non-smooth surface with grooves. Ridges are formed between at least some adjacent grooves. The tandem solar cell satisfies at least one of the following features: at least some of the grooves have different widths at at least some depth positions; and at least some of the ridges have different widths at at least some height positions.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with grooves. Further, at least some of the grooves have different widths at at least some depth positions. Optionally, a length-to-width ratio of the grooves is greater than 1. Optionally, a band gap of a first perovskite layer in the first perovskite sub-cell is different from a band gap of a second perovskite layer in the second perovskite sub-cell.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with grooves. Further, ridges are formed between at least some adjacent grooves. Optionally, a length-to-width ratio of the grooves is greater than 1. Optionally, a band gap of a first perovskite layer in the first perovskite sub-cell is different from a band gap of a second perovskite layer in the second perovskite sub-cell.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with ridges. Further, grooves are formed between at least some adjacent ridges. Optionally, a length-to-width ratio of the grooves is greater than 1. Optionally, a band gap of a first perovskite layer in the first perovskite sub-cell is different from a band gap of a second perovskite layer in the second perovskite sub-cell.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with ridges. Further, at least some of the ridges have different widths at at least some height positions. Optionally, a band gap of a first perovskite layer in the first perovskite sub-cell is different from a band gap of a second perovskite layer in the second perovskite sub-cell.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with grooves. Ridges are formed between at least some adjacent grooves. The tandem solar cell satisfies at least one of the following features (i) and (ii). (i) At least some of the grooves have different widths at at least some depth positions. (ii) At least some of the ridges have different widths at at least some height positions. Optionally, a length-to-width ratio of the grooves is greater than 1. Optionally, a band gap of a first perovskite layer in the first perovskite sub-cell is different from a band gap of a second perovskite layer in the second perovskite sub-cell.

In some embodiments, a perovskite-based tandem solar cell is provided. The tandem solar cell includes a first perovskite sub-cell, a carrier recombination layer, and a second perovskite sub-cell that are sequentially stacked. A surface of a side of the first perovskite layer close to the carrier recombination layer is a non-smooth surface. The non-smooth surface is provided with grooves. Ridges are formed between at least some adjacent grooves. A concave-convex interface formed by the grooves, the ridges, and adjacent structural layers is denoted as a first interface. The tandem solar cell satisfies at least one of the following features (i) and (ii). (i) At least some of the grooves have different widths at at least some depth positions. (ii) At least some of the ridges have different widths at at least some height positions. The tandem solar cell has excellent comprehensive performance in terms of short-circuit current density and photoelectric conversion efficiency. Optionally, a band gap of a first perovskite layer in the first perovskite sub-cell is different from a band gap of a second perovskite layer in the second perovskite sub-cell.

In some embodiments, a perovskite-based tandem solar cell is provided. The perovskite-based tandem solar cell includes a first perovskite sub-cell, a carrier recombination layer, and a second perovskite sub-cell that are sequentially stacked. The first perovskite sub-cell includes a first perovskite layer. The second perovskite sub-cell includes a second perovskite layer. A band gap of the first perovskite layer is different from a band gap of the second perovskite layer.

A thickness direction of the first perovskite layer is denoted as a longitudinal direction.

A surface of a side of the first perovskite layer close to the carrier recombination layer is a non-smooth surface. The non-smooth surface is provided with grooves. Ridges are formed between at least some adjacent grooves. A concave-convex interface formed by the grooves, the ridges, and adjacent structural layers is denoted as a first interface.

The tandem solar cell satisfies at least one of the following features:
At least some of the grooves have different widths at at least some depth positions.

At least some of the ridges have different widths at at least some height positions.

In the present application, unless otherwise specified, the "perovskite-based tandem solar cell" refers to a tandem solar cell where a light-absorbing layer of at least one sub-cell includes perovskite semiconductor materials. Unless otherwise specified, the "tandem solar cell" has a well-known meaning in the art, and refers to a solar cell formed by stacking sub-cells based on semiconductor materials with different band gaps, thereby broadening an absorption spectrum of the solar cell and reducing thermal relaxation losses.

In the present application, unless otherwise specified, the "perovskite layer" refers to a light-absorbing layer containing perovskite semiconductor materials. Depending on different sub-cells, the perovskite layer may be classified into different perovskite layers such as a first perovskite layer contained in a first perovskite sub-cell or a second perovskite layer contained in a second perovskite sub-cell.

In the present application, unless otherwise specified, the "carrier recombination layer" is a structural layer where electrons and holes transported from the first perovskite sub-cell and the second perovskite sub-cell respectively are recombined, or a structural layer where holes and electrons transported from the first perovskite sub-cell and the second perovskite sub-cell respectively are recombined, so that the first perovskite sub-cell and the second perovskite sub-cell are connected in series.

In the present application, unless otherwise specified, the "band gap" has a well-known meaning in the art, and may be analyzed, compared, and confirmed using conventional methods in the technical field. Without limitation, band gap parameters of a band gap of a material may be determined through an absorption spectrum or emission spectrum of the band gap. Common optical methods include ultraviolet-visible absorption spectroscopy, photoluminescence spectroscopy, and Raman spectroscopy.

In some embodiments, the band gap of the first perovskite layer is greater than the band gap of the second perovskite layer. At this time, the first perovskite layer is also referred to as a wide-band gap perovskite layer, and the second perovskite layer is also referred to as a narrow-band gap perovskite layer. In the present application, unless otherwise specified, "wide band gap" and "narrow band gap" are relative concepts. There is no special limitation on absolute values of the band gaps, and a band gap of a "wide-band gap structural layer" is greater than a band gap of a "narrow-band gap structural layer".

In the present application, unless otherwise specified, the thickness direction of the first perovskite layer is denoted as the "longitudinal direction", which may be referred to an X direction marked in FIGS. 10 to 12. Along the longitudinal direction, the first perovskite layer has two opposite surfaces. The surface close to the carrier recombination layer may be denoted as a first surface, and the surface away from the carrier recombination layer may be denoted as the second surface. The cross-sectional direction of the thickness of the first perovskite layer refers to a direction orthogonal to the longitudinal direction, which may alternatively be denoted as a lateral direction. When the first perovskite layer is a thin film with a uniform thickness, the longitudinal direction is orthogonal to the lateral direction, and the first surface is parallel to the second surface. Taking FIG. 10 as an example, FIG. 10 is a schematic diagram of a tandem solar cell 10 in an embodiment of the present application, including a first perovskite sub-cell 200, a carrier recombination layer 410, and a second perovskite sub-cell 600 that are sequentially stacked.

In the present application, unless otherwise specified, the direction from the first perovskite layer to the second perovskite layer in the longitudinal direction is denoted as a "first direction".

In the present application, unless otherwise specified, the "groove" refers to a strip-shaped groove with a length-to-width ratio greater than 1.

In the present application, unless otherwise specified, the "non-smooth surface" in the first perovskite layer means that the surface (i.e., the first surface) of the first perovskite layer close to the carrier recombination layer has a non-smooth region. Within the non-smooth region, the first surface is uneven along the thickness direction of the first perovskite layer, so that the non-smooth surface has a certain degree of roughness.

In the present application, unless otherwise specified, the "groove" on the non-smooth surface of the first perovskite layer refers to a depression with a certain depth along the thickness direction of the first perovskite layer. The groove has a certain length-to-width ratio in the lateral direction, and a projection thereof along the longitudinal direction forms a long strip-shaped contour. The length direction of the long strip-shaped contour may be denoted as an extending direction of the groove. Unless otherwise specified, the length-to-width ratio of the groove is greater than 1.

In the present application, unless otherwise specified, the "ridge" on the non-smooth surface of the first perovskite layer refers to a protrusion with a certain height along the thickness direction of the first perovskite layer. The ridge has a certain length-to-width ratio in the lateral direction, and a projection thereof along the longitudinal direction forms a long strip-shaped contour. The length direction of the long strip-shaped contour may be denoted as an extending direction of the ridge. Unless otherwise specified, the length-to-width ratio of the ridge is greater than 1.

A ridge is formed between adjacent grooves, and a groove is formed between adjacent ridges. The texture formed by a plurality of groups of alternately arranged grooves and ridges may be referred to as a "wrinkled texture".

It may be understood that due to the presence of grooves, there is a non-smooth region in the non-smooth surface.

By arranging perovskite light-absorbing layers with different band gaps in the tandem solar cell, photons in different wavelength ranges may be fully absorbed, thermal relaxation losses can be reduced, and the utilization rate of incident light can be improved. A non-smooth surface including grooves and ridges may be arranged on the surface of the side of the first perovskite layer close to the carrier recombination layer, so that the non-smooth surface and an adjacent surface of an adjacent structural layer form a strip-shaped concave-convex interface, which may be denoted as a first interface. When at least one of the two features "at least some of the grooves have different widths at at least some depth positions" and "at least some of the ridges have different widths at at least some height positions" is satisfied, at least some of the photons emitted to the first interface can undergo at least one of multiple refractions and multiple reflections at the first interface. For the photons emitted to the first interface, compared with the situation where photons only undergo a single reflection and/or refraction after contacting a conventional smooth interface, the non-smooth first interface in the present application may increase contact opportunities between the photons and the first interface, improve the probability of the photons being captured by the perovskite layers in the perovskite-based tandem solar cell, and enhance the light utilization efficiency. For photons that pass through the first perovskite layer without being absorbed and are emitted to the first interface, the probability of the photons entering the second perovskite layer can be increased, thereby increasing the number of photons in an absorbable wavelength range in the second perovskite layer. For photons that pass through the second perovskite layer still without being absorbed and are emitted to the first interface, the probability of entering the first perovskite layer can be increased, thereby increasing the number of photons in an absorbable wavelength range in the first perovskite layer. Therefore, the overall current level of the tandem solar cell can be improved, the short-circuit current density can be increased, and it is additionally beneficial to improving the photoelectric conversion efficiency.

The "extending direction of the groove" refers to the extending direction of the groove in the lateral direction. In the lateral direction, the extending direction of the groove may be obtained by: acquiring a peripheral extending contour of the groove on the first surface of the first perovskite layer, and connecting width centers of the extending contour at different length positions sequentially, to obtain a contour width center connecting line for characterizing the extending direction of the groove. The contour width center connecting line may be denoted as an "extending line of the groove". In the extending contour of the groove on the first surface, the length of the contour width center connecting line of the groove may be denoted as a "length of the groove".

On the non-smooth surface with the grooves, the "average spacing of the grooves" may be obtained by statistically analyzing an average distance between the extending lines. For example, it may be obtained by acquiring a plurality of positions and statistically averaging distances between the extending lines at different acquisition positions of the grooves. The average spacing of the grooves within a selected region may alternatively be estimated by the following formula: A1/L1, where A1 is a projected area of the selected non-smooth region along the longitudinal direction, and L1 is a sum of lengths of the extending lines of the grooves in the selected non-smooth region.

The "longitudinal cross-section of the groove" is a cross-section that is orthogonal to the extending line of the groove and parallel to the thickness direction of the first perovskite layer. A contour line of the longitudinal cross-section is an opening line with an upper opening and a downward depression. A position in the longitudinal cross-section contour line close to the outside of the first perovskite layer is denoted as "upper". Two upper endpoints of the longitudinal cross-section contour line is denoted as an "opening connecting line" of the groove. The length of the opening connecting line is denoted as an "opening width of the groove" or a "width of the groove". The position of the longitudinal contour line that is farthest from the opening connecting line is denoted as a "bottom of the groove". A straight line parallel to the opening connecting line is drawn at the bottom position. The length of a line segment of the straight line between the longitudinal cross-section contour lines is denoted as a "bottom width of the groove". A vertical distance between each point on the longitudinal cross-section contour line and the opening connecting line corresponds to the depth of the groove at different contour positions. A maximum vertical distance is denoted as a "depth of the groove". A straight line parallel to the opening connecting line is drawn at a midpoint of a maximum depth (i.e., a half-height position). The length of a line segment of the straight line between the longitudinal cross-section contour lines is denoted as a "half-height width of the groove", and a corresponding average value may be denoted as a "half-height width of the groove".

The ratio of the length of the groove to the width of the groove is denoted as a "length-to-width ratio of the groove". Unless otherwise specified, the length-to-width ratio of the groove is greater than 1.

The ratio of the depth of the groove to the width of the groove is denoted as a "depth-to-width ratio of the groove".

The cross-section at a half-height of the groove, which is a region enclosed by the groove contour lines on a cross-section orthogonal to the longitudinal direction at the half-height of the groove, is denoted as a "half-height cross-section of the groove".

An average width, an average depth, an average half-height width, and an average length of the grooves may be obtained by calculating an arithmetic average of multi-point test values of corresponding parameters respectively.

The "extending direction of the ridge" refers to the extending direction of the ridge in the lateral direction. In the lateral direction, the extending direction of the ridge may be obtained by: projecting the ridge along the longitudinal direction onto a longitudinal orthogonal plane, acquiring a peripheral projection contour of the ridge as an extending contour, and connecting width centers of the extending contour at different length positions sequentially, to obtain a contour width center connecting line for characterizing the extending direction of the ridge. The contour width center connecting line may be denoted as an "extending line of the ridge". In the extending contour of the ridge on the first surface, the length of the contour width center connecting line of the ridge may be denoted as a "length of the ridge".

On the non-smooth surface with the ridges, the "average spacing of the ridges" may be obtained by statistically analyzing an average distance between the extending lines. For example, it may be obtained by acquiring a plurality of positions and statistically averaging distances between the extending lines at different acquisition positions of the ridges. The flat spacing of the ridges within a selected region may alternatively be estimated by the following formula: A1/L2, where A1 is a projected area of the selected non-smooth region along the longitudinal direction, and L2 is a sum of lengths of the extending lines of the ridges in the selected non-smooth region.

The "longitudinal cross-section of the ridge" is a cross-section that is orthogonal to the extending line of the ridge and parallel to the thickness direction of the first perovskite layer. A contour line of the longitudinal cross-section is an opening line with a bottom opening and a protrusion toward the top. A position in the longitudinal cross-section contour line material the outside of the first perovskite layer is denoted as "bottom". Two bottom endpoints of the longitudinal cross-section contour line is denoted as an "opening connecting line" of the ridge. The length of the opening connecting line is denoted as a "bottom width of the ridge" or a "width of the ridge". The position of the longitudinal contour line that is farthest from the opening connecting line is denoted as a "top of the ridge". A straight line parallel to the opening connecting line of the ridge is drawn at the top position. The length of a line segment of the straight line between the longitudinal cross-section contour lines is denoted as a "top width of the ridge". A vertical distance between each point on the longitudinal cross-section contour line and the opening connecting line corresponds to the height of the ridge at different contour positions. A maximum vertical distance is denoted as a "height of the ridge". A straight line parallel to the opening connecting line is drawn at a midpoint of a maximum depth (i.e., a half-height position). The length of a line segment of the straight line between the longitudinal cross-section contour lines is denoted as a "half-height width of the ridge", and a corresponding average value may be denoted as a "half-height width of the ridge".

The ratio of the length of the ridge to the width of the ridge is denoted as a "length-to-width ratio of the ridge". Unless otherwise specified, the length-to-width ratio of the ridge is greater than 1.

The ratio of the height of the ridge to the width of the ridge is denoted as a "height-to-width ratio of the ridge".

When the grooves and the ridges are arranged alternately, adjacent grooves and ridges share a side surface. The average spacing of the ridges is substantially the same as the average spacing of the grooves in value. Furthermore, the depth of the grooves is substantially the same as the height of the ridges in average.

The cross-section at a half-height of the ridge, which is a region enclosed by the ridge contour lines on a cross-section orthogonal to the longitudinal direction at the half-height of the ridge, is denoted as a "half-height cross-section of the ridge".

An average width, an average depth, an average length, an average half-height width, and an average height-to-width ratio of the ridges may be obtained by calculating an arithmetic average of multi-point test values of corresponding parameters respectively.

In the present application, shape parameters of the grooves and the ridges on the non-smooth surface of the first perovskite layer may be tested and analyzed by methods including but not limited to the following:
(1) A morphology map or surface roughness curve of the non-smooth surface of the first perovskite layer is obtained by an SEM, an optical microscope photograph, a step profiler, and the like. Combined with image analysis software such as Image-J, the following information and/or parameters may be tested and analyzed, including but not limited to the extending contour of the groove on the non-smooth surface of the first perovskite layer, the extending line of the groove, the extending direction of the groove, the length of the groove, the average spacing of the grooves, the extending contour of the ridge on the non-smooth surface of the first perovskite layer, the extending line of the ridge, the extending direction of the ridge, the length of the ridge, the average spacing of the ridges, the projected area of the non-smooth region along the longitudinal direction, and the like.
(2) A longitudinal cross-sectional view of the first perovskite layer is obtained by an SEM, an optical microscope photograph, a step profiler, and the like. Combined with image analysis software such as Image-J, the following information and/or parameters may be tested and analyzed: the longitudinal cross-section of the groove, the contour line of the longitudinal cross-section of the groove, the opening connecting line of the groove, the opening width of the groove, the width of the groove, the bottom width of the groove, the depth of the groove, the half-height width of the groove, the length-to-width ratio of the groove, the depth-to-width ratio of the groove, the half-height cross-section of the groove, the longitudinal cross-section of the ridge, the contour line of the longitudinal cross-section of the ridge, the opening connecting line of the ridge, the bottom width of the ridge, the width of the ridge, the top width of the ridge, the height of the ridge, the half-height width of the ridge, the length-to-width ratio of the ridge, the height-to-width ratio of the ridge, the half-height cross-section of the ridge, and the like.
(3) Average value of parameters: Average values such as the average width of the grooves, the average half-height width of the grooves, the average depth of the grooves, the average depth-to-width ratio of the grooves, the average length of the grooves, the average length-to-width ratio of the grooves, the average half-height cross-section of the grooves, the average width of the ridges, the average half-height width of the ridges, the average height of the ridges, the average height-to-width ratio of the ridges, the average length of the ridges, the average length-to-width ratio of the ridges, and the average half-height cross-section of the ridges may be obtained by a simple arithmetic average calculation of corresponding parameter values acquired at a plurality of positions. The number of acquisition positions may be appropriately selected according to difference levels of the shapes and dimensions of the grooves and the ridges. For example, a minimum data acquisition amount may be determined by controlling a standard deviation of the average value to be less than or equal to (≤) 10% of the average value. Taking the acquisition of an average width of the grooves as a non-limiting instance, width values of the grooves at an appropriate number of positions (e.g., 20 positions) may be acquired, and an average value obtained by a simple arithmetic average calculation may be used as the "average width of the grooves".

A to-be-tested sample containing the first perovskite layer may be obtained by the method in the following examples. Taking SEM observation as an example, an assembly where the first perovskite layer has been deposited on the first carrier transport layer but the second carrier transport layer has not been deposited may be selected as the to-be-tested sample. The test and analysis may be carried out from the longitudinal direction and the lateral direction. (1) If an observation surface is a lateral surface of an exposed side of the first perovskite layer. (2) An assembly containing the first perovskite layer or the tandem solar cell is cut off by using a glass knife along the longitudinal direction, and the longitudinal cross-section is placed upward for SEM testing. (3) A cryogenic focused ion beam (FIB) is used for slicing along the longitudinal direction to obtain a cross-section which is the longitudinal cross-section, and SEM morphological observation is performed on the cross-section.

It may be understood that some parameter values based on statistical results of a large sample set in the present application may be determined by a random sampling statistics method. For example, some parameter values of the grooves (average width, average half-height width, average depth, average depth-to-width ratio, average length, and the like) and some parameter values of the ridges (average width, average half-height width, average height, average height-to-width ratio, average length, and the like) within the entire non-smooth surface region may be determined by a statistical average value among a plurality of randomly selected regions in the non-smooth surface.

Based on any suitable embodiment in the present application, in some further embodiments, an average half-height width of the ridges is 1 µm to 2.5 µm, optionally 1.5 µm to 2 µm.

In the present application, unless otherwise specified, the "surface roughness" refers to surface unevenness formed by the staggered arrangement of micro-nano-scale convex and concave portions on the surface. A smaller surface roughness indicates a smoother surface. A larger surface roughness indicates a more uneven surface. In the non-smooth surface of the first perovskite layer, a larger surface roughness caused by the grooves and the ridges indicates a more uneven non-smooth surface.

In the present application, unless otherwise specified, the "surface roughness" of the non-smooth surface may be characterized by a distance between the highest point and the lowest point of the surface along the longitudinal direction. Generally, a concave portion between two nearest adjacent protrusions where a height difference between the highest point and the lowest point is greater than or equal to 100 nm (≥ 100 nm) is denoted as a "groove", and a fluctuation less than 100 nm is regarded as a morphological change within the groove. Unless otherwise specified, the "surface roughness" of a specified region is numerically equal to the average depth of the grooves within the specified region, or numerically equal to the average height of the ridges within the specified region.

A surface roughness testing method for the selected non-smooth region may be, but is not limited to, step profiler testing. The step profiler may be a probe profiler. The test method in the following examples may be referred to, and the size of the grooves and/or the ridges may be statistically analyzed according to a surface roughness curve obtained from the test.

In some embodiments, the surface roughness is obtained by step profiler testing.

The shape and size of the grooves (e.g., length, width, depth, length-to-width ratio, length-to-depth ratio, depth-to-width ratio, etc.), a distribution quantity and distribution mode of the grooves on the non-smooth surface of the first perovskite layer, the shape and size of the ridges (e.g., length, width, height, length-to-width ratio, length-to-height ratio, height-to-width ratio, etc.), and a distribution quantity and distribution mode of the ridges on the non-smooth surface of the first perovskite layer may affect the surface roughness of the non-smooth surface. By controlling the surface roughness of the non-smooth region in the non-smooth surface within a relatively appropriate range, the non-smooth surface may be controlled to have a relatively appropriate morphology, which is beneficial to fully exerting the light-trapping effect of the first interface and better improving the comprehensive performance of the short-circuit current density and the photoelectric conversion efficiency.

For photons emitted from the inside of the first perovskite layer or the inside of the second perovskite layer to the first interface, generally speaking, the photons partially enter an adjacent structural layer through one refraction, and are partially reflected back to the first perovskite layer through one reflection. At this time, a concave-convex morphology at the first interface may be used to make at least some of the photons undergo at least one of the following effects: (i) A plurality of reflection and refraction effects are used, so that at least some of the photons can be refracted out of the first perovskite layer at the ridge interface. At this time, at least some of the photons absorbable by the second perovskite layer (denoted as photons in a second wavelength range) can be captured and absorbed by the second perovskite layer after secondary reflection or more reflections. (ii) Secondary refraction and reflection effects are used, so that at least some of the photons can be reflected at the groove interface and then refracted into the first perovskite layer. At this time, at least some of the photons absorbable by the first perovskite layer (denoted as photons in a first wavelength range) can be captured and absorbed by the first perovskite layer after secondary refraction. Based on the foregoing effects of the concave-convex morphology at the first interface, a contact opportunity between the perovskite light-absorbing layer and photons in the tandem solar cell may be increased, the utilization rate of incident light by the tandem solar cell can be improved, and the short-circuit current density of the tandem solar cell can be improved. Furthermore, it is further beneficial to improving the photoelectric conversion efficiency of the tandem solar cell.

In the present application, the photons absorbable by the first perovskite layer are denoted as "photons in a first wavelength range".

The concave-convex interface morphology on the side of the first perovskite layer close to the carrier recombination layer may be obtained by preparing the first perovskite layer through a vacuum flash evaporation process, and may alternatively be adjusted by adjusting parameters of the vacuum flash evaporation process and the composition of a perovskite material of the first perovskite layer. In some examples, increasing the bromine content in the perovskite material of the first perovskite layer is beneficial to promoting the formation of wrinkled textures and increasing the depth-to-width ratio and wrinkle density of the grooves. During the vacuum flash evaporation process, a higher vacuum degree indicates a higher solvent removal speed, a larger depth-to-width ratio of the grooves, a higher formed wrinkle density, a smaller spacing between the grooves, and a smaller spacing between the ridges. In some examples, reducing the temperature of a sample during the vacuum flash evaporation process is further beneficial to promoting the formation of wrinkled textures and increasing the depth-to-width ratio and wrinkle density of the grooves. Taking process parameters of vacuum flash evaporation treatment at 100 Pa for 20 s as an example, in one example, the average depth-to-width ratio of the grooves in the wrinkled texture is 0.3, and the average spacing between the grooves is 15 µm.

In some embodiments, a ratio of the sum of extending lengths of the grooves to the sum of extending lengths of the ridges is 0.9 to 1.1, and may further be 1.

Based on any suitable embodiment in the present application, in some further embodiments, morphologies of interfaces formed by different structural layers between the first perovskite layer and the second perovskite layer are substantially matched.

When the morphologies of the interfaces between the structural layers between the first perovskite layer and the second perovskite layer are substantially consistent, the structural layers have a uniform thickness respectively. When the morphologies of the interfaces formed by different structural layers between the first perovskite layer and the second perovskite layer are substantially matched, the different structural layers respectively have a uniform thickness. At this time, the surface of the side of the second perovskite layer close to the first perovskite layer may form a non-smooth surface with a similar morphology. Corresponding to a "concave-convex" interface on the surface of the first perovskite layer, a corresponding "convex-concave" interface (denoted as the second interface) may be formed on the surface of the second perovskite layer. The second interface is also beneficial to increasing the number of photons in the absorbable wavelength ranges in the perovskite layers of the tandem solar cell and the light utilization efficiency, is beneficial to improving the overall current level of the tandem solar cell, and is also beneficial to enhancing the photoelectric conversion efficiency.

The wavelength range of light absorbable by the second perovskite layer is denoted as a "second wavelength range", and an interface formed between the side of the second perovskite layer close to the intermediate interconnection layer and the adjacent structural layer is denoted as a "second interface". After light in the second wavelength range passes through the first perovskite layer, a portion of the light will be reflected at the second interface. Due to the presence of the concave-convex wrinkled texture, the reflected light will reach the second interface again and be absorbed by the second perovskite layer, thereby enhancing the absorption of light in the second wavelength range by the second perovskite layer.

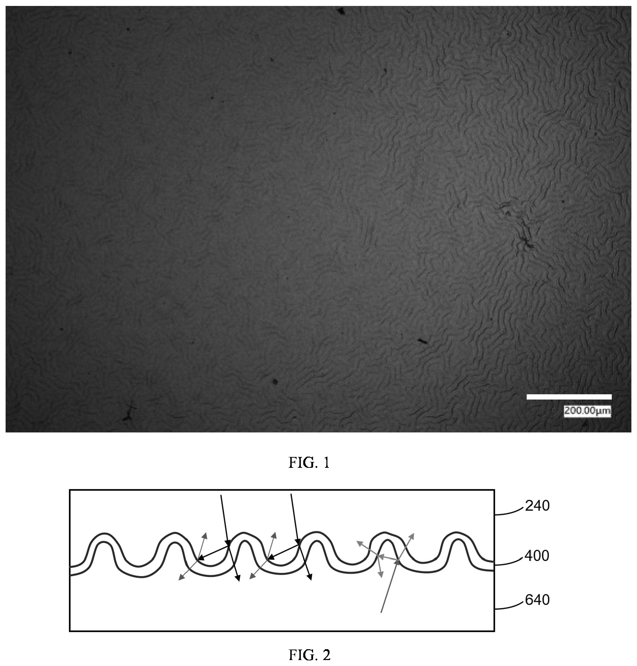

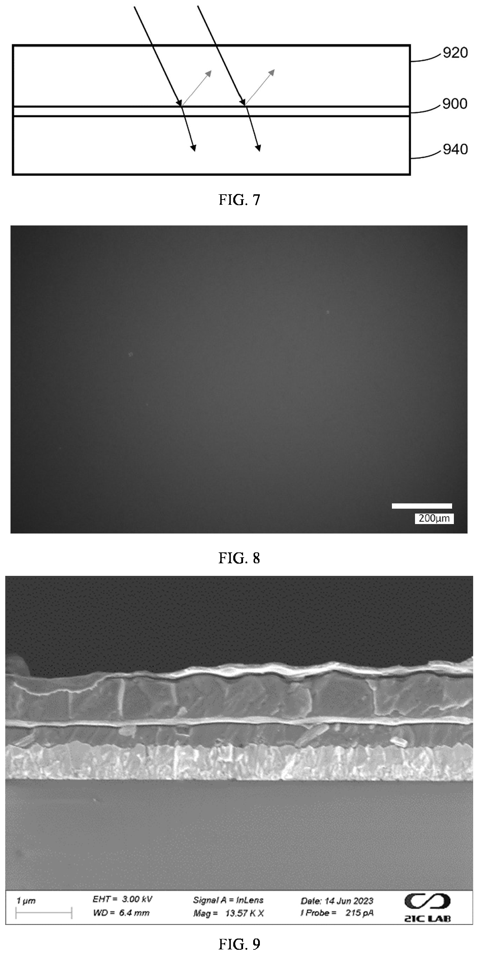

FIG. 2 is a schematic diagram of a transport path of incident light at a non-smooth surface of a first perovskite layer in an embodiment of the present application. For a conventional smooth interface, a transport path of incident light may be referred to in FIG. 7.

FIG. 2 is a schematic diagram of a transport path of incident light at a non-smooth surface of a first perovskite layer in an embodiment of the present application. A first perovskite layer is prepared by a vacuum flash evaporation process in this example. A structure shown in FIG. 2 includes a first perovskite layer 240, an intermediate interconnection layer 400, and a second perovskite layer 640 that are sequentially stacked. The structure shown in FIG. 2 may be obtained by the following method. On the basis of forming the first perovskite layer, the intermediate interconnection layer with a uniform thickness is deposited by evaporation, and then the second perovskite layer is prepared. At this time, a wrinkled intermediate interconnection layer with substantially matched concave-convex morphology and uniform thickness is formed at an interface between two perovskite sub-cells. After photons in the second wavelength range pass through the first perovskite layer, a portion of light will be reflected by the interface at the second interface, or a portion of reflected light from the second electrode may be reflected at the second interface or the first interface. Due to the presence of the concave-convex wrinkled texture between the first perovskite layer and the second perovskite layer, the reflected light may reach the second interface again and be absorbed by the second perovskite layer, thereby enhancing the absorption of light in the second wavelength range by the second perovskite layer. In some further examples, the first perovskite layer has a wide band gap, and the second perovskite layer has a narrow band gap.

FIG. 7 is a schematic diagram of a transport path of incident light at an interface between an intermediate interconnection layer 900 (with smooth interfaces on both sides) and perovskite layers 920 and 940 on both sides thereof in a comparative example of the present application. In this comparative example, a first perovskite layer is prepared by an anti-solvent method. In this comparative example, the interface between the two perovskite sub-cells is a flat and smooth planar structure. Some long-wavelength incident light passes through the first perovskite layer, then passes through the intermediate interconnection layer, enters the second perovskite, and is absorbed. However, a portion of the light will be reflected once at the interface, resulting in light loss. In some further examples, the first perovskite layer has a wide band gap, and the second perovskite layer has a narrow band gap.

A first surface morphology in the first perovskite layer and the morphology of the intermediate interconnection layer between the first perovskite layer and the second perovskite layer may be observed, photographed, and analyzed using an optical microscope from the side of a transparent electrode, with a magnification factor such as 200X. For example, when a first electrode is a transparent electrode, a portion of visible light passes through the first perovskite layer, and a portion of reflected light passes through the side of the transparent electrode, making observation with the optical microscope feasible. It is also possible to observe the morphology of a longitudinal cross-section and the morphology of a lateral cross-section by slicing with a focused ion beam (LIB) combined with an SEM technology.

FIG. 3 is an optical microscope image of a tandem solar cell from a glass substrate side in an embodiment of the present application, where a transparent electrode is arranged on a surface of the glass substrate close to a carrier recombination layer. Obvious wrinkled textures may be observed. In this example, after the first perovskite layer is prepared by a vacuum flash evaporation method, an image observed from the side of the first perovskite layer using an optical microscope is as shown in FIG. 2. An obvious wrinkled surface morphology may be observed, where grooves and ridges are generally evenly arranged alternately. The width of the grooves varies within a small range, and the width of the ridges is also relatively stable. The observation results of FIG. 3 and FIG. 2 are relatively consistent.

FIG. 8 is an optical microscope image of an all-perovskite tandem solar cell from a glass substrate side in an embodiment of the present application, where a transparent electrode is arranged on a surface of the glass substrate close to a carrier recombination layer. No obvious wrinkled textures are observed.

Based on any suitable embodiment in the present application, in some further embodiments, an intermediate interconnection layer is arranged between a first perovskite layer and a second perovskite layer. From the first perovskite layer to the second perovskite layer, the intermediate interconnection layer sequentially includes a second carrier transport layer, a carrier recombination layer, and a fourth carrier transport layer. One of the second carrier transport layer and the fourth carrier transport layer is an electron transport layer, and the other is a hole transport layer.

Internal structural layers of the intermediate interconnection layer and interfaces on both sides have substantially matched concave-convex morphologies.

When the internal structural layers of the intermediate interconnection layer and the interfaces on both sides have substantially matched concave-convex morphologies, each structural layer in the intermediate interconnection layer has a uniform thickness, and the interfaces are substantially parallel to each other. At this time, on the one hand, it is beneficial to fully exerting the reflection and refraction effects of the grooves and the ridges at the interfaces on both sides, which is beneficial to increasing the number of photons in an absorbable wavelength range in a perovskite layer of the tandem solar cell and a light utilization rate, improving an overall current level of the tandem solar cell, and also beneficial to enhancing the photoelectric conversion efficiency.

Based on any suitable embodiment in the present application, in some further embodiments, a width of at least some of the ridges is 0.5 µm to 4 µm, optionally 1 µm to 4 µm, and further optionally 2 µm to 3.5 µm. Without limitation, the width of at least some of the ridges may alternatively be selected from any one of the following values, or from an interval formed by any two of the following values: 0.5 µm, 0.6 µm, 0.8 µm, 1 µm, 1.2 µm, 1.5 µm, 1.6 µm, 1.8 µm, 2 µm, 2.5 µm, 3 µm, 3.5 µm, 4 µm, etc.

Based on any suitable embodiment in the present application, in some further embodiments, a half-height width of at least some of the ridges is 1 µm to 2.5 µm, optionally 1.5 µm to 2 µm. Without limitation, the half-height width of at least some of the ridges may alternatively be selected from any one of the following values, or from an interval formed by any two of the following values: 1 µm, 1.2 µm, 1.5 µm, 1.6 µm, 1.8 µm, 2 µm, 2.5 µm, etc.

Based on any suitable embodiment in the present application, in some further embodiments, a height of at least some of the ridges is greater than or equal to 100 nm, optionally 100 nm to 500 nm, and further optionally 100 nm to 250 nm. Without limitation, the height of the ridges may alternatively be selected from any one of the following values, or from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, etc.

Based on any suitable embodiment in the present application, in some further embodiments, within at least some regions in the non-smooth surface, an average width of the ridges is 0.5 µm to 4 µm, optionally 1 µm to 4 µm, and further optionally 2 µm to 3.5 µm. Without limitation, within at least some regions in the non-smooth surface, the average width of the ridges may alternatively be selected from any one of the following values, or from an interval formed by any two of the following values: 0.5 µm, 0.6 µm, 0.8 µm, 1 µm, 1.2 µm, 1.5 µm, 1.6 µm, 1.8 µm, 2 µm, 2.5 µm, 3 µm, 3.5 µm, 4 µm, etc.

Based on any suitable embodiment in the present application, in some further embodiments, within at least some regions in the non-smooth surface, an average half-height width of the ridges is 1 µm to 2.5 µm, optionally 1.5 µm to 2 µm. Without limitation, within at least some regions in the non-smooth surface, the average half-height width of the ridges may alternatively be selected from any one of the following values, or from an interval formed by any two of the following values: 1 µm, 1.2 µm, 1.5 µm, 1.6 µm, 1.8 µm, 2 µm, 2.5 µm, etc.

Based on any suitable embodiment in the present application, in some further embodiments, within at least some regions in the non-smooth surface, an average height of the ridges is 100 nm to 500 nm, optionally 100 nm to 250 nm. Without limitation, within at least some regions in the non-smooth surface, the average height of the ridges may alternatively be selected from any one of the following values, or from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, etc.

Based on any suitable embodiment in the present application, in some further embodiments, the tandem solar cell satisfies one or more of the following features (the reference in any one of the following features may alternatively be selected from any suitable value or range in the context):

A length-to-width ratio of at least some of the ridges is greater than 1. Optionally, the length-to-width ratio of at least some of the ridges is greater than or equal to 2. Further optionally, the length-to-width ratio of at least some of the ridges is greater than or equal to 3. Furthermore optionally, the length-to-width ratio of at least some of the ridges is greater than or equal to 5.

A width of at least some of the ridges is 0.5 µm to 4 µm, optionally 1 µm to 4 µm, and further optionally 2 µm to 3.5 µm.

The half-height width of at least some of the ridges is 1 µm to 2.5 µm, optionally 1.5 µm to 2 µm.

The height of at least some of the ridges is greater than or equal to 100 nm, optionally 100 nm to 500 nm, and further optionally 100 nm to 250 nm.

Within at least some regions in the non-smooth surface, the average width of the ridges is 0.5 µm to 4 µm, optionally 1 µm to 4 µm, and further optionally 2 µm to 3.5 µm.

Within at least some regions in the non-smooth surface, the average half-height width of the ridges is 1 µm to 2.5 µm, optionally 1.5 µm to 2 µm.

Within at least some regions in the non-smooth surface, the average height of the ridges is 100 nm to 500 nm, optionally 100 nm to 250 nm.

Optionally, a projected area of at least some regions of the non-smooth surface along the longitudinal direction is greater than or equal to 0.1 mm², further optionally greater than or equal to 0.5 mm², and further optionally greater than or equal to 0.6 mm².

In the present application, unless otherwise specified, "at least some of the ridges" may be calculated based on an extending length of the ridges, and may indicate at least 80% of the extending length, or 90% to 100% of the extending length.

In the present application, unless otherwise specified, "at least some regions" in "at least some regions in the non-smooth surface" refers to a non-smooth surface portion corresponding to a projected area region in which a projected area along the longitudinal direction is at least a value. "At least some regions in the non-smooth surface" may alternatively be expressed as "non-smooth surface regions corresponding to at least some projected areas in the projected area of the non-smooth surface along the longitudinal direction". The projected area of at least some regions of the non-smooth surface along the longitudinal direction is optionally greater than or equal to 0.1 mm², further optionally greater than or equal to 0.5 mm², and further optionally greater than or equal to 0.6 mm². In a non-limiting instance, the projected area is 960000 µm².

The length-to-width ratio, width, half-height width, and height of the ridges, and the average values of these parameters may be combined in any suitable manner.

By adjusting one or more parameters among the width, half-height width, height of the ridges, and the average values of these parameters, the probability that photons emitted from the interior of the first perovskite layer toward the first interface are emitted after multiple reflections at a ridge interface of the first perovskite layer may be adjusted. Controlling one or more of the foregoing parameters within the foregoing ranges helps more photons be absorbed by the second perovskite layer and enhances the utilization efficiency of photons that pass through the first perovskite layer without being absorbed. These photons may include the photons in the absorbable wavelength range in the second perovskite layer, thereby better improving the short-circuit current density and, additionally, better improving the photoelectric conversion efficiency of the tandem solar cell. Photons emitted from the side of the first perovskite layer toward the first interface may come from external incident light.

Based on any suitable embodiment in the present application, in some further embodiments, a width of at least some of the grooves is less than or equal to 1.2 µm, optionally 0.5 µm to 1 µm. Without limitation, the width of at least some of the grooves may alternatively be selected from any one of the following values, or less than or equal to any one of the following values, or from an interval formed by any two of the following values: 0.5 µm, 0.6 µm, 0.8 µm, 1 µm, 1.1 µm, 1.2 µm, etc.

Based on any suitable embodiment in the present application, in some further embodiments, an average half-height width of the grooves is less than or equal to 1 µm, optionally 0.2 µm to 0.7 µm, and further optionally 0.3 µm to 0.55 µm. Without limitation, the average half-height width of the grooves may alternatively be selected from any one of the following values, or from an interval formed by any two of the following values: 0.2 µm, 0.25 µm, 0.3 µm, 0.35 µm, 0.4 µm, 0.45 µm, 0.5 µm, 0.55 µm, 0.6 µm, 0.65 µm, 0.7 µm, 0.75 µm, 0.8 µm, 0.9 µm, etc.

Based on any suitable embodiment in the present application, in some further embodiments, a depth of at least some of the grooves is greater than or equal to 100 nm, optionally 100 nm to 500 nm, and further optionally 100 nm to 250 nm. Without limitation, the depth of at least some of the grooves may alternatively be selected from any one of the following values, or from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, 600 nm, etc.

Based on any suitable embodiment in the present application, in some further embodiments, a depth-to-width ratio of at least some of the grooves is 0.03 to 0.5, optionally 0.2 to 0.5, and further optionally 0.25 to 0.35. Without limitation, the depth-to-width ratio of at least some of the grooves may alternatively be selected from any one of the following values, or from an interval formed by any two of the following values: 0.03, 0.05, 0.1, 0.15, 0.2, 0.22, 0.24, 0.25, 0.26, 0.275, 0.28, 0.30, 0.32, 0.35, 0.36, 0.38, 0.40, 0.42, 0.45, 0.46, 0.48, 0.50, etc.

In the present application, unless otherwise specified, "at least some of the grooves" may be calculated based on an extending length of the grooves, and may indicate at least 80% of the extending length, or 90% to 100% of the extending length.

Based on any suitable embodiment in the present application, in some further embodiments, within at least some regions in the non-smooth surface, an average width of the grooves is 0.3 µm to 1 µm, optionally 0.5 µm to 1 µm. Without limitation, the average width of the grooves may alternatively be selected from any one of the following values, or less than or equal to any one of the following values of 0.4 µm to 1 µm, or from an interval formed by any two of the following values: 0.3 µm, 0.4 µm, 0.5 µm, 0.6 µm, 0.7 µm, 0.8 µm, 0.9 µm, 1 µm, etc.

Based on any suitable embodiment in the present application, in some further embodiments, within at least some regions in the non-smooth surface, an average half-height width of the grooves is 0.2 µm to 0.7 µm, optionally 0.3 µm to 0.55 µm. Without limitation, within at least some regions in the non-smooth surface, the average half-height width of the grooves may alternatively be selected from any one of the following values, or from an interval formed by any two of the following values: 0.2 µm, 0.3 µm, 0.4 µm, 0.5 µm, 0.6 µm, 0.7 µm, etc.

Based on any suitable embodiment in the present application, in some further embodiments, within at least some regions in the non-smooth surface, an average depth of the grooves is 100 nm to 500 nm, optionally 100 nm to 250 nm. Without limitation, the average depth of the grooves may be selected from any one of the following values, or from an interval formed by any two of the following values: 100 nm, 110 nm, 120 nm, 130 nm, 140 nm, 150 nm, 160 nm, 180 nm, 200 nm, 210 nm, 220 nm, 240 nm, 250 nm, 300 nm, 350 nm, 400 nm, 450 nm, 500 nm, etc.

Based on any suitable embodiment in the present application, in some further embodiments, within at least some regions in the non-smooth surface, an average depth-to-width ratio of the grooves is 0.03 to 0.5, optionally 0.2 to 0.5, and further optionally 0.25 to 0.35. Without limitation, the average depth-to-width ratio of the grooves may alternatively be selected from any one of the following values, or from an interval formed by any two of the following values: 0.03, 0.05, 0.1, 0.15, 0.2, 0.22, 0.24, 0.25, 0.26, 0.275, 0.28, 0.30, 0.32, 0.35, 0.36, 0.38, 0.40, 0.42, 0.45, 0.46, 0.48, 0.50, etc.

Based on any suitable embodiment in the present application, in some further embodiments, the tandem solar cell satisfies one or more of the following features (the reference in any one of the following features may alternatively be selected from any suitable value or range in the context):

A length-to-width ratio of at least some of the grooves is greater than 1. Optionally, the length-to-width ratio of at least some of the grooves is greater than or equal to 3. Further optionally, the length-to-width ratio of at least some of the grooves is greater than or equal to 5. Furthermore optionally, the length-to-width ratio of at least some of the grooves is greater than or equal to 10. More optionally, the length-to-width ratio of at least some of the grooves is greater than or equal to 15.

A width of at least some of the grooves is less than or equal to 1.2 µm, optionally 0.5 µm to 1 µm.

A half-height width of at least some of the grooves is less than or equal to 1 µm, optionally 0.2 µm to 0.7 µm.

A depth of at least some of the grooves is greater than or equal to 100 nm, optionally 100 nm to 500 nm, and further optionally 100 nm to 250 nm.

A depth-to-width ratio of at least some of the grooves is 0.03 to 0.5, optionally 0.2 to 0.5, and further optionally 0.25 to 0.35.

Within at least some regions in the non-smooth surface, an average width of the grooves is 0.3 µm to 1 µm, optionally 0.5 µm to 1 µm.

Within at least some regions in the non-smooth surface, an average half-height width of the grooves is 0.2 µm to 0.7 µm, optionally 0.3 µm to 0.55 µm.

Within at least some regions in the non-smooth surface, an average depth of the grooves is 100 nm to 500 nm, optionally 100 nm to 250 nm.

Within at least some regions in the non-smooth surface, an average depth-to-width ratio of the grooves is 0.03 to 0.5, optionally 0.2 to 0.5, and further optionally 0.25 to 0.35.

Optionally, a projected area of at least some regions of the non-smooth surface along the longitudinal direction is greater than or equal to 0.1 mm², further optionally greater than or equal to 0.5 mm², and further optionally greater than or equal to 0.6 mm².

The length-to-width ratio, width, half-height width, depth, and depth-to-width ratio of the grooves, and the average values of these parameters may be combined in any suitable manner.

By adjusting one or more parameters among the width, half-height width, depth, and depth-to-width ratio of the grooves, and the average values of these parameters, the probability that photons emitted from the side of the second perovskite layer toward the first interface enter the first perovskite layer at a groove interface of the first perovskite layer may be adjusted. Controlling one or more of the foregoing parameters within the foregoing ranges significantly increases an optical path of photons that are reflected by the interface of the second perovskite layer and remain unabsorbed in the first perovskite layer, and the photons may be more absorbed by the first perovskite layer. These photons may include the photons in the absorbable wavelength range in the first perovskite layer, thereby improving light utilization efficiency, which in turn better improves the overall current level and the photoelectric conversion efficiency of the tandem solar cell. Photons emitted from the side of the second perovskite layer toward the first interface may come from reflected light at the second electrode.

By comprehensively adjusting the width and length of the grooves, a proportion of a longitudinal projected area of the grooves in a longitudinal projected area of the first perovskite layer may be adjusted. A higher proportion indicates a more significant comprehensive improvement effect of the grooves on the overall current level and photoelectric conversion efficiency. The longitudinal projected area of the first perovskite layer may be numerically regarded as being substantially equal to a longitudinal projected area of the non-smooth surface. Therefore, the proportion of the longitudinal projected area of the grooves in the longitudinal projected area of the first perovskite layer is numerically substantially equal to a percentage of a sum of projected areas of the grooves along the longitudinal direction relative to a projected area of the non-smooth surface along the longitudinal direction.

Based on any suitable embodiment in the present application, in some further embodiments, within at least some regions in the non-smooth surface, an average spacing of the ridges is 1 µm to 20 µm, optionally 10 µm to 20 µm. Without limitation, within at least some regions in the non-smooth surface, the average spacing of the ridges may alternatively be selected from any one of the following values, or from an interval formed by any two of the following values: 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc.

Based on any suitable embodiment in the present application, in some further embodiments, within at least some regions in the non-smooth surface, an average spacing of the grooves is 1 µm to 20 µm, optionally 10 µm to 20 µm. Without limitation, within at least some regions in the non-smooth surface, the average spacing of the grooves may alternatively be selected from any one of the following values, or from an interval formed by any two of the following values: 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, etc.

Based on any suitable embodiment in the present application, in some further embodiments, the half-height width of at least some of the ridges is greater than the half-height width of the adjacent grooves.

Based on any suitable embodiment in the present application, in some further embodiments, within at least a partial region of the non-smooth surface, a ratio of the average half-height width of the ridges to the average half-height width of the grooves is 1 to 6, further optionally 4 to 5. Without limitation, the ratio of the average half-height width of the ridges to the average half-height width of the grooves may alternatively be selected from any one of the following values, or from an interval formed by any two of the following values: 1.0, 1.5, 1.6, 2, 2.5, 3, 3.5, 3.6, 4, 4.5, 5, 5.5, 6, etc.

Based on any suitable embodiment in the present application, in some further embodiments, within at least some regions in the non-smooth surface, a ratio of a sum of areas of half-height cross-sections of the ridges to a sum of areas of half-height cross-sections of the grooves is 1 to 36, further optionally 10 to 30. Without limitation, within at least some regions in the non-smooth surface, the ratio of the sum of areas of half-height cross-sections of the ridges to the sum of areas of half-height cross-sections of the grooves may alternatively be selected from any one of the following values, or from an interval formed by any two of the following values: 1, 1.1, 1.2, 1.21, 1.25, 1.3, 1.4, 1.44, 1.5, 1.56, 1.6, 1.69, 1.7, 1.8, 1.9, 1.96, 2, 2.25, 2.5, 2.56, 2.6, 2.8, 2.89, 3, 3.2, 3.24, 3.5, 3.6, 2.61, 4, 4.2, 4.4, 4.5, 4.6, 4.8, 4.84, 4.9, 5, 5.2, 5.4, 5.5, 5.6, 5.8, 6, 6.2, 6.25, 6.4, 6.5, 6.76, 7, 7.2, 7.5, 7.6, 7.8, 7.84, 8, 8.1, 8.2, 8.4, 8.5, 9, 9.5, 9.6, 10, 10.24, 11, 11.56, 12, 12.25, 12.5, 12.6, 12.96, 13, 13.5, 14, 14.44, 14.5, 16, 16.5, 17, 17.5, 18, 18.48, 19, 19.36, 20, 20.25, 21.26, 22, 23.04, 24, 25, 26, 28, 29.16, 30, 30.25, 31.36, 32, 33.64, 34, 35, 36, etc.

Based on any suitable embodiment in the present application, in some further embodiments, within at least some regions in the non-smooth surface, a percentage of a sum of projected areas of the grooves along the longitudinal direction relative to a projected area of the non-smooth surface along the longitudinal direction is 5% to 95%, optionally 5% to 90%, further optionally 5% to 70%, and furthermore optionally 5% to 50%. Without limitation, within at least some regions in the non-smooth surface, the percentage of the sum of projected areas of the grooves along the longitudinal direction relative to the projected area of the non-smooth surface along the longitudinal direction may alternatively be selected from any two of the following percentages or an interval formed by any two of the following percentages: 5%, 6%, 6.4%, 6.5%, 7%, 8%, 9%, 10%, 12%, 15%, 16%, 18%, 20%, 25%, 30%, 35%, 36%, 38%, 40%, 45%, 48%, 50%, 54%, 55%, 56%, 60%, 64%, 65%, 66%, 68%, 70%, 75%, 80%, 81%, 84%, 85%, 90%, 95%, etc. Within at least some regions in the non-smooth surface, the percentage of the sum of projected areas of the grooves along the longitudinal direction relative to the projected area of the non-smooth surface along the longitudinal direction may alternatively be selected from any one of the following ranges: 10%-95%, 10%-90%, 10%-70%, 10%-50%, 15%-95%, 15%-90%, 15%-70%, 15%-50%, 20%-95%, 20%-90%, 20%-70%, 20%-50%, etc.

Based on any suitable embodiment in the present application, in some further embodiments, the tandem solar cell satisfies one or more of the following features (the reference in any one of the following features may alternatively be selected from any suitable value or range in the context):
Within at least some regions in the non-smooth surface, an average spacing of the ridges is 1 µm to 20 µm, optionally 10 µm to 20 µm.

Within at least some regions in the non-smooth surface, an average spacing of the grooves is 1 µm to 20 µm, optionally 10 µm to 20 µm.

A half-height width of at least some of the ridges is greater than a half-height width of an adjacent groove.

Within at least some regions in the non-smooth surface, a ratio of the average half-height width of the ridges to the average half-height width of the grooves is 1 to 6, further optionally 4 to 5.

Within at least some regions in the non-smooth surface, a ratio of a sum of areas of half-height cross-sections of the ridges to a sum of areas of half-height cross-sections of the grooves is 1 to 36, further optionally 10 to 30.

Within at least some regions in the non-smooth surface, a percentage of a sum of projected areas of the grooves along the longitudinal direction relative to a projected area of the non-smooth surface along the longitudinal direction is 5% to 95%, optionally 5% to 90%, and further optionally 5% to 70%.

Optionally, a projected area of at least some regions of the non-smooth surface along the longitudinal direction is greater than or equal to 0.1 mm², further optionally greater than or equal to 0.5 mm², and further optionally greater than or equal to 0.6 mm².

The "percentage of the sum of projected areas of the grooves along the longitudinal direction relative to the projected area of the non-smooth surface along the longitudinal direction" may reflect a proportion of the grooves on the non-smooth surface.

By adjusting one or more parameters including the average spacing of the ridges, the average spacing of the grooves, the ratio of the average half-height width of the ridges to the average half-height width of the grooves, and the ratio of the sum of the areas of the half-height cross-sections of the ridges to the sum of the areas of the half-height cross-sections of the grooves, the density of the grooves and/or the ridges on the non-smooth surface of the first perovskite layer may be adjusted, and the unevenness of the non-smooth surface may be adjusted, thereby adjusting the degree of improvement in the photoelectric conversion effect. Controlling one or more of these parameters within the foregoing ranges allows a concave-convex morphology of the first interface to fully function, enabling the first perovskite layer and/or the second perovskite layer to absorb more photons, which is more beneficial to improving the short-circuit current density and, additionally, better improving the photoelectric conversion efficiency. When external incident light enters from the first electrode, controlling the half-height width of at least some of the ridges to be greater than the half-height width of adjacent grooves is beneficial for more photons that are not utilized by the first perovskite layer among photons initially emitted to the first interface to enter the second perovskite layer.

Based on any suitable embodiment in the present application, in some further embodiments, an opening width of at least some of the grooves is greater than a bottom width thereof.

Based on any suitable embodiment in the present application, in some further embodiments, based on a proportion of the projected areas of the grooves along the longitudinal direction, an opening width of at least 50% of the grooves is greater than a bottom width thereof. Further optionally, an opening width of at least 80% of the grooves is greater than a bottom width thereof. Without limitation, the percentage of the sum of the longitudinal projected areas of the grooves satisfying "the opening width is greater than the bottom width" relative to the sum of the projected areas of all grooves on the non-smooth surface may alternatively be selected from any one of the following percentages, or be greater than or equal to any one of the following percentages, or be selected from an interval formed by any one of the following percentages and 100%, or be selected from an interval formed by any two of the following percentages: 50%, 60%, 70%, 80%, 90%, 95%, 99%, etc. In some embodiments, the opening width of 100% of the grooves is greater than the bottom width. The foregoing percentage values may be determined by a random sampling statistics method.

Based on any suitable embodiment in the present application, in some further embodiments, based on a proportion of the projected areas of the grooves along the longitudinal direction, an opening width of at least some of the grooves is greater than a half-height width thereof, which in turn is greater than a bottom width thereof. Further optionally, an opening width of at least 50% of the grooves is greater than a half-height width thereof, which in turn is greater than a bottom width thereof. Still further optionally, an opening width of at least 80% of the grooves is greater than a half-height width thereof, which in turn is greater than a bottom width thereof. Without limitation, the percentage of the sum of the longitudinal projected areas of the grooves satisfying "the opening width of the grooves is greater than a half-height width thereof, which in turn is greater than a bottom width thereof" relative to the sum of the projected areas of all grooves along the longitudinal direction may alternatively be selected from any one of the following percentages, or be greater than or equal to any one of the following percentages, or be selected from an interval formed by any one of the following percentages and 100%, or be selected from an interval formed by any two of the following percentages: 50%, 60%, 70%, 80%, 90%, 95%, 99%, etc. In some embodiments, the opening width of 100% of the grooves is greater than a half-height width thereof, which in turn is greater than a bottom width thereof. The foregoing percentage values may be determined by a random sampling statistics method.

When the grooves have an overall cross-section "wider at the top and narrower at the bottom", the opening width of the grooves is greater than the bottom width. Further, the opening width is greater than a half-height width thereof, which in turn is greater than a bottom width thereof, thereby being beneficial to increasing the number of photons entering the first perovskite layer, correspondingly improving light absorption, better improving the short-circuit current density, and being additionally beneficial to better improving the photoelectric conversion efficiency.

Based on any suitable embodiment in the present application, in some further embodiments, a bottom width of at least some of the ridges is greater than a top width thereof.

Based on any suitable embodiment in the present application, in some further embodiments, based on a proportion of the projected areas of the ridges along the longitudinal direction, a bottom width of at least 50% of the ridges is greater than a top width thereof. Further optionally, a bottom width of at least 80% of the ridges is greater than a top width thereof. Without limitation, the percentage of the sum of the longitudinal projected areas of the ridges satisfying "the bottom width is greater than the top width" relative to the sum of the projected areas of all ridges on the non-smooth surface may alternatively be selected from any one of the following percentages, or be greater than or equal to any one of the following percentages, or be selected from an interval formed by any one of the following percentages and 100%, or be selected from an interval formed by any two of the following percentages: 50%, 60%, 70%, 80%, 90%, 95%, 99%, etc. In some embodiments, the opening width of 100% of the grooves is greater than the bottom width. The foregoing percentage values may be determined by a random sampling statistics method.

Based on any suitable embodiment in the present application, in some further embodiments, based on a proportion of the projected areas of the ridges along the longitudinal direction, a bottom width of at least some of the ridges is greater than a half-height width thereof, which in turn is greater than a top width thereof. Further optionally, a bottom width of at least 50% of the ridges is greater than a half-height width thereof, which in turn is greater than a top width thereof. Further optionally, a bottom width of at least 80% of the ridges is greater than a half-height width thereof, which in turn is greater than a top width thereof. Without limitation, the percentage of the sum of the longitudinal projected areas of the ridges satisfying "the bottom width is greater than the half-height width, which in turn is greater than a top width thereof" relative to the sum of the projected areas of all ridges on the non-smooth surface may alternatively be selected from any one of the following percentages, or be greater than or equal to any one of the following percentages, or be selected from an interval formed by any one of the following percentages and 100%, or be selected from an interval formed by any two of the following percentages: 50%, 60%, 70%, 80%, 90%, 95%, 99%, etc. In some embodiments, the opening width of 100% of the grooves is greater than a half-height width thereof, which in turn is greater than a bottom width thereof. The foregoing percentage values may be determined by a random sampling statistics method.

When the ridges have an overall cross-section "narrower at the top and wider at the bottom", the bottom width of the ridges is greater than the top width. Further, the bottom width is greater than the half-height width, which in turn is greater than a top width thereof, thereby being beneficial to increasing the number of photons entering the second perovskite layer, correspondingly improving light absorption, better improving the short-circuit current density, and being additionally beneficial to better improving the photoelectric conversion efficiency.

Based on any suitable embodiment in the present application, in some further embodiments, the tandem solar cell satisfies one or more of the following features (the reference in any one of the following features may alternatively be selected from any suitable value or range in the context):
At least some of the grooves have a corner in an extending direction thereof.

At least some of the grooves have at least one segment of non-straight line in an extending direction thereof.

At least some of the grooves have an intersection node therebetween.

At least some of the ridges have a corner in an extending direction thereof.

At least some of the ridges have at least one segment of non-straight line in an extending direction thereof.

At least some of the ridges have an intersection node therebetween.

A deviation of a maximum width within an extending length of at least some of the grooves relative to an average width of the grooves does not exceed 30%.

A deviation of a maximum width within an extending length of at least some of the ridges relative to an average width of the ridges does not exceed 30%.

An extending length of at least some of the grooves is greater than or equal to 50 µm.

An extending length of at least some of the ridges is greater than or equal to 50 µm.

A length-to-width ratio of at least some of the grooves is greater than or equal to 2. Optionally, a length-to-width ratio of at least some of the grooves is greater than or equal to 5.

A length-to-width ratio of at least some of the grooves is 1 to 10, optionally 5 to 10.

A length-to-width ratio of at least some of the ridges is greater than or equal to 2. Optionally, a length-to-width ratio of at least some of the ridges is greater than or equal to 5.

A length-to-width ratio of at least some of the ridges is 1 to 20, optionally 10 to 20.

Based on any suitable embodiment in the present application, in some further embodiments, the length-to-width ratio of at least some of the grooves is greater than 1. Optionally, the length-to-width ratio of at least some of the grooves is greater than or equal to 2. Further optionally, the length-to-width ratio of at least some of the grooves is greater than or equal to 3. Furthermore optionally, the length-to-width ratio of at least some of the grooves is greater than or equal to 5. Without limitation, the length-to-width ratio of at least some of the grooves may alternatively be any one of the following values, or be greater than or equal to any one of the following values, or be selected from an interval formed by any two of the following values: 1.5, 2, 2.5, 3, 3.5, 4, 4.5, 5, 5.5, 6, 6.5, 7, 7.5, 8, 9, 10, etc. The length-to-width ratio of at least some of the grooves may alternatively be in any one of the following ranges: greater than 1 and less than or equal to 10, 2-10, 5-10, etc. Reference may be made to FIG. 1.

Based on any suitable embodiment in the present application, in some further embodiments, the length-to-width ratio of at least some of the ridges is greater than 1. Optionally, the length-to-width ratio of at least some of the ridges is greater than or equal to 3. Further optionally, the length-to-width ratio of at least some of the ridges is greater than or equal to 5. Furthermore optionally, the length-to-width ratio of at least some of the ridges is greater than or equal to 10. More optionally, the length-to-width ratio of at least some of the ridges is greater than or equal to 15. Without limitation, the length-to-width ratio of at least some of the ridges may alternatively be any one of the following values, or be greater than or equal to any one of the following values, or be selected from an interval formed by any two of the following values: 1.5, 2, 3, 4, 5, 6, 7, 8, 9, 10, 11, 12, 13, 14, 15, 16, 17, 18, 19, 20, etc. The length-to-width ratio of at least some of the ridges may alternatively be in any one of the following ranges: greater than 1 and less than or equal to 20, 2-20, 5-20, 10-20, etc. Reference may be made to FIG. 1.

When at least some of the grooves have one or more of the following characteristics in the extending direction: (1) the grooves have a corner in the extending direction thereof; (2) the grooves have at least one segment of non-straight line in the extending direction thereof; and (3) the grooves have intersection nodes, the grooves are more likely to present a random distribution on the non-smooth surface of the first perovskite layer. This is beneficial to shortening a transport distance of photons between two consecutive contacts with the first interface at the grooves, improving the transport efficiency of photons, and thus better increasing the short-circuit current density and photoelectric conversion efficiency. The presence of intersection nodes between different grooves means that the extending directions of these grooves are non-parallel or not completely parallel, enabling different grooves to be communicated.

When at least some of the ridges have one or more of the following characteristics in the extending direction: (1) the ridges have a corner in the extending direction thereof; (2) the ridges have at least one segment of non-straight line in the extending direction thereof; and (3) the ridges have intersection nodes, the ridges are more likely to present a random distribution on the non-smooth surface of the first perovskite layer. This is beneficial to shortening a transport distance of photons between two consecutive contacts with the first interface at the ridge interface, improving the transport efficiency of photons, and thus better increasing the light short-circuit current density and electric conversion efficiency. The presence of intersection nodes between different ridges means that the extending directions of these ridges are non-parallel or not completely parallel, enabling different ridges to be connected.

When the grooves and the ridges respectively satisfy at least one of the foregoing features, it is beneficial to more effectively exerting the cooperation effect between the grooves and the ridges, while increasing the number of photons and light absorption in the first perovskite layer and the second perovskite layer, better improving the short-circuit current density and, additionally, better improving the photoelectric conversion efficiency.

In the present application, unless otherwise specified, when statistically analyzing the "deviation of a maximum width of a groove within an extending length from an average width of the groove" and the "deviation of a maximum width of a ridge within an extending length from an average width of the ridge", the 10% length of end-sealing portions at both ends may be excluded from a statistical scope of the extending length.

Based on any suitable embodiment in the present application, in some further embodiments, the tandem solar cell satisfies one or more of the following features (the reference in any one of the following features may alternatively be selected from any suitable value or range in the context):
An angle between extending directions of at least some two adjacent grooves in an extending length region of at least 30 µm is less than or equal to 30°.

An angle between extending directions of at least some two adjacent ridges in an extending length region of at least 30 µm is less than or equal to 30°.

Based on any suitable embodiment in the present application, in some further embodiments, the tandem solar cell satisfies one or more of the following features (the reference in any one of the following features may alternatively be selected from any suitable value or range in the context):
An angle between extending directions of at least some two adjacent grooves in an extending length of at least 30 µm is less than or equal to 15°. Optionally, an angle between extending directions of at least some two adjacent grooves in an extending length of at least 50 µm is less than or equal to 15°. Further optionally, an angle between extending directions of at least some two adjacent grooves in an extending length of at least 80 µm is less than 15°.

An angle between extending directions of at least some two adjacent grooves in an extending length of at least 50 µm is less than or equal to 30°. Optionally, an angle between extending directions of at least some two adjacent grooves in an extending length of at least 80 µm is less than 30°.

An angle between extending directions of at least some two adjacent ridges in an extending length of at least 30 µm is less than or equal to 15°. Optionally, an angle between extending directions of at least some two adjacent ridges in an extending length of at least 50 µm is less than or equal to 15°. Further optionally, an angle between extending directions of at least some two adjacent ridges in an extending length of at least 80 µm is less than 15°.

An angle between extending directions of at least some two adjacent ridges in an extending length of at least 50 µm is less than or equal to 30°. Optionally, an angle between extending directions of at least some two adjacent ridges in an extending length of at least 80 µm is less than 30°.

Based on any suitable embodiment in the present application, in some further embodiments, one or more of the following features (the reference in any one of the following features may alternatively be selected from any suitable value or range in the context) may be satisfied:
At least some adjacent grooves and ridges have consistent extending directions over an extending length of at least 50 µm.

At least some adjacent grooves and ridges have consistent extending directions over at least 60% of adjacent lengths.

In the present application, unless otherwise specified, "consistent extending directions" means that an angle does not exceed 10°, further optionally does not exceed 5°, and furthermore optionally does not exceed 2°.

By adjusting the angle between the extending directions of two adjacent grooves, the regularity of the grooves in the non-smooth surface of the first perovskite layer may be adjusted. A smaller angle reflects more consistent extending directions of the two adjacent grooves, and a better parallelism. A smaller angle between the extending directions indicates a larger extending length, a higher regularity of the grooves, and a better parallelism between the two adjacent grooves.

By adjusting the angle between the extending directions of two adjacent ridges, the regularity of the ridges in the non-smooth surface of the first perovskite layer may be adjusted. A smaller angle reflects more consistent extending directions of the two adjacent ridges, and a better parallelism. A smaller angle between the extending directions indicates a larger extending length, a higher regularity of the ridges, and a better parallelism between the two adjacent ridges.

When the grooves and the ridges respectively satisfy at least one of the foregoing features, the functions of both the grooves and the ridges may be effectively exerted.

Based on any suitable embodiment in the present application, in some further embodiments, the band gap of the first perovskite layer is greater than the band gap of the second perovskite layer.

When the first perovskite layer is a wide-band gap perovskite layer with a relatively wider band gap and the second perovskite layer is a narrow-band gap perovskite layer with a relatively narrower band gap, the first electrode may be a transparent electrode, the first perovskite sub-cell may be a top cell, and the second perovskite sub-cell may be a bottom cell. At this time, it is beneficial to more effectively utilize the differences of different band gaps of different perovskite layers and thus more fully utilize incident light.

Based on any suitable embodiment in the present application, in some further embodiments, the band gap of the first perovskite layer is 1.2 eV to 2.4 eV, optionally 1.6 eV to 2.3 eV. The band gap of the second perovskite layer is 1.0 eV to 1.4 eV.

By adjusting the band gaps of the perovskite layers, the wavelength ranges of absorbable photons in the perovskite layers may be adjusted. When the band gaps of the first perovskite layer and the second perovskite layer are respectively controlled within the foregoing ranges, it is beneficial to better broadening the absorbable wavelength range of incident light. Combined with a special morphology of the first interface, the first perovskite layer and the second perovskite layer as a whole may achieve a higher total light absorption amount and light utilization rate, thereby better improving the photoelectric conversion efficiency and short-circuit current density.

Based on any suitable embodiment in the present application, in some further embodiments, the first perovskite layer includes a first perovskite-type metal halide. A halogen in the first perovskite-type metal halide includes bromine and iodine. Optionally, the halogen in the first perovskite-type metal halide is a combination of bromine and iodine.

According to the component design of the perovskite-type metal halide in the first perovskite layer, bromine and iodine may be incorporated into the perovskite precursor solution simultaneously. By adjusting an atomic molar ratio of the two elements, various parameters may be adjusted, including: size-related parameters of the grooves and the ridges (e.g., length, width, depth or height, depth-to-width ratio or height-to-width ratio, half-height width, half-height cross-section, and an average value of any of the foregoing parameters), distribution-related parameters (e.g., average spacing, proportion calculation of projected areas of the grooves or the ridges on the non-smooth surface, ratio of an average half-height width of the ridges to an average half-height width of the grooves, and ratio of a sum of areas of the half-height cross-sections of the ridges to a sum of areas of the half-height cross-sections of the grooves), thereby flexibly adjusting the enhancement effect of the concave-convex interface on short-circuit current density and photoelectric conversion efficiency.

Based on any suitable embodiment in the present application, in some further embodiments, the second perovskite layer includes a second perovskite-type metal halide. A halogen in the second perovskite-type metal halide includes iodine. Further optionally, the halogen in the second perovskite-type metal halide is iodine.

Furthermore, by adjusting the halogen components of the perovskite-type metal halides in the first perovskite layer and the second perovskite layer, a band gap difference between two light-absorbing layers and the morphology of a first interface may be adjusted, thereby broadening the absorbable wavelength range of incident light, promoting more photons to enter the perovskite layers in the tandem solar cell through the first interface, and improving the comprehensive performance of short-circuit current density and photoelectric conversion efficiency.

Based on any suitable embodiment in the present application, in some further embodiments, an atomic molar ratio of bromine to iodine in the first perovskite-type metal halide is (3-y):y, where 0<y≤2. Optionally, 1≤y≤2. Non-limiting instances of y may further include the following values: 0.3, 0.4, 0.5, 0.6, 2/3, 0.7, 0.75, 0.8, 0.9, 1.0, 1.1, 1.2, 1.3, 1.4, 1.5, 1.6, 1.8, 1.9, 2, etc, and y may alternatively be selected from an interval formed by any two of the foregoing values.

In some embodiments, the atomic molar ratio of bromine to iodine is 2:3. At this time, y is 1.8.

In some embodiments, the atomic molar ratio of bromine to iodine is 1:2. At this time, y is 2.

According to the component design of the perovskite-type metal halide in the first perovskite layer, the atomic molar ratio of bromine to iodine in the perovskite precursor solution may be adjusted, thereby adjusting the comprehensive performance of the short-circuit current density and photoelectric conversion efficiency of the tandem solar cell. By adjusting the atomic molar ratio of bromine to iodine in the perovskite-type metal halide of the first perovskite layer within the foregoing range, the short-circuit current density of the tandem solar cell can be improved effectively, and the photoelectric conversion efficiency can be improved.

Without limitation, a chemical composition of the first perovskite-type metal halide is ABX₃, where A is a monovalent cation, B is a divalent metal ion, and X is a halogen anion. Optionally, A in the first perovskite-type metal halide includes one or more of alkali metal ions, monovalent amine cations, and monovalent amidinium cations. Optionally, B in the first perovskite-type metal halide includes one or more of Pb²⁺, Be²⁺, Mg²⁺, Ca²⁺, Sr²⁺, Ba²⁺, Zn²⁺, Ge²⁺, Fe²⁺, Co²⁺, and Ni²⁺. Optionally, X in the first perovskite-type metal halide includes at least one of Br⁻ and I⁻. As a non-limiting instance, A in the first perovskite-type metal halide includes one or more of CH(NH₂)₂⁺, CH₃NH₃⁺, Li⁺, Na⁺, K⁺, Rb⁺, and Cs⁺.

Non-limiting instances of monovalent amine cations include, for example, CH₃NH₃⁺ (methylamine, MA⁺) and ammonium (NH₄⁺). Non-limiting instances of monovalent amidinium cations include, for example, NH₂CH=NH₂⁺ (formamidinium, which may be denoted as FA⁺).

In some embodiments, A in the first perovskite-type metal halide includes one or more of CH(NH₂)₂⁺, CH₃NH₃⁺, Li⁺, Na⁺, K⁺, Rb⁺, and Cs⁺.

In some embodiments, in the first perovskite-type metal halide, A includes CH(NH₂)₂⁺ and Cs⁺, B includes Pb²⁺, and X includes Br⁻ and I⁻. A molar ratio of CH(NH₂)₂⁺ to Cs⁺ is (1-a):a, where 0<a<1. Optionally, a ranges from 0.3 to 0.9. Further optionally, a is any one of the following values, or may be selected from a ratio formed by any two of the following values: 0.3, 0.4, 0.5, 0.6, 0.7, 0.8, 0.9, etc. In some of the embodiments, the molar ratio of CH(NH₂)₂⁺ to Cs⁺ is 3:2. Further, the atomic molar ratio of bromine to iodine may be 2:3 or 1:2.

Without limitation, a chemical composition of the second perovskite-type metal halide is MNY₃, where M is a monovalent cation, N is a divalent metal ion, and Y is a halogen anion. Optionally, M in the second perovskite-type metal halide includes one or more of alkali metal ions, monovalent amine cations, and monovalent amidinium cations. Optionally, N in the second perovskite-type metal halide includes one or both of Sn²⁺ and Pb²⁺. Optionally, Y in the second perovskite-type metal halide includes I⁻.

In some embodiments, M in the second perovskite-type metal halide includes one or more of CH(NH₂)₂+, CH₃NH₃⁺, Li⁺, Na⁺, K⁺, Rb⁺, and Cs⁺.

In some embodiments, in the second perovskite-type metal halide, M includes CH(NH₂)₂⁺ and CH₃NH₃⁺, N includes Pb²⁺ and Sn²⁺, and Y includes I⁻. The molar ratio of CH(NH₂)₂⁺ to CH₃NH₃⁺ is 7:3, and the molar ratio of Pb²⁺ to Sn²⁺ is 1:1.

A suitable perovskite-type metal halide may be selected according to performance and process control requirements of a perovskite film.

Based on any suitable embodiment in the present application, in some further embodiments, at least some perovskite grains in the first perovskite layer are through-type grains. Both ends of the through-type grains along the longitudinal direction are located on surfaces of two sides of the first perovskite layer respectively.

When the perovskite grains in the first perovskite layer include through-type grains along the thickness direction (i.e., the longitudinal direction) of the first perovskite layer, it means that these perovskite grains grow continuously in the longitudinal direction. There are few cracks in the longitudinal cross-section of the first perovskite layer, and the grains appear as large-sized grains that run through longitudinally. At this time, the through-type grains that run through the first perovskite layer along the longitudinal direction are beneficial to smoother and more efficient carrier transport, reducing non-radiative recombination caused by grain interfaces, and improving the short-circuit current density and photoelectric conversion efficiency of a device.

In the present application, unless otherwise specified, the "lateral dimension" of the perovskite grains in the first perovskite layer refers to a maximum dimension among dimensions in all directions of the grains in a lateral cross-section of the first perovskite layer. Statistical analysis may be performed based on a longitudinal cross-sectional image and a lateral cross-sectional image of the first perovskite layer. The longitudinal cross-sectional image and the lateral cross-sectional image of the first perovskite layer may be obtained by an SEM, an optical microscopy, and the like. Semi-quantitative analysis of the lateral dimension of the grains may be performed based on a grain width in the longitudinal cross-sectional image, and quantitative statistical analysis data of the grain lateral dimension may further be obtained through the analysis of longitudinal cross-sectional images at different positions and in different directions. Quantitative statistics of the lateral dimension of the grains may be performed based on the lateral cross-sectional image.

In the present application, when performing statistical analysis on the grain size in the first perovskite layer, a data acquisition amount is appropriately selected according to the shape, size, uniformity, distribution mode, and the like of the grains. For example, a minimum data acquisition amount may be determined by controlling a standard deviation of an average value to be less than or equal to 10% of the average value.

Based on any suitable embodiment in the present application, in some further embodiments, a lateral dimension of at least some of the through-type grains is greater than or equal to 400 nm, where a lateral direction is orthogonal to the longitudinal direction. The lateral dimension of the through-type grains refers to a maximum dimension among dimensions in all directions of the grains in a lateral cross-section.

In the present application, unless otherwise specified, "at least a portion" in "at least some of the through-type grains" may be calculated based on the number of grains, the lateral area of the grains, or the volume of the grains. In terms of quantity, "at least a portion" may be greater than or equal to any one of the following percentages: 30%, 40%, 50%, 60%, 70%, 80%, 90%, 95%, 99%, etc.

Without limitation, the lateral dimension of at least some of the through-type grains may alternatively be greater than or equal to any one of the following dimensions: 0.4 µm, 400 nm, 0.5 µm, 500 nm, 0.6 µm, 600 nm, 0.7 µm, 0.8 µm, 800 nm, 0.9 µm, 1.0 µm, 1.2 µm, etc. In some embodiments, the lateral dimension of at least some of the through-type grains is greater than or equal to 0.400 nm, optionally greater than or equal to 500 nm.

Without limitation, the lateral dimension of at least some of the through-type grains may alternatively be selected from any one of the following dimensions, or from an interval formed by any two of the following dimensions: 0.4 µm, 400 nm, 0.5 µm, 500 nm, 0.6 µm, 600 nm, 0.7 µm, 0.8 µm, 800 nm, 0.9 µm, 1.0 µm, 1.2 µm, 1.4 µm, 1.5 µm, 1.6 µm, 1.8 µm, 2 µm, etc.

Without limitation, an average lateral dimension of the through-type grains is 300 nm to 2 µm, optionally 400 nm to 1 µm, and further optionally 500 nm to 800 nm. The average lateral dimension of the through-type grains may alternatively be selected from any one of the following dimensions, or from an interval formed by any two of the following dimensions: 0.3 µm, 400 nm, 0.3 µm, 400 nm, 0.5 µm, 0.6 µm, 0.7 µm, 0.8 µm, 0.9 µm, 1.0 µm, 1.2 µm, 1.4 µm, 1.5 µm, 1.6 µm, 1.8 µm, 2 µm, etc.

By controlling the lateral dimension of the through-type grains, the number of interfaces between the perovskite grains may be adjusted. A larger lateral dimension indicates fewer through-seams between grains, which in turn results in fewer defects and higher quality of the perovskite layers. When the lateral dimension of the through-type grains is controlled within the foregoing range, it is beneficial to fully exerting the promoting effect of the aforementioned through-type grains.

Based on any suitable embodiment in the present application, in some further embodiments, within at least some width regions of the longitudinal cross-section of the first perovskite layer, an area percentage of the through-type grains relative to the longitudinal cross-section is greater than or equal to 80%, optionally greater than or equal to 90%. Without limitation, the area percentage of the through-type grains relative to the longitudinal cross-section may alternatively be selected from any one of the following percentages, or be greater than or equal to any one of the following percentages, or be selected from an interval formed by any two of the following percentages: 80%, 85%, 90%, 95%, etc. Optionally, at least some width regions of the longitudinal cross-section of the first perovskite layer corresponds to a width region of at least 10 µm.

By controlling the area ratio of the through-type grains in the longitudinal cross-section of the first perovskite layer, the effect exertion of the through-type grains may be adjusted. When the area percentage of the through-type grains relative to the longitudinal cross-section of the first perovskite layer is controlled within the foregoing range, it is beneficial to more fully exerting the advantages of the through-type grains, and more beneficial to the improvement of carrier transport and photoelectric conversion efficiency.

Based on any suitable embodiment in the present application, in some further embodiments, in the longitudinal cross-section of the first perovskite layer, an area percentage of the through-type grains with a lateral dimension greater than or equal to 400 nm relative to the longitudinal cross-section is greater than or equal to 80%, optionally greater than or equal to 90%. Without limitation, the area percentage of the through-type grains with a lateral dimension greater than or equal to 600 nm relative to the longitudinal cross-section may alternatively be selected from any one of the following percentages, or be greater than or equal to any one of the following percentages, or be selected from an interval formed by any two of the following percentages: 80%, 85%, 90%, etc.

By controlling the area ratio of large-sized through-type grains in the longitudinal cross-section of the first perovskite layer, the effect exertion of the through-type grains may be adjusted. When the area percentage of through-type grains with a certain lateral dimension relative to the longitudinal cross-section of the first perovskite layer is controlled within the foregoing range, it is beneficial to more fully exerting the advantages of the through-type grains, and more beneficial to the improvement of carrier transport and photoelectric conversion efficiency.

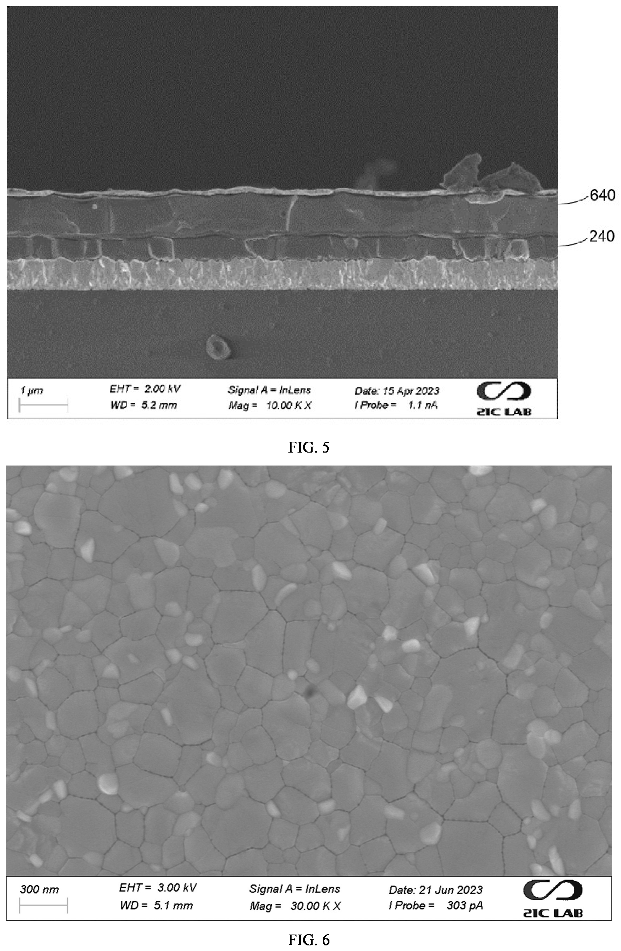

FIG. 4 is an SEM image of a longitudinal cross-section of a tandem solar cell in an embodiment of the present application. FIG. 5 is an SEM image of a longitudinal cross-section of a tandem solar cell in another embodiment of the present application. In the first perovskite layer, a large number of longitudinally through-type grains may be observed, with large lateral dimensions. There are few broken grains in the first perovskite layer. Furthermore, in the examples shown in FIG. 4 and FIG. 5, the second perovskite layer is also prepared by the vacuum flash evaporation method. Similarly, in the second perovskite layer, a large number of longitudinally through-type grains may be observed, with large lateral dimensions. There are few broken grains in the second perovskite layer.

FIG. 9 is an SEM image of a longitudinal cross-section of a tandem solar cell prepared by an anti-solvent method in a comparative example of the present application. A first perovskite layer is prepared by the anti-solvent method. A surface of the first perovskite layer away from the first electrode is a flat and smooth surface. A first electrode is a transparent electrode. In the comparative example of FIG. 9, when optical microscope observation is performed from the transparent electrode layer of the tandem solar cell, no obvious wrinkled textures are observed between a wide-band gap perovskite layer and a narrow-band gap perovskite layer. In FIG. 9, there are few longitudinally through-type grains and more broken grains in the first perovskite layer, and the lateral dimensions of the grains are also small. According to the analysis of a grain area in the longitudinal cross-section of the first perovskite layer, an area ratio of the longitudinally through-type grains in the first perovskite layer of FIG. 9 is less than 50%.

In some embodiments, the thickness of the first perovskite layer may be 300 nm to 500 nm, and further may be 400 nm.

In some embodiments, the thickness of the second perovskite layer may be 300 nm to 500 nm, and further may be 400 nm.

In some embodiments, referring to FIG. 11, a tandem solar cell 10 includes a substrate layer 100, a first perovskite sub-cell 200, a carrier recombination layer 410, and a second perovskite sub-cell 600 that are sequentially stacked. The first perovskite sub-cell 200 includes a first electrode 220, a first carrier transport layer 230, a first perovskite layer 240, and a second carrier transport layer 250 that are sequentially stacked. The second perovskite sub-cell 600 includes a third carrier transport layer 630, a second perovskite layer 640, a fourth carrier transport layer 650, and a second electrode 660 that are sequentially stacked. The first electrode 220, the first carrier transport layer 230, the first perovskite layer 240, the second carrier transport layer 250, the carrier recombination layer 410, the third carrier transport layer 630, the second perovskite layer 640, the fourth carrier transport layer 650, and the second electrode 660 are sequentially stacked. At this time, the second carrier transport layer 250 is located between the first perovskite layer 240 and the carrier recombination layer 410. The third carrier transport layer 630 is located between the carrier recombination layer 410 and the second perovskite layer 640. The second carrier transport layer 250, the carrier recombination layer 410, and the third carrier transport layer 630 constitute an intermediate interconnection layer 400. An interface between the intermediate interconnection layer 400 and the first perovskite layer 240 corresponds to the aforementioned first interface. Further, the second carrier transport layer and the third carrier transport layer on both sides of the carrier recombination layer are heterogeneous carrier transport layers, where one is an electron transport layer and the other is a hole transport layer. One of the first carrier transport layer and the second carrier transport layer is an electron transport layer, and the other is a hole transport layer. One of the third carrier transport layer and the fourth carrier transport layer is an electron transport layer, and the other is a hole transport layer. Therefore, both the first carrier transport layer and the third carrier transport layer are electron transport layers or are hole transport layers. Correspondingly, both the second carrier transport and the fourth carrier transport layer are hole transport layers or are electron transport layers.

In some embodiments, both the first carrier transport layer and the third carrier transport layer are electron transport layers, and both the second carrier transport layer and the fourth carrier transport layer are hole transport layers.

In some other embodiments, both the first carrier transport layer and the third carrier transport layer are hole transport layers, and both the second carrier transport layer and the fourth carrier transport layer are electron transport layers.

In some embodiments, the perovskite-based tandem solar cell includes a first electrode and a second electrode, one of which is a positive electrode and the other is a negative electrode. The first electrode is located at the end of the first perovskite sub-cell away from the carrier recombination layer. The second electrode is located at the end of the second perovskite sub-cell away from the carrier recombination layer. The positive electrode may collect electron carriers transported via the electron transport layer. The negative electrode may collect hole carriers transported via the hole transport layer.

At least one of the first electrode and the second electrode is a transparent electrode for light incidence. In some examples, the first electrode is a transparent electrode.

In some embodiments, one of the first electrode and the second electrode is a transparent electrode, and the other is a metal electrode. In some embodiments, the first electrode is a transparent electrode, and the second electrode is a metal electrode.

Without limitation, the tandem perovskite-based tandem solar cell further includes a substrate layer. A substrate may be arranged on the side of the first electrode away from the carrier recombination layer, or on the side of the second electrode away from the carrier recombination layer. In some embodiments, the tandem cell includes a substrate layer, a first perovskite sub-cell, a carrier recombination layer, and a second perovskite sub-cell that are sequentially arranged. In some embodiments, the tandem cell includes a substrate layer, a first electrode, a first carrier transport layer, a first perovskite layer, a second carrier transport layer, a carrier recombination layer, a third carrier transport layer, a second perovskite layer, a fourth carrier transport layer, and a second electrode that are sequentially arranged. In some embodiments, the tandem cell includes a substrate layer, a first electrode, a first carrier transport layer, a first perovskite layer, an intermediate interconnection layer, a second perovskite layer, a fourth carrier transport layer, and a second electrode that are sequentially arranged. The intermediate interconnection layer may include a second carrier transport layer, a carrier recombination layer, and a third carrier transport layer. The second carrier transport layer is located between the first perovskite layer and the carrier recombination layer. The third carrier transport layer is located between the carrier recombination layer and the second perovskite layer. Further, the second carrier transport layer and the third carrier transport layer on both sides of the carrier recombination layer are heterogeneous carrier transport layers, where one is an electron transport layer and the other is a hole transport layer.

In the embodiments or examples of the present application, the substrate layer involved may be, but is not limited to, a glass substrate or a flexible substrate. Without limitation, the flexible substrate may include one or more materials such as polyethylene terephthalate, polyimide, polyethylene, polypropylene, polystyrene, and polyethylene naphthalate. Unless otherwise specified, the substrate layer is a transparent substrate.

In some embodiments, the substrate layer is a flexible substrate layer. Further, the material of the substrate layer may be, for example (but not limited to), an organic polymer material. Further, the material may be a mixture of one or more of the following materials in different proportions, including but not limited to polyvinyl alcohol (PVA), polyester (PET), polyimide (PI), polyethylene naphthalate (PEN), polydimethylsiloxane (PDMS), and the like.

Taking the case where the first electrode is a transparent electrode and the transparent substrate layer is located on the side of the first electrode away from the carrier recombination layer (i.e., on the side of the first perovskite sub-cell) as an example: during the operation of the tandem perovskite-based tandem solar cell, incident light is partially absorbed by the first perovskite layer, and partially passes through the first perovskite layer and the first interface to be absorbed by the second perovskite layer. After the two perovskite light-absorbing layers receive photons, internal electrons gain energy and are separated from the light-absorbing layers to form negatively charged electron carriers, while positively charged hole carriers are formed, thereby generating electron-hole pairs. Free electrons and free holes are transmitted in opposite directions through the corresponding transport layers, making the electrons and the holes flow. One of the second carrier transport layer and the third carrier transport layer on both sides of the carrier recombination layer is an electron transport layer, and the other is a hole transport layer. Electrons and holes from both sides of the carrier recombination layer are recombined in the carrier recombination layer, so that the first perovskite sub-cell and the second perovskite sub-cell are connected in series, thereby forming a current in the tandem solar cell and realizing the conversion of light energy to electrical energy.

When both the first carrier transport layer and the third carrier transport layer are electron transport layers and both the second carrier transport layer and the fourth carrier transport layer are hole transport layers, free electrons are collected by the first electrode via the first carrier transport layer, and free holes are collected by the second electrode via the fourth carrier transport layer, thereby forming an optical circuit in the tandem solar cell.

The electron transport layer can extract and transport the electron carriers, and can block the passage of the free holes.

The hole transport layer can extract and transport the hole carriers, and can block the passage of the free electrons.

In some embodiments, the material of the transparent electrode may be, for example, but is not limited to, one or more of the following materials: fluorine-doped tin oxide (FTO), indium-doped tin oxide (ITO), aluminum-doped zinc oxide (AZO), boron-doped zinc oxide (BZO), indium zinc oxide (IZO), tungsten-doped indium oxide (IWO), and the like.

In some embodiments, the transparent electrode mainly includes a transparent conductive material. The transparent conductive material may include a transparent conductive oxide. Without limitation, the transparent conductive oxide in the transparent electrode may include one or more of indium tin oxide, fluorine-doped tin oxide, indium-doped tungsten oxide, indium-doped zinc oxide, and aluminum-doped zinc oxide.

In some embodiments, the metal electrode mainly includes a metal material. The metal material may include one or more of gold, silver, copper, aluminum, nickel, chromium, bismuth, platinum, magnesium, molybdenum, tungsten, and the like.

In the present application, when the composition involves "mainly including one or more of substances a1, a2, ..., etc.", unless otherwise specified, "mainly including" means that a mass percentage content is at least 80%, may be greater than or equal to 90%, 95%, 98%, etc., or may be 100%. When the mass percentage content is 100%, "mainly including one or more of substances a1, a2, ..., etc." means being composed of one or more of substances a1, a2, ..., etc.

In some embodiments, an electron transport material (which may be denoted as a first electron transport material) in the electron transport layer of the first perovskite sub-cell includes an N-type semiconductor. The first electron transport material may include, but is not limited to, one or more of the following materials: bathocuproine, [6,6]-phenyl-C₆₁-butyric acid isomethyl ester, [6,6]-phenyl-C₇₁-butyric acid methyl ester, C₆₀, C₇₀, tin oxide (SnOₓ, where x ranges from 1.5 to 2), zinc oxide and its derivatives, and modified products of any one of the aforementioned materials through doping or passivation.

In some embodiments, a hole transport material (which may be denoted as a first hole transport material) in the hole transport layer of the first perovskite sub-cell includes a P-type semiconductor. The first hole transport material may include, but is not limited to, one or more of the following materials: carbazole phosphate materials (non-limiting instances of carbazole phosphate materials include [4-(3,6-dimethoxy-9H-carbazol-9-yl)butyl]phosphonic acid (MeO-4PACz)), poly[bis(4-phenyl)(2,4,6-trimethylphenyl)amine], poly-3-hexylthiophene, triphenylene-core triphenylamine, 3,4-ethylenedioxythiophene-methoxytriphenylamine, N-(4-aniline)carbazole-spirobifluorene, poly(3,4-ethylenedioxythiophene):poly(styrenesulfonic acid) (PEDOT:PSS), polythiophene, nickel oxide, molybdenum oxide, cuprous iodide, cuprous oxide and its derivatives, and modified products of any one of the aforementioned materials through doping or passivation.

Without limitation, the material of the carrier recombination layer may include at least one of a transparent conductive oxide and a metal element. Without limitation, the transparent conductive oxide in the carrier recombination layer may include one or more of indium tin oxide, fluorine-doped tin oxide, indium-doped tungsten oxide, indium-doped zinc oxide, and aluminum-doped zinc oxide. The metal element in the carrier recombination layer may include one or more of gold, silver, copper, aluminum, nickel, chromium, bismuth, platinum, magnesium, molybdenum, tungsten, and the like.

In some embodiments, an electron transport material (which may be denoted as a second electron transport material) in the electron transport layer of the second perovskite sub-cell includes an N-type semiconductor. The second electron transport material may include, but is not limited to, one or more of the following materials: bathocuproine, [6,6]-phenyl-C₆₁-butyric acid isomethyl ester, [6,6]-phenyl-C₇₁-butyric acid methyl ester, C₆₀, C₇₀, tin oxide (SnOₓ, where x ranges from 1.5 to 2), zinc oxide and its derivatives, and modified products of any one of the aforementioned materials through doping or passivation.

In some embodiments, a hole transport material (which may be denoted as a second hole transport material) in the hole transport layer of the second perovskite sub-cell includes a P-type semiconductor. The second hole transport material may include, but is not limited to, one or more of the following materials: carbazole phosphate materials (non-limiting instances of carbazole phosphate materials include [4-(3,6-dimethoxy-9H-carbazol-9-yl)butyl]phosphonic acid), poly[bis(4-phenyl)(2,4,6-trimethylphenyl)amine], poly-3-hexylthiophene, triphenylene-core triphenylamine, 3,4-ethylenedioxythiophene-methoxytriphenylamine, N-(4-aniline)carbazole-spirobifluorene, poly(3,4-ethylenedioxythiophene):poly(styrenesulfonic acid) (PEDOT:PSS), polythiophene, nickel oxide, molybdenum oxide, cuprous iodide, cuprous oxide and its derivatives, and modified products of any one of the aforementioned materials through doping or passivation.

Based on any suitable embodiment in the present application, in some further embodiments, a heterogeneous carrier blocking layer is arranged on at least one side of one or more carrier transport layers among the first carrier transport layer, the second carrier transport layer, the third carrier transport layer, and the fourth carrier transport layer.

In some embodiments, referring to FIG. 12, a tandem solar cell 10 includes a substrate layer 100, a first perovskite sub-cell 200, a carrier recombination layer 410, and a second perovskite sub-cell 600 that are sequentially stacked. The first perovskite sub-cell 200 includes a first electrode 220, a first carrier transport layer 230, a first perovskite layer 240, and a second carrier transport layer 250 that are sequentially stacked. The second perovskite sub-cell 600 includes a third carrier transport layer 630, a second perovskite layer 640, a fourth carrier transport layer 650, and a second electrode 660 that are sequentially stacked. The first electrode 220, the first carrier transport layer 230, the first perovskite layer 240, the second carrier transport layer 250, the carrier recombination layer 410, the third carrier transport layer 630, the second perovskite layer 640, the fourth carrier transport layer 650, and the second electrode 660 are sequentially stacked. Both the fourth carrier transport layer and the second carrier transport layer are electron transport layers. Both the third carrier transport layer and the first carrier transport layer are hole transport layers. The side of the fourth carrier transport layer 650 close to the second perovskite layer 640 includes a second hole-blocking layer 6501. The side of the second carrier transport layer 250 close to the first perovskite layer 240 includes a first hole-blocking layer 2501. The second carrier transport layer 250, the carrier recombination layer 410, and the third carrier transport layer 630 constitute an intermediate interconnection layer 400. An interface between the intermediate interconnection layer 400 and the first perovskite layer 240 corresponds to the aforementioned first interface.

Based on any suitable embodiment in the present application, in some further embodiments, a heterogeneous carrier blocking layer may be independently arranged for any one of the first carrier transport layer, the second carrier transport layer, the third carrier transport layer, and the fourth carrier transport layer. In some of the embodiments, for any one of the aforementioned transport layers, the heterogeneous carrier blocking layer may be independently arranged on at least one side of the transport layer.

Based on any suitable embodiment in the present application, in some further embodiments, the tandem solar cell satisfies one or more of the following features (the reference in any one of the following features may alternatively be selected from any suitable value or range in the context):
Both a first carrier transport layer and a third carrier transport layer are electron transport layers, and both a second carrier transport layer and a fourth carrier transport layer are hole transport layers. Alternatively, both the first carrier transport layer and the third carrier transport layer are hole transport layers, and both the second carrier transport layer and the fourth carrier transport layer are electron transport layers.

The tandem solar cell further includes a first electrode and a second electrode. The first electrode is located on a side of the first perovskite sub-cell away from the carrier recombination layer. The second electrode is located on a side of the second perovskite sub-cell away from the carrier recombination layer. The first electrode is a transparent electrode.

At least one side of the first carrier transport layer includes a heterogeneous carrier blocking layer.

At least one side of the second carrier transport layer includes a heterogeneous carrier blocking layer.

At least one side of the third carrier transport layer includes a heterogeneous carrier blocking layer.

At least one side of the fourth carrier transport layer includes a heterogeneous carrier blocking layer.

Both the first perovskite sub-cell and the second perovskite sub-cell may be of an n-i-p type or a p-i-n type.

When the first electrode is a transparent electrode, incident light entering the tandem solar cell may enter from the side of the first electrode. At this time, when the incident light is first emitted to the first interface from the side of the first perovskite layer, the first interface is beneficial to exerting the aforementioned effect of improving the comprehensive performance of short-circuit current density and photoelectric conversion efficiency.

Furthermore, the heterogeneous carrier blocking layer may be arranged on at least one side of one or more carrier transport layers among the first carrier transport layer, the second carrier transport layer, the third carrier transport layer, and the fourth carrier transport layer, to block the transport of heterogeneous carriers, thereby helping to reduce the recombination probability of electrons-holes.

In some embodiments, the material composition of the hole blocking layer (which may be denoted as a first hole blocking layer) in the first perovskite sub-cell includes one or more of fullerene and its derivatives, and SnOₓ (where x ranges from 1.5 to 2). Non-limiting instances of fullerene may include one or more of C60, C61, C70, etc.

In some embodiments, the material composition of the hole blocking layer (which may be denoted as a second hole blocking layer) in the second perovskite sub-cell includes one or more of fullerene and its derivatives, and SnOₓ (where x ranges from 1.5 to 2). Non-limiting instances of fullerene may include one or more of C60, C61, C70, etc.

In some embodiments, the thickness of the electron transport layer may be 20 nm.

In some embodiments, when the corresponding blocking layers are present, the thicknesses of the first hole blocking layer and the second hole blocking layer are each independently 10 nm.

In some embodiments, the hole transport layer and the thickness may be 20 nm.

Based on any suitable embodiment in the present application, in some further embodiments, the first perovskite sub-cell and the second perovskite sub-cell form a two-terminal integrated structure.

Based on any suitable embodiment in the present application, in some further embodiments, the tandem solar cell is a two-terminal tandem solar cell.

Based on any suitable embodiment in the present application, in some further embodiments, the tandem solar cell is an all-perovskite tandem solar cell.

Taking an all-perovskite tandem solar cell (where the first perovskite sub-cell is a wide-band gap perovskite sub-cell and the second perovskite sub-cell is a narrow-band gap perovskite sub-cell) as an example of tandem solar cells containing perovskite layers, the conventional preparation method involves first using a solvent method to prepare the wide-band gap perovskite layer on the carrier transport layer, and then depositing each functional layer of the intermediate interconnection layer and the narrow-band gap perovskite layer sequentially. Solvents in the functional layers other than the perovskite layer (e.g., the carrier transport layers) are usually removed by thermal evaporation, which requires a plurality of high-temperature processes. The accumulation of these high-temperature processes is equivalent to annealing the wide-band gap perovskite layer in the bottom sub-cell, which easily reduces the photoelectric conversion efficiency of the bottom wide-band gap perovskite sub-cell. In some embodiments, the third carrier transport layer is prepared by a vacuum flash evaporation process. The high-temperature treatment process of the first perovskite layer helps reduce the efficiency degradation of the first perovskite layer sub-cell caused by subsequent processes. In some further embodiments, both the third carrier layer and the second perovskite layer are prepared by the vacuum flash evaporation process.

In the present application, unless otherwise specified, any perovskite layer in the perovskite-based tandem solar cell may be tested and analyzed on the surface of the perovskite layer after disassembly using the following method: Taking the case where the electron transport layer is C60/BCP and the second electrode is a Cu electrode located on the surface of the side of the electron transport layer away from the light-absorbing layer as an example, the tandem solar cell may be disassembled by removing the first electrode and the second electrode (e.g., Cu electrode), and the electron transport layer (e.g., C60/BCP) may be washed away using an anti-solvent (e.g., chlorobenzene) suitable for the corresponding perovskite layer. The second electrode is removed by methods such as tape peeling.

It should be understood that the structure of the perovskite sub-cells involved in the present application is not limited to the structural layers listed above. Other functional layers, such as buffer layers and intercalation layers, may be introduced as needed. In some embodiments, the perovskite sub-cell may be provided with a buffer layer with a suitable energy level, which may perform one or more functions: reducing energy level barriers, promoting energy level matching, improving carrier extraction efficiency, passivating interface defect states, protecting the light-absorbing layer, inhibiting oxidation and decomposition of the cell by water molecules and oxygen, increasing photoelectric conversion efficiency, and improving the stability of the perovskite sub-cell and the tandem solar cell. Depending on different positions of the buffer layers, the types of the buffer layers may include four categories: buffer layers between the hole transport layer and an anode, buffer layers between the electron transport layer and a cathode, buffer layers between the hole transport layer and an absorption layer, and buffer layers between the electron transport layer and the absorption layer. Materials applicable for the buffer layer in the tandem solar cell may include, but are not limited to: Cu2O, NiO, AZO, TiO2, etc. In some embodiments, an intercalation layer may be arranged between the electron transport layer and an adjacent electrode. Instances of the material of the intercalation layer include bathocuproine (BCP).

According to a second aspect of the present application, a preparation method for a perovskite-based tandem solar cell described according to the first aspect of the present application is provided, including the following steps: sequentially stacking a first carrier transport layer, a first perovskite layer, a second carrier transport layer, a carrier recombination layer, a third carrier transport layer, a second perovskite layer, a fourth carrier transport layer, and a second electrode on a surface of one side of a first electrode, to obtain the perovskite-based tandem solar cell.

A method for stacking the first perovskite layer on a side of the first carrier transport layer away from the first electrode includes the following steps:
coating a precursor solution I of the first perovskite layer onto a surface of the side of the first carrier transport layer away from the first electrode, to form a coating layer I; and
performing vacuum flash evaporation treatment and annealing treatment on the coating layer I to form the first perovskite layer, with a non-smooth surface formed on the side of the first perovskite layer away from the first electrode.

The first perovskite layer is prepared via a vacuum flash evaporation process. The aforementioned groove and ridge morphologies may be formed on the surface of the side of the first perovskite layer close to the carrier recombination layer, thereby increasing the amount of photons in contact with the perovskite layers and light utilization efficiency, improving the short-circuit current density of the tandem solar cell, and also improving the photoelectric conversion efficiency. Furthermore, the formation of large-sized through-type grains may be promoted, and the carrier transport and the photoelectric conversion efficiency may be promoted.

Based on the principle of preparing a perovskite layer by vacuum flash evaporation treatment, after a perovskite wet film formed by spin-coating is placed in a vacuum flash evaporation apparatus, an atmosphere inside the apparatus is pumped out by a vacuum pump, making an internal pressure much lower than the atmospheric pressure, thereby reducing a saturated vapor pressure of a solvent in the perovskite wet film. A boiling point of the solvent in the wet film drops below the room temperature within a few seconds, causing the solvent to evaporate from the wet film and be continuously pumped away, thereby achieving the effect of removing the solvent and promoting crystallization.

Without limitation, a precursor solution for any perovskite layer may be prepared by: preparing perovskite precursor materials according to a stoichiometric ratio of the perovskite-type metal halide in the perovskite layer, dissolving the perovskite precursor materials in the solvent to form a mixed solution, stirring for 1 h, and filtering through a 0.22 µm organic filter membrane to obtain the perovskite precursor solution. In the present application, unless otherwise specified, the perovskite precursor solution refers to a perovskite precursor solution.

Taking the precursor solution for preparing the first perovskite layer as an example (where the perovskite-type metal halide is CsₐFA₁₋ₐPbI_{3-y}Br_{y} (0<a<1, 0<y≤1.2)), the perovskite precursor materials may be a combination of lead iodide, lead bromide, formamidinium bromide, formamidinium iodide, cesium iodide, and cesium bromide. An active material of the perovskite absorption layer is a CsFA system.

Without limitation, in the process of preparing the first perovskite layer, the preparation method for a perovskite-based tandem solar cell may further satisfy one or more of the following features:
The vacuum flash evaporation treatment is performed under a negative pressure. Optionally, the negative pressure is less than or equal to 100 Pa, further optionally 50 Pa to 100 Pa.

A temperature for the vacuum flash evaporation treatment is -10°C to 100°C, optionally 0°C to 30°C, and further optionally 20°C to 30°C.

A duration of the vacuum flash evaporation treatment is 10 s to 100 s, optionally 10 s to 30 s, and further optionally 15 s to 25 s.

The annealing treatment is performed using a hot stage, optionally a hot stage at 30°C to 200°C, further optionally a hot stage at 90°C to 110°C, and still further optionally a hot stage at 98°C to 102°C.

An annealing duration of the annealing treatment is 30 s to 60 min, optionally 5 min to 20 min, and further optionally 14 min to 16 min.

Based on any suitable embodiment in the present application, in some further embodiments, the step of coating a precursor solution I of the first perovskite layer onto a surface of the side of the first carrier transport layer away from the first electrode includes:
spin-coating a portion of the precursor solution I onto the surface of the side of the first carrier transport layer away from the first electrode at a first rotational speed; and
increasing a rotational speed from the first rotational speed to a second rotational speed, and continuing to spin-coat another portion of the precursor solution I at the second rotational speed.

The second rotational speed is greater than the first rotational speed.

Based on any suitable embodiment in the present application, in some further embodiments, in the process of preparing the first perovskite layer, the preparation method for a perovskite-based tandem solar cell satisfies one or more of the following features (the reference in any one of the following features may alternatively be selected from any suitable value or range in the context):
The first rotational speed is 1000 rpm to 6000 rpm, optionally 1000 rpm to 2000 rpm. Spin-coating is performed at the first rotational speed for 8 s to 12 s.

In the step of increasing the rotational speed from the first rotational speed to the second rotational speed, an acceleration is 200 rpm/s to 2000 rpm/s, optionally 800 rpm/s to 1200 rpm/s.

The second rotational speed is 3000 rpm to 4500 rpm, optionally 3800 rpm to 4200 rpm. Spin-coating is performed at the second rotational speed for 18 s to 22 s.

By adjusting one or more parameters in the preparation process of the first perovskite layer, the surface morphology and/or grain size of the first perovskite layer may be adjusted as needed. This optimization of process parameters enables better improvement of the comprehensive performance of the tandem solar cell, including short-circuit current density and photoelectric conversion efficiency.

In some embodiments, the second perovskite layer is also prepared by vacuum flash evaporation treatment, including the following steps: coating a precursor solution II of the second perovskite layer onto the surface of the side of the third carrier transport layer away from the carrier recombination layer to form a coating layer II, and performing vacuum flash evaporation treatment and annealing treatment on the coating layer II to form the second perovskite layer. The parameters for the vacuum flash evaporation treatment and annealing treatment of the coating layer II may refer to the description part of the coating layer I.

The second perovskite layer is prepared by the vacuum flash evaporation process. Grooves and ridges similar to those mentioned above may be formed on the surface of the side of the second perovskite layer away from the carrier recombination layer, which increases the chance of secondary light incidence on the second perovskite layer, improves light utilization efficiency, improves the photoelectric conversion efficiency of the tandem solar cell, and also improves the short-circuit current density. Furthermore, the formation of large-sized through-type grains may be promoted, and the carrier transport and the photoelectric conversion efficiency may be promoted.

Structural layers other than perovskite layers in the tandem solar cell may be prepared by one or more methods including, but not limited to: chemical bath deposition, electrochemical deposition, chemical vapor deposition, thermal evaporation co-evaporation, atomic layer deposition, magnetron sputtering, precursor solution spin-coating, precursor solution slot-die coating, precursor solution blade-coating, mechanical lamination, and the like. A suitable method may be selected based on the material properties of each structural layer to stack with adjacent structural layers. In some embodiments, structural layers other than perovskite layers in the tandem solar cell may be prepared by one or more methods including, but not limited to: thermal evaporation, precursor solution coating, and the like. The precursor solution coating may be precursor solution spin-coating.

Without limitation, the second perovskite layer may be prepared using vacuum flash evaporation parameters similar to those for the first perovskite layer.

Based on any suitable embodiment in the present application, in some further embodiments, the vacuum flash evaporation treatment and annealing of the precursor solution II include: performing vacuum flash evaporation treatment on the precursor solution II under a negative pressure, followed by annealing under heating conditions.

Without limitation, in the process of preparing the second perovskite layer, the preparation method for a perovskite-based tandem solar cell may further satisfy one or more of the following features (the reference in any one of the following features may alternatively be selected from any suitable value or range in the context):
The negative pressure is less than or equal to 100 Pa (≤100 Pa), optionally 50 Pa to 100 Pa.

A temperature for the vacuum flash evaporation treatment is -10°C to 100°C, optionally 0°C to 30°C, and further optionally 20°C to 30°C.

Time of the vacuum flash evaporation treatment is 10 s to 100 s, optionally 10 s to 30 s, and further optionally 15 s to 25 s.

Under the heating conditions, a hot stage at 30°C to 200°C is used. Optionally, a hot stage at 90°C to 110°C is used. Further optionally, a hot stage at 98°C to 102°C is used.

An annealing time of the annealing treatment is 30 s to 60 min, optionally 5 min to 20 min, and further optionally 8 min to 12 min.

Based on any suitable embodiment in the present application, in some further embodiments, the step of coating a precursor solution II of the second perovskite layer onto the surface of the side of the third carrier transport layer away from the carrier recombination layer includes:
spin-coating a portion of the precursor solution II onto the surface of the side of the third carrier transport layer away from the carrier recombination layer at a third rotational speed; and
increasing a rotational speed from the third rotational speed to a fourth rotational speed, and continuing to spin-coat another portion of the precursor solution II at the fourth rotational speed.

The fourth rotational speed is greater than the third rotational speed.

Based on any suitable embodiment in the present application, in some further embodiments, in the process of preparing the first perovskite layer, the preparation method for a perovskite-based tandem solar cell satisfies one or more of the following features (the reference in any one of the following features may alternatively be selected from any suitable value or range in the context):
The third rotational speed is 1000 rpm to 6000 rpm, optionally 1000 rpm to 2000 rpm. Spin-coating is performed at the third rotational speed for 8 s to 12 s.

In the step of increasing the rotational speed from the third rotational speed to the fourth rotational speed, an acceleration is 200 rpm/s to 2000 rpm/s, optionally 800 rpm/s to 1200 rpm/s.

The fourth rotational speed is 3000 rpm to 4500 rpm, optionally 3800 rpm to 4200 rpm. Spin-coating is performed at four rotational speeds for 18 s to 22 s.

In some modes, taking the substrate layer located on the side of the first perovskite sub-cell away from the carrier recombination layer as an example, and taking a first substrate (including the substrate layer and the first electrode) to prepare each structural layer sequentially: one or more structural layers from the first perovskite layer to the second electrode in the tandem solar cell are prepared by vacuum flash evaporation. At this time, after the non-smooth surface is formed on the side of the first perovskite layer away from the first electrode, fewer thermal evaporation processes are required, which helps reduce the adverse impact of conventional thermal annealing processes on the photoelectric conversion efficiency of the first perovskite layer.

In some modes, structural layers other than the structural layers prepared by vacuum flash evaporation in the tandem solar cell may be prepared by evaporation. For example, both the first electrode and the first carrier transport layer may be prepared by evaporation.

According to a third aspect of the present application, a power consuming apparatus is provided, including at least one of the perovskite-based tandem solar cell described according to the first aspect of the present application and the perovskite-based tandem solar cell prepared using the preparation method for a perovskite-based tandem solar cell described according to the second aspect of the present application.

In some of the embodiments, the foregoing tandem solar cell may be used as a power generation device for the power consuming apparatus. Types of the power generation device may include, but are not limited to, integrated power generation. Positions of the power generation device may include, but are not limited to, a roof, back panel, and the like of an automobile.

Further, the foregoing power consuming apparatus may include mobile devices (e.g., mobile phones and laptops), electric vehicles, electric trains, ships, satellites, power generation systems, and the like, but are not limited thereto.

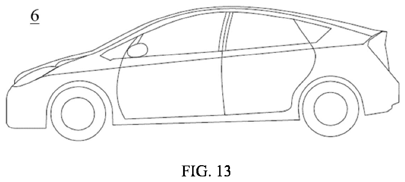

FIG. 13 shows a power consuming apparatus as an instance. The power consuming apparatus 6 is an automobile, which may further be an all-electric vehicle, a hybrid electric vehicle, a plug-in hybrid electric vehicle, or the like.

The power consuming apparatus as another instance may be a mobile phone, a tablet, a laptop, a computer, or the like.

The power consuming apparatus as another instance may be a wearable device, such as a watch.

Some examples of the present application will be described hereinafter. The examples described below are exemplary, and are only intended to explain the present application rather than being construed as a limitation to the present application. Where techniques or conditions are not indicated in the examples, the techniques or conditions described above or in the literatures in the art or described in the product specifications are followed. The reagents or instruments for which no manufacturers are noted are all commercially available common products, or can be conventionally synthesized with commercially available products.

In the following examples, the room temperature refers to a range of 20°C to 30°C.

In a preparation method of a perovskite-based tandem solar cell, a first perovskite layer and a second perovskite layer are prepared by vacuum flash evaporation. Both perovskite sub-cells are of an inverted p-i-n type. The first perovskite layer serves as a wide-band gap perovskite layer, with a band gap ranging from 1.2 eV to 2.4 eV and additionally satisfying a range of 1.6 eV to 2.3 eV. The second perovskite layer serves as a narrow-band gap perovskite layer, with a band gap ranging from 1.0 eV to 1.4 eV.

S10: Clean glass with a deposited transparent conductive film ITO: clean the glass using acetone, alcohol, and deionized water sequentially to obtain a first electrode plate, and dry the first electrode plate for subsequent use. A substrate layer is a glass substrate, and an ITO layer serves as a first electrode. The first electrode has a length of 20 mm, a width of 15 mm, and a height of 200 nm.

S20: Spin-coat an ethanol solution of MeO-4PACz onto a surface of a first electrode of the first substrate at a rotational speed of 4000 rpm for 30 seconds, and then transfer to a hot stage for annealing at 100°C for 10 min to form a hole transport layer (first carrier transport layer) with a thickness of 1 nm on the surface of the first electrode.

MeO-4PACz refers to [4-(3,6-dimethoxy-9H-carbazol-9-yl)butyl]phosphonic acid. A preparation method of the ethanol solution of MeO-4PACz includes: adding 0.3 mg of MeO-4PACz to 1 mL of ethanol, and stirring uniformly.

S30: Drop 85 µL of a first perovskite precursor solution onto a surface of the hole transport layer formed in step S20, spin at a speed of 1000 rpm to 2000 rpm for 10 s, increase the speed to 4000 rpm at an acceleration of 1000 rpm/s, continue spinning using a spinning process at 4000 rpm for 20 s, transfer to a vacuum flash evaporation chamber, use a vacuum pump to reduce the pressure inside the chamber to below 100 Pa (room temperature, approximately 60 Pa), maintain for 20 s, and anneal a multi-layer film on a hot stage at 100°C for 15 min after completing the vacuum flash evaporation treatment, to form a first perovskite layer (also referred to as a wide-band gap perovskite layer) with a thickness of approximately 400 nm.

A precursor solution for the first perovskite layer is also denoted as a wide-band gap perovskite precursor solution or the first perovskite precursor solution. A preparation method includes: adding a perovskite precursor material to 1 mL of a mixed solvent of N,N-dimethylformamide (DMF) and dimethyl sulfoxide (DMSO) with a volume ratio of 3:1, stirring at 600 rpm on a magnetic stirrer for 2 h, and filtering for later use.

In Example 1, the precursor solution for the first perovskite layer is prepared by: adding a perovskite precursor material, including 123 mg of formamidinium iodide (FAI), 59 mg of formamidinium bromide (FABr), 46 mg of cesium iodide (CsI), 25 mg of cesium bromide (CsBr), 428 mg of lead iodide (PbI₂), and 209 mg of lead bromide (PbBr₂), to 1 mL of a mixed solvent of N,N-dimethylformamide (DMF) and dimethyl sulfoxide (DMSO) with a volume ratio of 3:1, stirring at 600 rpm on the magnetic stirrer for 2 h, and filtering for later use. The chemical formula of the corresponding perovskite material is CsₐFA₁₋ₐPbI_{3-y}Br_{y}, where a is 0.4 and y is 2.

S40: Evaporate a 20 nm-thick layer of C60 onto the wide-band gap perovskite layer prepared in step S30 to form a C60 film layer, as an electron transport layer (second carrier transport layer).

S50: Prepare a 20 nm-thick SnOₓ (1.5≤x≤2) layer on the C60 film layer prepared in step S40 by using an atomic layer deposition (ALD) device via an atomic layer deposition process, as a first hole-blocking layer. In this example, the second carrier transport layer is composed of a 20 nm-thick C60 film layer (prepared in step S40) and the 20 nm-thick SnOₓ (1.5≤x≤2) film layer (prepared in step S50).

S60: Evaporate a layer of Au with a thickness of approximately 1 nm onto the SnOₓ film layer prepared in step S50, as a carrier recombination layer.

S70: Spin-coat a solution of poly(3,4-ethylenedioxythiophene):polystyrenesulfonate (PEDOT:PSS) (with water as the solvent) onto the carrier recombination layer prepared in step S60 at a rotational speed of 4000 rpm for 30 s, and then transfer to a hot stage for annealing at 150°C for 10 min to form a PEDOT:PSS film layer (third carrier transport layer, serving as a hole transport layer) with a thickness of approximately 20 nm.

S80: Drop 100 µL of a second perovskite precursor solution onto the PEDOT:PSS film layer prepared in step S70, spin at a speed of 1000 rpm to 2000 rpm for 10 s, increase the speed to 4000 rpm at an acceleration of 1000 rpm/s, continue spinning using a spinning process at 4000 rpm for 20 s, transfer to the vacuum flash evaporation chamber, use the vacuum pump to reduce the pressure inside the chamber to below 100 Pa (60 Pa), maintain for 20 s, and anneal a multi-layer film on a hot stage at 100°C for 10min after completing the vacuum flash evaporation treatment, to form a second perovskite layer (also referred to as a narrow-band gap perovskite layer or the second perovskite precursor solution) with a thickness of approximately 700 nm.

The second perovskite precursor solution is prepared by: adding a perovskite precursor material to 1 mL of a mixed solvent of DMF and DMSO with a volume ratio of 3:1, stirring at 600 rpm on the magnetic stirrer for 2 h, and filtering for later use.

In Example 1, the second perovskite precursor solution is prepared by: adding 216 mg of FAI, 85 mg of MAI, 414 mg of PbI₂, 335 mg of SnI₂, and 0.1 mg to 1 mg (0.6 mg in Example 1) of MeO-4PACz to 1 mL of a mixed solvent of DMF and DMSO with a volume ratio of 3:1, stirring at 600 rpm on the magnetic stirrer for 2 h, and filtering for later use. In Example 1, a perovskite-type metal halide in the second perovskite precursor solution and the second perovskite layer is FA_{0.7}MA_{0.3}Pb_{0.5}Sn_{0.5}I₃.

S90: Sequentially evaporate C60 with a thickness of 25 nm, bathocuproine (BCP) with a thickness of 10 nm, and Cu with a thickness of 80 nm using an evaporation device on the narrow-band gap perovskite layer prepared in step S80, to serve as an electron transport layer (third carrier transport layer), an intercalation layer, and a second electrode respectively.

**Example 2** adopts a method substantially the same as Example 1 to prepare the tandem solar cell. The operating processes of steps S10, S30, S40, S50, S60, S80, and S90 are the same as those in Example 1, except that a vacuum flash evaporation process is adopted in step S20 (preparing the hole transport layer) and step S70 (preparing the PEDOT:PSS film layer).

S20: Spin-coat an ethanol solution of MeO-4PACz onto the first substrate prepared in step S10 at a spin-coating rotational speed of 4000 rpm for 30 s, transfer to the vacuum flash evaporation chamber, use the vacuum pump to reduce the pressure inside the chamber to below 100 Pa, and maintain for 20 s.

S70: Prepare a PEDOT:PSS film layer on the carrier recombination layer prepared in step S60 by a spin-coating process at a spin-coating rotational speed of 4000 rpm for 30 s, transfer to the vacuum flash evaporation chamber, use the vacuum pump to reduce the pressure inside the chamber to below 100 Pa, and maintain for 20 s.

**Examples 3 to 9** adopt a method substantially the same as Example 1, and preparation parameters may be referred to in Table 1. The only difference is the composition of the perovskite-type metal halide.

### Comparative Example 1: The first perovskite layer and the second perovskite layer are prepared by an anti-solvent method

Comparative Example 1 adopts a method substantially the same as Example 1, except that the methods for preparing the first perovskite layer in S30 and the second perovskite layer in S80 are different and both belong to the anti-solvent method.

S30: Prepare the first perovskite layer by the anti-solvent method: add 123 mg of CH(NH₂)₂I, 59 mg of CH(NH₂)₂Br, 46 mg of CsI, 25 mg of CsBr, 428 mg of PbI₂, and 209 mg of PbBr₂ into 1 mL of a mixed solvent of DMF and DMSO (a volume ratio of DMF to DMSO is 3:1), stir at a rotational speed of 600 rpm on the magnetic stirrer for 2 h, filter to obtain the first perovskite precursor solution, spin-coat 100 µL of the foregoing first perovskite precursor solution onto the hole transport layer prepared in step S20 (spin-coat at 2000 rpm for 10 s, and then spin-coat at 4000 rpm for 30 s), drop 250 µL of chlorobenzene onto the spin-coated first perovskite precursor solution, spin-coat the foregoing first perovskite precursor solution again, and then transfer to a hot stage for annealing at 100°C for 10 min to form the first perovskite layer.

S80: Prepare the second perovskite layer by the anti-solvent method: add 216 mg of CH(NH₂)₂I, 85 mg of CH₃NH₂I, 414 mg of PbI₂, 335 mg of SnI₂, and 0.3 mg of MeO-4PACz into 1 mL of a mixed solvent of DMF and DMSO (a volume ratio of DMF to DMSO is 3:1), stir at a rotational speed of 600 rpm on the magnetic stirrer for 2 h, filter to obtain the second perovskite precursor solution, spin-coat 100 µL of the foregoing second perovskite precursor solution onto the PEDOT:PSS film layer prepared in step S70 (spin-coat at 1000 rpm for 10 s, and then spin-coat at 4000 rpm for 30 s), drop 300 µL of ethyl acetate onto the spin-coated second perovskite precursor solution, spin-coat the foregoing second perovskite precursor solution again, and then transfer to a hot stage for annealing at 100°C for 10 min to form the second perovskite layer.

### Comparative Example 2: The first perovskite layer and the second perovskite layer are prepared by an anti-solvent method

Comparative Example 2 adopts a method substantially the same as Example 2, except that the methods for preparing the first perovskite layer in S30 and the second perovskite layer in S80 are different and both belong to the anti-solvent method.

S20: Prepare the first perovskite layer by the anti-solvent method: add 123 mg of CH(NH₂)₂I, 59 mg of CH(NH₂)₂Br, 46 mg of CsI, 25 mg of CsBr, 428 mg of PbI₂, and 209 mg of PbBr₂ into 1 mL of a mixed solvent of DMF and DMSO (a volume ratio of DMF to DMSO is 3:1), stir at a rotational speed of 600 rpm on the magnetic stirrer for 2 h, filter to obtain the first perovskite precursor solution, spin-coat 100 µL of the foregoing first calcium perovskite precursor solution onto the hole transport layer prepared in step S20 (spin-coat at 2000 rpm for 10 s, and then spin-coat at 4000 rpm for 30 s), drop 250 µL of chlorobenzene onto the spin-coated first calcium perovskite precursor solution, spin-coat the foregoing first calcium perovskite precursor solution again, and then transfer to a hot stage for annealing at 100°C for 10 min to form the first perovskite layer.

S80: Prepare the second perovskite layer by the anti-solvent method: add 216 mg of CH(NH₂)₂I, 85 mg of CH₃NH₂I, 414 mg of PbI₂, 335 mg of SnI₂, and 0.3 mg of MeO-4PACz into 1 mL of a mixed solvent of DMF and DMSO (a volume ratio of DMF to DMSO is 3:1), stir at a rotational speed of 600 rpm on the magnetic stirrer for 2 h, filter to obtain the second perovskite precursor solution, spin-coat 100 µL of the foregoing second perovskite precursor solution onto the PEDOT:PSS film layer prepared in step S70 (spin-coat at 1000 rpm for 10 s, and then spin-coat at 4000 rpm for 30 s), drop 300 µL of ethyl acetate onto the spin-coated second perovskite precursor solution, spin-coat the foregoing second perovskite precursor solution again, and then transfer to a hot stage for annealing at 100°C for 10 min to form the second perovskite layer.

### Comparative Example 3: The first perovskite layer and the second perovskite layer are prepared by an anti-solvent method

Comparative Example 3 adopts a method substantially the same as Comparative Example 2. To be specific, the anti-solvent method is used to prepare the first perovskite layer and the second perovskite layer. The difference is that the first perovskite precursor solution used in preparing the first perovskite layer in step S30 is the same, and the corresponding perovskite-type metal halide is FAPbI_{3-y}Br_{y}, where y=1.2.

**Comparative Examples 4 to 5** adopt a method substantially the same as Comparative Example 1, except that the first perovskite precursor solution used in preparing the first perovskite layer is the same, and the corresponding perovskite-type metal halide is CsaFA₁₋ₐPbI_{3-y}Br_{y}(a=0.4), where y is 0 and 3, respectively. Reference may be made to Table 1.

**Comparative Examples 6 to 7** adopt a method substantially the same as Example 1, except that the methods for preparing the first perovskite layer and the second perovskite layer are different and both belong to the evaporation method. Reference may be made to Table 1.

Step S30 of preparing a wide band gap includes: adding 154 mg of CH(NH₂)₂I, 74 mg of CH(NH₂)₂Br, 428 mg of PbI₂, and 209 mg of PbBr₂ into 1 mL of a mixed solvent of DMF and DMSO (a volume ratio of DMF to DMSO is 3:1), stirring at a rotational speed of 600 rpm on the magnetic stirrer for 2 h, filtering to obtain the first perovskite precursor solution, spin-coating 100 µL of the foregoing first perovskite precursor solution onto the hole transport layer prepared in step S20 (spin-coating at 2000 rpm for 10 s, and then spin-coating at 4000 rpm for 30 s), dropping 250 µL of chlorobenzene onto the spin-coated perovskite precursor solution, spin-coating the foregoing perovskite precursor solution again, and then transferring to a hot stage for annealing at 100°C for 10 min to form the first perovskite layer.

Step S80 of preparing a narrow band gap includes: adding 216 mg of CH(NH₂)₂I, 85 mg of CH₃NH₂I, 414 mg of PbI₂, 335 mg of SnI₂, and 0.3 mg of MeO-4PACz into 1 mL of a mixed solvent of DMF and DMSO (a volume ratio of DMF to DMSO is 3:1), stirring at a rotational speed of 600 rpm on the magnetic stirrer for 2 h, filtering to obtain the second perovskite precursor solution, spin-coating 100 µL of the foregoing second perovskite precursor solution onto the PEDOT:PSS film layer prepared in step S70 (spin-coating at 1000 rpm for 10 s, and then spin-coating at 4000 rpm for 30 s), dropping 300 µL of ethyl acetate onto the spin-coated perovskite precursor solution, spin-coating the foregoing perovskite precursor solution again, and then transferring to a hot stage for annealing at 100°C for 10 min to form the second perovskite layer.

Reference may be made to Table 1.

**Table 1.**

| No. | Perovskite-Type Metal Halide in First Perovskite Layer | | Preparation Process of First perovskite Layer |
|---|---|---|---|
| | ABX₃ | y | |
| Example 1 | CsₐFA₁₋ₐPbI_{3-y}Br_{y} (a=0.4) | 2 | Vacuum flash evaporation treatment at 25°C, 60 Pa for 20 s; A PEDOT:PSS film layer is prepared by an evaporation method |
| Example 2 | CsₐFA₁₋ₐPbI_{3-y}Br_{y} (a=0.4) | 2 | Vacuum flash evaporation treatment at 25°C, 60 Pa for 20 s; A PEDOT:PSS film layer is prepared by a vacuum flash evaporation method |
| Example 3 | CsₐFA₁₋ₐPbI_{3-y}Br_{y} (a=0.4) | 1.8 | Vacuum flash evaporation treatment at 25°C, 60 Pa for 20 s |
| Example 4 | CsₐFA₁₋ₐPbI_{3-y}Br_{y} (a=0.4) | 1.2 | Vacuum flash evaporation treatment at 25°C, 60 Pa for 20 s |
| Example 5 | CsₐFA₁₋ₐPbI_{3-y}Br_{y} (a=0.4) | 1 | Vacuum flash evaporation treatment at 25°C, 60 Pa for 20 s |
| Example 6 | CsₐFA₁₋ₐPbI_{3-y}Br_{y} (a=0.4) | 0.6 | Vacuum flash evaporation treatment at 25°C, 60 Pa for 20 s |
| Example 7 | CsPbI_{3-y}Br_{y} | 1.2 | Vacuum flash evaporation treatment at 25°C, 60 Pa for 20 s |
| Example 8 | FAPbI_{3-y}Br_{y} | 1.2 | Vacuum flash evaporation treatment at 25°C, 60 Pa for 20 s |
| Example 9 | CsₐFA₁₋ₐSnI_{3-y}Br_{y} (a=0.4) | 1.2 | Vacuum flash evaporation treatment at 25°C, 60 Pa for 20 s |
| Comparative Example 1 | Similar to Example 1 | 2 | Prepared using an anti-solvent method |
| Comparative Example 2 | Similar to Example 2 | 1.2 | Prepared using an anti-solvent method |
| Comparative Example 3 | Similar to Example 7 | 1.2 | Prepared using an anti-solvent method |
| Comparative Example 4 | CsₐFA₁₋ₐPbI (a=0.4), based on Example 1 | y=0 | Vacuum flash evaporation treatment at 25°C, 60 Pa for 20 s |
| Comparative Example 5 | CsₐFA₁₋ₐPbBr (a=0.4), based on Example 1 | y=3 | Vacuum flash evaporation treatment at 25°C, 60 Pa for 20 s |
| Comparative Example 6 | Based on Example 1 | 2 | Evaporation process |
| Comparative Example 7 | Based on Example 2 | 2 | Evaporation process |

### Test method

### 1. Morphology and Structure Testing

A to-be-tested sample is fixed on a sample holder using a conductive tape before testing. An SEM is an experimental observation tool that falls between a transmission electron microscope and an optical microscope. It is an electron-optical instrument that scans a surface of an observed sample with an electron beam, then collects a series of electronic information generated by the interaction between the electron beam and the sample, and forms images through conversion, magnification, and digital processing. It has a large depth of field, a wide field of view, and good three-dimensional imaging effects, enabling effective analysis of the surface morphology of the sample. A magnification factor may be adjusted by changing the scanning amplitude of the electron beam on the surface of the sample, allowing magnification observation of the test sample from approximately 20x to 200,000x (e.g., magnification factors such as 7K, 10K, 20K, and 30K, where 1K=1000x). The SEM may be used to observe the crystallization status (e.g., grain size, grain thickness, "presence of through-type grains with a lateral dimension ≥ 400 nm", etc.) and morphological features of perovskite samples.

SEM test objects include: assembly samples with the first perovskite layer deposited on the hole transport layer but without the second carrier transport layer deposited based on the first electrode (transparent electrode), which may be tested and analyzed from both longitudinal and lateral directions; and assembly samples with the second perovskite layer already deposited.
(1) The observation surface is either the exposed surface of the first perovskite layer or the surface of the transparent first electrode.
(2) A 1×0.5 cm² assembly sample is cut with a glass knife, stuck on an SEM sample stage with a longitudinal cross-section facing up, and crystallization quality and grain thickness are observed by using the SEM.

According to an SEM picture of the longitudinal cross-section, combined with analysis software such as Image-J, relevant information may be obtained, including dimensions of grooves and ridges, and an area ratio of through-type grains with a lateral dimension greater than or equal to 400 nm in the longitudinal cross-section. The dimensions of the grooves include size parameters such as a width, an average width, a length, a length-to-width ratio, a half-height width, an average half-height width, a depth, an average depth, a depth-to-width ratio, an average depth-to-width ratio, and an average spacing of the grooves. The dimensions of the ridges include size parameters such as a width, an average width, a length, a length-to-width ratio, a half-height width, an average half-height width, a height, an average height, a height-to-width ratio, an average height-to-width ratio, and an average spacing of the ridges. For the average values in the foregoing parameters, data from at least three regions must be acquired.

The depth of the grooves is substantially consistent with the height of the ridges in average.

### 2. Surface Roughness and Structural Size Analysis of First Perovskite Layer

A step profiler (probe step profiler) is used to test the surface roughness and groove structure of the first perovskite layer.

To-be-tested Sample: An assembly with the first perovskite layer deposited on the first carrier transport layer but without the second carrier transport layer deposited (step S30 completed, step S40 not yet performed) serves as the to-be-tested sample. A lateral surface of one side of the perovskite layer serves as a test surface. The test results are shown in Table 2.

Test Conditions: A probe directly contacts the surface to record contour changes, to obtain two-dimensional contour changes and calculate line roughness.

The test is conducted using a contact-motion method: When a stylus slides gently along the tested surface, tiny peaks and valleys on the surface cause the stylus to move up and down along the peaks and valleys while sliding. A motion trajectory of the stylus reflects the surface contour status.

Test Results and Analysis Method: A surface morphology curve (also referred to as a surface roughness curve) may be obtained. The "valleys" in the curve correspond to grooves. A region between two adjacent peaks with a fluctuation depth greater than or equal to 100 nm is regarded as one "valley". The "peaks" in the curve correspond to ridges. A region between two adjacent valleys with a fluctuation height greater than or equal to 100 nm is regarded as one "peak". By counting a "valley depth" or "peak height" in the surface roughness curve, the surface roughness of the to-be-tested surface may be obtained. Further, size parameters such as a width, an average width, a length, a length-to-width ratio, a half-height width, an average half-height width, a depth, an average depth, a depth-to-width ratio, an average depth-to-width ratio, and an average spacing of the grooves may be analyzed and obtained. Similarly, size parameters such as a width, an average width, a length, a length-to-width ratio, a half-height width, an average half-height width, a height, an average height, a height-to-width ratio, an average height-to-width ratio, and an average spacing of the ridges may be analyzed and obtained. Furthermore, these size parameters of the grooves and the ridges may alternatively be observed and analyzed from SEM pictures of the longitudinal cross-section at a certain magnification factor (e.g., 20K, 30K, or 40K).

### 3. Optical Microscope Observation

A to-be-tested sample is a film assembly with the first perovskite layer deposited on the first carrier transport layer but without the electron transport layer deposited (Step S30 completed, Step S40 not yet performed). An exposed surface of the first perovskite layer is used as a test surface. A lateral dimension of the assembly is denoted as A2.

Instrument: Optical microscope (Keyence VHX-S650E). The test surface is directly placed under a light beam, and a focal length is adjusted for observation.

A to-be-tested sample is a film assembly with the first perovskite layer deposited on the first carrier transport layer but without the electron transport layer deposited (Step S30 completed, Step S40 not yet performed). An exposed surface of the first perovskite layer is used as a test surface.

### Test and Analysis Method:

Statistical analysis is performed within an area range of at least 960,000 µm².
(1) Morphological pictures of the non-smooth surface of the first perovskite may be obtained. An area enclosed by the contours of the grooves in the pictures is denoted as A1. Then, a "percentage of a sum of projected areas of the grooves along the longitudinal direction relative to a projected area of the non-smooth surface along the longitudinal direction (denoted as R1)" is equal to A1/A2×100%.
(2) The spacing of a plurality of adjacent grooves may be measured by analyzing center connecting lines of the groove widths, and may be averaged to obtain the average spacing of the grooves.

The average spacing of the ridges is substantially consistent with the average spacing of the grooves in value.

### 4. Performance Testing of Tandem Solar Cell

A to-be-tested tandem solar cell is connected to a dedicated capacitor (used as a variable load). During the charging process of the capacitor by the tandem solar cell, current and voltage are sampled, corresponding current-voltage data is recorded, and a volt-ampere characteristic curve (I-V curve) chart is drawn. Various electrical performance parameters are calculated to obtain test values of open-circuit voltage (Voc), short-circuit current density (Jsc), fill factor (FF), and photoelectric conversion efficiency (PCE).

Test Method: A solar simulator is used for testing in accordance with the national standard IEC 61215. The light intensity is calibrated with a crystalline silicon solar cell to reach one sun intensity (AM 1.5). The cell is connected to a source meter, and the photoelectric conversion efficiency PCE is tested under illumination.

Under the atmospheric environment, an AM1.5G standard light source is used as a solar simulation light source. A four-channel source meter (Keithley 2440) is used to measure a volt-ampere characteristic curve of the cell under light irradiation, to obtain the open-circuit voltage Voc, short-circuit current density Jsc, and fill factor (FF) of the cell, thereby calculating the photoelectric conversion efficiency PCE of the tandem solar cell.

The photoelectric conversion efficiency is calculated as follows: PCE=Pout/Popt
=Voc×Jsc×(Vmpp×Jmpp)/(Voc×Jse)
=Voc×Jsc×FF

Pout represents an output power of the cell during operation. Popt represents an incident light power. Vmpp represents voltage at a maximum power point of the cell. Jmpp represents current at the maximum power point of the cell.

### Test and Analysis Results

According to the test results, the first perovskite layer prepared in Examples 1 to 9 forms a non-smooth surface on the side away from the first electrode. The non-smooth surface includes alternately arranged grooves and ridges. The ridges are formed between adjacent grooves. The grooves are formed between adjacent ridges. The further prepared tandem solar cell has a "concave-convex" interface formed by the alternate arrangement of the grooves and the ridges at the first interface.

In Comparative Examples 1 to 7, the first perovskite layer in Comparative Examples 1 to 3 is prepared by the conventional anti-solvent method. Both perovskite layers in Comparative Examples 6 to 7 are prepared by an evaporation process. Comparative Examples 4 to 5 include only one type of halogen (either I or Br). Almost no non-smooth surface is formed at the first interface in Comparative Examples 1 to 7, which may be regarded as a relatively flat surface with substantially no grooves or ridges.

FIG. 1 is an optical microscope image of a non-smooth surface of a first perovskite layer prepared by a vacuum flash evaporation method in Example 1. FIG. 2 is an optical microscope image of a non-smooth surface of a first perovskite layer prepared by a vacuum flash evaporation method in Example 2. FIG. 3 is an optical microscope image observed from a glass substrate side in Example 1, where a transparent electrode, a hole transport layer, and a first perovskite layer are arranged sequentially.

In FIG. 1, obvious grooves may be observed, and ridges are formed between adjacent grooves. The overall distribution of the grooves and the ridges on the surface of the first perovskite layer is relatively uniform, and the lateral dimension combination of the grooves and the ridges is well-matched, presenting an overall wrinkled morphology.

Referring to FIG. 1, the non-smooth surface of the first perovskite layer has grooves with an extending length greater than or equal to 50 µm, and also has ridges with an extending length greater than or equal to 50 µm.

It can be seen from FIG. 1 that the length-to-width ratio of most ridges is greater than 1, and the length-to-width ratio of the ridges may satisfy a variety of ranges, including but not limited to ≥2, ≥3, ≥5, greater than 1 and less than or equal to 20, 2-10, 5-10, etc.

It can be seen from FIG. 1 that the length-to-width ratio of most grooves is greater than 1, and the length-to-width ratio of the grooves may satisfy a variety of ranges in the region shown in the figure, including but not limited to ≥5, ≥10, ≥15, greater than 1 and less than or equal to 20, 2-20, 5-20, 10-20, etc.

It can be seen from FIG. 1 that some of the grooves have a corner in an extending direction thereof. Some of the grooves have non-straight lines in an extending direction thereof. There are intersection nodes between some adjacent grooves (i.e., some adjacent grooves are communicated through the intersection nodes).

It can be seen from FIG. 1 that some of the ridges have a corner in an extending direction thereof. Some of the ridges have non-straight lines in an extending direction thereof. There are intersection nodes between some adjacent ridges (i.e., some adjacent ridges are communicated through the intersection nodes).

FIG. 8 is an optical microscope image of an all-perovskite tandem solar cell from a glass substrate side in Comparative Example 1, where a transparent electrode is arranged on a surface of the glass substrate close to a carrier recombination layer. FIG. 9 is an SEM image of a longitudinal cross-section of a tandem solar cell prepared by an anti-solvent method in Comparative Example 1.

Based on direct observation results of a non-smooth surface of a first perovskite layer via an optical microscope, lateral and longitudinal cross-sections via SEM (see FIGS. 1, 4-6), and surface roughness test and analysis results of the non-smooth surface, morphological and size parameters of grooves and ridges may be obtained, including but not limited to: a width, an average width, a length, a length-to-width ratio, a half-height width, an average half-height width, a depth, an average depth, a depth-to-width ratio, an average depth-to-width ratio, and an average spacing of the grooves, a width, an average width, a length, a length-to-width ratio, a half-height width, an average half-height width, a height, an average height, a height-to-width ratio, an average height-to-width ratio, and an average spacing of the ridges, a percentage of a sum of projected areas of grooves along a longitudinal direction relative to a projected area of the non-smooth surface along the longitudinal direction, a ratio of the half-height width of the ridges to the half-height width of adjacent grooves, a ratio of the average half-height width of the ridges to the average half-height width of the grooves, a ratio of a sum of half-height cross-sectional areas of the ridges to a sum of half-height cross-sectional areas of the grooves, and a percentage of a sum of projected areas of the grooves along the longitudinal direction relative to a projected area of the non-smooth surface along the longitudinal direction, etc. An average depth of grooves, an average height of ridges, and surface roughness within a test region are substantially equal in value. Within the test region, an average spacing of ridges is substantially consistent with an average spacing of grooves in value.

In Examples 1 to 9, the average width of the grooves on the non-smooth surface of the first perovskite layer satisfies both ranges of 0.3 µm to 1 µm and 0.5 µm to 1 µm. The average half-height width of the grooves satisfies both ranges of 0.2 µm to 0.7 µm and 0.3 µm to 0.55 µm. The average depth of the grooves satisfies both ranges of 100 nm to 500 nm and 100 nm to 250 nm. The average depth-to-width ratio of the grooves satisfies all three ranges of 0.03 to 0.5, 0.2 to 0.5, and 0.25 to 0.3. As an instance, Example 1 has an average width of approximately 0.8 µm, an average half-height width of approximately 0.4 µm, an average depth of approximately 200 nm, and an average depth-to-width ratio of approximately 0.28. The average width, average half-height width, average depth, and average depth-to-width ratio of the grooves in Examples 1 to 9 are relatively close to each other. In Examples 1 to 9, the ratio of the sum of half-height cross-sectional areas of the ridges to the sum of half-height cross-sectional areas of the grooves satisfies both ranges of 1 to 36 and 10 to 30. In Examples 1 to 9, morphologies of interfaces formed by different structural layers between the first perovskite layer and the second perovskite layer are substantially matched. Within most non-smooth regions, the ridges and the grooves satisfy that the half-height width of the ridges is greater than the half-height width of adjacent grooves. According to the test and analysis results, on the non-smooth surface of the first perovskite layer, most grooves have a longitudinal cross-sectional shape with a wider top and a narrower bottom. Some grooves have an opening width greater than a bottom width. Some grooves have the opening width greater than a half-height width thereof, which in turn is greater than a bottom width thereof. Based on a proportion of projected areas of the grooves along the longitudinal direction, within some non-smooth regions, the proportion of grooves with the opening width greater than the bottom width is greater than or equal to 50%, and within some non-smooth regions, the proportion of grooves with the opening width greater than the bottom width is greater than or equal to 80%. Based on a proportion of projected areas of the grooves along the longitudinal direction, within some non-smooth regions, the proportion of grooves with the opening width greater than a half-height width thereof, which in turn is greater than a bottom width thereof is greater than or equal to 50%, and within some non-smooth regions, the proportion of grooves with the opening width greater than a half-height width thereof, which in turn is greater than a bottom width thereof is greater than or equal to 80%. According to the test and analysis results, on the non-smooth surface of the first perovskite layer, most ridges have a longitudinal cross-sectional shape with a narrower top and a wider bottom. The ridges have a bottom width greater than a top width. Based on a proportion of projected areas of the ridges along the longitudinal direction, within some non-smooth regions, the proportion of ridges with the bottom width greater than the top width is greater than or equal to 50%, and within some non-smooth regions, the proportion of ridges with the bottom width greater than the top width is greater than or equal to 80%. The half-height width of at least some of the ridges is within the following two ranges: 1 µm to 2.5 µm, and 1.5 µm to 2 µm. The half-height width of at least some of the grooves is within the following two ranges: less than or equal to 1 µm, and 0.2 µm to 0.7 µm. Within some test regions, the ratio of the average half-height width of the ridges to the average half-height width of the grooves satisfies both ranges of 1 to 6 and 4 to 5. The ratio of the sum of the half-height cross-sectional areas of the ridges to the sum of the half-height cross-sectional areas of the grooves satisfies both ranges of 1 to 36 and 10 to 30.

In each example, there are some test regions that satisfy: a deviation of a maximum width of a ridge within an extending length from an average width of the ridge does not exceed 30%. Alternatively, there are some test regions that satisfy: a deviation of a maximum width of a ridge within an extending length from an average width of the ridge does not exceed 30%. Reference may be made to FIG. 1.

In Examples 1 to 9, within most test regions, the average spacing of the grooves satisfies a range of 1 µm to 20 µm. Within some test regions, the average spacing of the grooves satisfies a range of 10 µm to 20 µm. Within the test region, the average spacing of the ridges is substantially consistent with the average spacing of the grooves in value. Reference may be made to FIG. 1.

In Examples 1 to 9, there are two adjacent grooves that satisfy: an angle between the extending directions is less than 15° or less than 30° within an extending length region, including but not limited to at least one of the extending length regions of at least 30 µm, at least 50 µm, and at least 80 µm. There are two adjacent ridges that satisfy: an angle between the extending directions is less than 15° or less than 30° within an extending length region, including but not limited to at least one of the extending length regions of at least 30 µm, at least 50 µm, and at least 80 µm. In some of Examples 1 to 9, there are two adjacent grooves that satisfy: an angle between the extending directions is less than 30° within an extending length region of at least 80 µm. In some of Examples 1 to 9, there are two adjacent ridges that satisfy: an angle between the extending directions is less than 30° within an extending length region of at least 80 µm. Reference may be made to FIG. 1.

FIG. 4 is an SEM image of a longitudinal cross-section of a tandem solar cell prepared by a vacuum flash evaporation method in the example shown in FIG. 1. FIG. 5 is an SEM image of a longitudinal cross-section of a tandem solar cell prepared by a vacuum flash evaporation method in Example 2 shown in FIG. 2. FIG. 6 is an SEM image of a lateral cross-section of a wide-band gap perovskite layer prepared by a vacuum flash evaporation method in Example 2 shown in FIG. 5.

According to FIG. 4 and FIG. 5, in the tandem solar cells prepared by the vacuum flash evaporation method in Examples 1 and 2, the perovskite crystallization quality of the first perovskite layer and the second perovskite layer is high. Perovskite grains in the perovskite layers have a relatively large average size and few defects. There are few cracks in the longitudinal cross-section of the perovskite layers, and longitudinally integrated through-type grains are formed. A lateral dimension of at least some of the through-type grains is greater than or equal to 400 nm. The lateral dimension of at least some of the through-type grains is greater than or equal to 500 nm. In FIG. 5, an area percentage of through-type grains with a lateral dimension greater than or equal to 400 nm relative to the longitudinal cross-section is more than 80%. In FIG. 4, an area percentage of through-type grains with a lateral dimension greater than or equal to 400 nm relative to the longitudinal cross-section is more than 80%.

In Examples 1 to 9, an average lateral dimension of the through-type grains is 300 nm to 2 µm. In some of the examples, the average lateral dimension of the through-type grains is 400 nm to 1 µm. In some of the examples, the average lateral dimension of the through-type grains is 500 nm to 800 nm. In some of the examples, within a width region of at least 10 µm in the longitudinal cross-section of the first perovskite layer, an area percentage of the through-type grains with a lateral dimension greater than or equal to 400 nm relative to the longitudinal cross-section is greater than or equal to 90%.

According to FIG. 9, in the tandem solar cell prepared by the anti-solvent method in Comparative Example 1, perovskite grains in the first perovskite layer and the second perovskite layer have a relatively small average size, and the perovskite layers have more defects. Many broken crystals are observed in the longitudinal cross-section, and there are basically no through-type grains. In other words, most grains are difficult to integrate longitudinally, which easily hinders the carrier transport process.

**Table 2. Non-Smooth Surface of First Perovskite Layer (Surface of Side of First Perovskite Layer Away from First Electrode)**

| No. | Presence of Grooves with Length-to-Width Ratio > 1 | Average Spacing of Ridges (µm) | Average Width of Ridges (µm) | Average Half-Height Width of Ridges (µm) |
|---|---|---|---|---|
| Example 1 | Yes | 15 | 2.5 | 1.8 |
| Example 2 | Yes | 15 | 2.5 | 1.8 |
| Example 3 | Yes | 13 | 2.3 | 1.7 |
| Example 4 | Yes | 15 | 2.5 | 1.8 |
| Example 5 | Yes | 17 | 2.6 | 1.9 |
| Example 6 | Yes | 20 | 2.8 | 1.9 |
| Example 7 | Yes | 15 | 2.5 | 1.8 |
| Example 8 | Yes | 15 | 2.5 | 1.8 |
| Example 9 | Yes | 15 | 2.5 | 1.8 |
| Comparative Example 1 | Yes | / | / | / |
| Comparative Example 2 | No | / | / | / |
| Comparative Example 3 | No | / | / | / |
| Comparative Example 4 | No | / | / | / |
| Comparative Example 5 | No | / | / | / |
| Comparative Example 6 | No | / | / | / |
| Comparative Example 7 | No | / | / | / |

In Examples 1 to 9, an average depth of grooves, an average height of ridges, and surface roughness within a test region are substantially equal in value. Within the test region, an average spacing of ridges is substantially consistent with an average spacing of grooves in value.

**Table 3.**

| No. | R1 | Presence of Through-type grains with Lateral Size ≥ 400 nm | Area Ratio of Through-type grains with Lateral Size ≥ 400 nm in Longitudinal Cross-Section | Short-Circuit Current Density Jsc (mA/cm²) | Photoelectric Conversion Efficiency PCE (%) |
|---|---|---|---|---|---|
| Example 1 | Satisfy 5% to 50% | Yes | 90% | 16.2 | 25.6 |
| Example 2 | Satisfy 5% to 50% | Yes | 90% | 16.5 | 26.0 |
| Example 3 | Satisfy 5% to 50% | Yes | 89% | 15.1 | 24.3 |
| Example 4 | Satisfy 5% to 50% | Yes | 90% | 15.3 | 24.8 |
| Example 5 | Satisfy 5% to 50% | Yes | 85% | 15.7 | 25.3 |
| Example 6 | Satisfy 5% to 50% | Yes | 80% | 15.0 | 24.2 |
| Example 7 | Satisfy 5% to 50% | Yes | 85% | 15.9 | 24.6 |
| Example 8 | Satisfy 5% to 50% | Yes | 84% | 15.7 | 24.8 |
| Example 9 | Satisfy 5% to 50% | Yes | 86% | 15.9 | 25.1 |
| Comparative Example 1 | 0% | No | 70% | 14.9 | 24.1 |
| Comparative Example 2 | 0% | No | 70% | 14.8 | 23.9 |
| Comparative Example 3 | 0% | No | 65% | 14.5 | 23.5 |
| Comparative Example 4 | 0% | No | 57% | 14.1 | 23.7 |
| Comparative Example 5 | 0% | No | 58% | 14.2 | 23.4 |
| Comparative Example 6 | 0% | Yes | 60% | 14.5 | 23.6 |
| Comparative Example 7 | 0% | No | 60% | 14.2 | 23.5 |

In Table 3, R1 represents a percentage of a sum of projected areas of grooves along a longitudinal direction relative to a projected area of a non-smooth surface along the longitudinal direction.

The foregoing descriptions of various embodiments and examples tend to emphasize the differences between the various embodiments and examples. The identical or similar parts therebetween may be referred to each other. For the sake of brevity, details are omitted herein.

The technical features of the foregoing embodiments and examples may be combined in any manner. For the sake of brevity, not all possible combinations of the technical features in the foregoing embodiments and examples have been described. However, any combination of these technical features should be considered within the scope of this specification, provided that no contradiction arises.

It should be noted that the present application is not limited to the foregoing embodiments and examples. The foregoing embodiments and examples are only illustrative, and the embodiments within the scope of the technical solution of the present application that have substantively the same composition and the same role and effect as the technical idea are all included within the technical scope of the present application. The foregoing embodiments and examples only represent several embodiments of the present application, and their descriptions are relatively detailed, but should not be construed as limiting the patent scope. In addition, within the scope of not departing from the gist of the present application, various variations made to the embodiments or examples that are conceivable to those skilled in the art and other modes constructed by combining some constituent elements of the embodiments or examples are also included within the scope of the present application.

## Claims

1. A perovskite-based tandem solar cell, comprising a first perovskite sub-cell, a carrier recombination layer, and a second perovskite sub-cell that are sequentially stacked, wherein the first perovskite sub-cell comprises a first perovskite layer, the second perovskite sub-cell comprises a second perovskite layer, and a band gap of the first perovskite layer is different from a band gap of the second perovskite layer;
a thickness direction of the first perovskite layer is denoted as a longitudinal direction;
a surface of a side of the first perovskite layer close to the carrier recombination layer is a non-smooth surface, the non-smooth surface is provided with grooves, and ridges are formed between at least some adjacent grooves; and
the tandem solar cell satisfies at least one of the following features:
at least some of the grooves have different widths at at least some depth positions; and
at least some of the ridges have different widths at at least some height positions.

2. The tandem solar cell according to claim 1, wherein morphologies of interfaces formed by different structural layers between the first perovskite layer and the second perovskite layer are substantially matched.

3. The tandem solar cell according to claim 1 or 2, wherein the tandem solar cell satisfies one or more of the following features:
a width of at least some of the ridges is 0.5 µm to 4 µm, further optionally 2 µm to 3.5 µm;
a half-height width of at least some of the ridges is 1 µm to 2.5 µm, optionally 1.5 µm to 2 µm;
a height of at least some of the ridges is greater than or equal to 100 nm, further optionally 100 nm to 250 nm;
within at least some regions in the non-smooth surface, an average width of the ridges is 0.5 µm to 4 µm, further optionally 2 µm to 3.5 µm;
within at least some regions in the non-smooth surface, an average half-height width of the ridges is 1 µm to 2.5 µm, optionally 1.5 µm to 2 µm;
within at least some regions in the non-smooth surface, an average height of the ridges is 100 nm to 500 nm, optionally 100 nm to 250 nm; and
optionally, a projected area of at least some regions of the non-smooth surface along the longitudinal direction is greater than or equal to 0.1 mm², further optionally greater than or equal to 0.6 mm².

4. The tandem solar cell according to any one of claims 1 to 3, wherein the tandem solar cell satisfies one or more of the following features:
a width of at least some of the grooves is less than or equal to 1.2 µm, optionally 0.5 µm to 1 µm;
a half-height width of at least some of the grooves is less than or equal to 1 µm, optionally 0.2 µm to 0.7 µm;
a depth of at least some of the grooves is greater than or equal to 100 nm, further optionally 100 nm to 250 nm;
a depth-to-width ratio of at least some of the grooves is 0.03 to 0.5, further optionally 0.25 to 0.35;
within at least some regions in the non-smooth surface, an average width of the grooves is 0.3 µm to 1 µm, optionally 0.5 µm to 1 µm;
within at least some regions in the non-smooth surface, an average half-height width of the grooves is 0.2 µm to 0.7 µm, optionally 0.3 µm to 0.55 µm;
within at least some regions in the non-smooth surface, an average depth of the grooves is 100 nm to 500 nm, optionally 100 nm to 250 nm;
within at least some regions in the non-smooth surface, an average depth-to-width ratio of the grooves is 0.03 to 0.5, further optionally 0.25 to 0.35; and
optionally, a projected area of at least some regions of the non-smooth surface along the longitudinal direction is greater than or equal to 0.1 mm², further optionally greater than or equal to 0.6 mm².

5. The tandem solar cell according to any one of claims 1 to 4, wherein the tandem solar cell satisfies one or more of the following features:
within at least some regions in the non-smooth surface, an average spacing of the ridges is 1 µm to 20 µm, optionally 10 µm to 20 µm;
within at least some regions in the non-smooth surface, an average spacing of the grooves is 1 µm to 20 µm, optionally 10 µm to 20 µm;
a half-height width of at least some of the ridges is greater than a half-height width of an adjacent groove;
within at least some regions in the non-smooth surface, a ratio of the average half-height width of the ridges to the average half-height width of the grooves is 1 to 6, further optionally 4 to 5;
within at least some regions in the non-smooth surface, a ratio of a sum of areas of half-height cross-sections of the ridges to a sum of areas of half-height cross-sections of the grooves is 1 to 36, further optionally 10 to 30;
within at least some regions in the non-smooth surface, a percentage of a sum of projected areas of the grooves along the longitudinal direction relative to a projected area of the non-smooth surface along the longitudinal direction is 5% to 95%, further optionally 10% to 50%; and
optionally, a projected area of at least some regions of the non-smooth surface along the longitudinal direction is greater than or equal to 0.1 mm², further optionally greater than or equal to 0.6 mm².

6. The tandem solar cell according to any one of claims 1 to 5, wherein an opening width of at least some of the grooves is greater than a bottom width thereof;
optionally, based on a proportion of the projected areas of the grooves along the longitudinal direction, an opening width of at least 50% of the grooves is greater than a bottom width thereof, and further optionally, an opening width of at least 80% of the grooves is greater than a bottom width thereof; and
optionally, based on a proportion of the projected areas of the grooves along the longitudinal direction, an opening width of at least some of the grooves is greater than a half-height width thereof, which in turn is greater than a bottom width thereof, further optionally, an opening width of at least 50% of the grooves is greater than a half-height width thereof, which in turn is greater than a bottom width thereof, and still further optionally, an opening width of at least 80% of the grooves is greater than a half-height width thereof, which in turn is greater than a bottom width thereof.

7. The tandem solar cell according to any one of claims 1 to 6, wherein a bottom width of at least some of the ridges is greater than a top width thereof;
optionally, based on a proportion of the projected areas of the ridges along the longitudinal direction, a bottom width of at least 50% of the ridges is greater than a top width thereof, and further optionally, a bottom width of at least 80% of the ridges is greater than a top width thereof; and
optionally, based on a proportion of the projected areas of the ridges along the longitudinal direction, a bottom width of at least some of the ridges is greater than a half-height width thereof, which in turn is greater than a top width thereof, further optionally, a bottom width of at least 50% of the ridges is greater than a half-height width thereof, which in turn is greater than a top width thereof, and still further optionally, a bottom width of at least 80% of the ridges is greater than a half-height width thereof, which in turn is greater than a top width thereof.

8. The tandem solar cell according to any one of claims 1 to 7, wherein the tandem solar cell satisfies one or more of the following features:
at least some of the grooves have a corner in an extending direction thereof;
at least some of the grooves have at least one segment of non-straight line in an extending direction thereof;
at least some of the grooves have an intersection node therebetween;
at least some of the ridges have a corner in an extending direction thereof;
at least some of the ridges have at least one segment of non-straight line in an extending direction thereof;
at least some of the ridges have an intersection node therebetween;
a deviation of a maximum width within an extending length of at least some of the grooves relative to an average width of the grooves does not exceed 30%;
a deviation of a maximum width within an extending length of at least some of the ridges relative to an average width of the ridges does not exceed 30%;
an extending length of at least some of the grooves is greater than or equal to 50 µm;
an extending length of at least some of the ridges is greater than or equal to 50 µm;
a length-to-width ratio of at least some of the grooves is greater than or equal to 2, and optionally, a length-to-width ratio of at least some of the grooves is greater than or equal to 5;
a length-to-width ratio of at least some of the grooves is 1 to 10, optionally 5 to 10;
a length-to-width ratio of at least some of the ridges is greater than or equal to 2, and optionally, a length-to-width ratio of at least some of the ridges is greater than or equal to 5; and
a length-to-width ratio of at least some of the ridges is 1 to 20, optionally 10 to 20.

9. The tandem solar cell according to any one of claims 1 to 8, wherein the tandem solar cell satisfies one or more of the following features:
an angle between extending directions of at least some two adjacent grooves in an extending length region of at least 30 µm is less than or equal to 30°; and
an angle between extending directions of at least some two adjacent ridges in an extending length region of at least 30 µm is less than or equal to 30°.

10. The tandem solar cell according to claim 9, wherein the tandem solar cell satisfies one or more of the following features:
an angle between extending directions of at least some two adjacent grooves in an extending length of at least 30 µm is less than or equal to 15°, optionally, an angle between extending directions of at least some two adjacent grooves in an extending length of at least 50 µm is less than or equal to 15°, and further optionally, an angle between extending directions of at least some two adjacent grooves in an extending length of at least 80 µm is less than 15°;
an angle between extending directions of at least some two adjacent grooves in an extending length of at least 50 µm is less than or equal to 30°, and optionally, an angle between extending directions of at least some two adjacent grooves in an extending length of at least 80 µm is less than 30°;
an angle between extending directions of at least some two adjacent ridges in an extending length of at least 30 µm is less than or equal to 15°, optionally, an angle between extending directions of at least some two adjacent ridges in an extending length of at least 50 µm is less than or equal to 15°, and further optionally, an angle between extending directions of at least some two adjacent ridges in an extending length of at least 80 µm is less than 15°; and
an angle between extending directions of at least some two adjacent ridges in an extending length of at least 50 µm is less than or equal to 30°, and optionally, an angle between extending directions of at least some two adjacent ridges in an extending length of at least 80 µm is less than 30°.

11. The tandem solar cell according to any one of claims 1 to 10, wherein the band gap of the first perovskite layer is greater than the band gap of the second perovskite layer; and
optionally, the band gap of the first perovskite layer is 1.2 eV to 2.4 eV, optionally 1.6 eV to 2.3 eV, and the band gap of the second perovskite layer is 1.0 eV to 1.4 eV.

12. The tandem solar cell according to any one of claims 1 to 11, wherein the first perovskite layer comprises a first perovskite-type metal halide, a halogen in the first perovskite-type metal halide comprises bromine and iodine, and optionally, the halogen in the first perovskite-type metal halide is a combination of bromine and iodine; and
optionally, the second perovskite layer comprises a second perovskite-type metal halide, a halogen in the second perovskite-type metal halide comprises iodine, and further optionally, the halogen in the second perovskite-type metal halide is iodine.

13. The tandem solar cell according to claim 12, wherein an atomic molar ratio of bromine to iodine in the first perovskite-type metal halide is (3-y):y, wherein 0<y≤2, and optionally, 1≤y≤2.

14. The tandem solar cell according to any one of claims 1 to 13, wherein at least some perovskite grains in the first perovskite layer are through-type grains, and both ends of the through-type grains along the longitudinal direction are located on surfaces of two sides of the first perovskite layer respectively.

15. The tandem solar cell according to claim 14, wherein a lateral dimension of at least some of the through-type grains is greater than or equal to 500 nm, wherein a lateral direction is orthogonal to the longitudinal direction, and the lateral dimension of the through-type grains refers to a maximum dimension among dimensions in all directions of the grains in a lateral cross-section;
optionally, a lateral dimension of at least some of the through-type grains is greater than or equal to 400 nm, optionally greater than or equal to 500 nm; and
optionally, an average lateral dimension of the through-type grains is 300 nm to 2 µm, optionally 400 nm to 1 µm, and further optionally 500 nm to 800 nm.

16. The tandem solar cell according to claim 14 or 15, wherein in a longitudinal cross-section of the first perovskite layer, an area percentage of the through-type grains relative to the longitudinal cross-section is greater than or equal to 80%, optionally greater than or equal to 90%.

17. The tandem solar cell according to any one of claims 14 to 16, wherein within at least some width regions of the longitudinal cross-section of the first perovskite layer, an area percentage of the through-type grains with a lateral dimension greater than or equal to 400 nm relative to the longitudinal cross-section is greater than or equal to 80%, optionally greater than or equal to 90%; and
optionally, at least some width regions of the longitudinal cross-section of the first perovskite layer correspond to a width region of at least 10 µm.

18. The tandem solar cell according to any one of claims 1 to 17, wherein the tandem solar cell satisfies one or more of the following features:
both the first carrier transport layer and the third carrier transport layer are electron transport layers, and both the second carrier transport layer and the fourth carrier transport layer are hole transport layers; or both the first carrier transport layer and the third carrier transport layer are hole transport layers, and both the second carrier transport layer and the fourth carrier transport layer are electron transport layers, wherein
the tandem solar cell further comprises a first electrode and a second electrode, the first electrode is located on a side of the first perovskite sub-cell away from the carrier recombination layer, the second electrode is located on a side of the second perovskite sub-cell away from the carrier recombination layer, and the first electrode is a transparent electrode;
at least one side of the first carrier transport layer comprises a heterogeneous carrier blocking layer;
at least one side of the second carrier transport layer comprises a heterogeneous carrier blocking layer;
at least one side of the third carrier transport layer comprises a heterogeneous carrier blocking layer; and
at least one side of the fourth carrier transport layer comprises a heterogeneous carrier blocking layer.

19. The tandem solar cell according to any one of claims 1 to 18, wherein the first perovskite sub-cell and the second perovskite sub-cell form a two-terminal integrated structure.

20. The tandem solar cell according to any one of claims 1 to 19, wherein the tandem solar cell is a two-terminal tandem solar cell.

21. The tandem solar cell according to any one of claims 1 to 20, wherein the tandem solar cell is an all-perovskite tandem solar cell.

22. A preparation method for a perovskite-based tandem solar cell according to any one of claims 1 to 21, comprising the following steps: sequentially stacking a first carrier transport layer, a first perovskite layer, a second carrier transport layer, a carrier recombination layer, a third carrier transport layer, a second perovskite layer, a fourth carrier transport layer, and a second electrode on a surface of one side of a first electrode, to obtain the perovskite-based tandem solar cell, wherein
a method for stacking the first perovskite layer on a side of the first carrier transport layer away from the first electrode comprises the following steps:
coating a precursor solution I of the first perovskite layer onto a surface of the side of the first carrier transport layer away from the first electrode, to form a coating layer I; and
performing vacuum flash evaporation treatment and annealing treatment on the coating layer I to form the first perovskite layer, with the non-smooth surface formed on the side of the first perovskite layer away from the first electrode.

23. The preparation method for a perovskite-based tandem solar cell according to claim 22, wherein the preparation method for a perovskite-based tandem solar cell satisfies one or more of the following features:
the vacuum flash evaporation treatment is performed under a negative pressure, wherein the negative pressure is less than or equal to 100 Pa, optionally 50 Pa to 100 Pa;
a temperature for the vacuum flash evaporation treatment is -10°C to 100°C, optionally 0°C to 30°C, and further optionally 20°C to 30°C;
a duration of the vacuum flash evaporation treatment is 10 s to 100 s, optionally 10 s to 30 s, and further optionally 15 s to 25 s;
the annealing treatment is performed using a hot stage, optionally a hot stage at 30°C to 200°C, further optionally a hot stage at 90°C to 110°C, and still further optionally a hot stage at 98°C to 102°C; and
an annealing duration of the annealing treatment is 30 s to 60 min, optionally 5 min to 20 min, and further optionally 14 min to 16 min.

24. The preparation method for a perovskite-based tandem solar cell according to claim 22 or 23, wherein the step of coating a precursor solution I of the first perovskite layer onto a surface of the side of the first carrier transport layer away from the first electrode comprises:
spin-coating a portion of the precursor solution I onto the surface of the side of the first carrier transport layer away from the first electrode at a first rotational speed; and
increasing a rotational speed from the first rotational speed to a second rotational speed, and continuing to spin-coat another portion of the precursor solution I at the second rotational speed, wherein
the second rotational speed is greater than the first rotational speed.

25. The preparation method for a perovskite-based tandem solar cell according to claim 24, wherein the preparation method satisfies one or more of the following features:
the first rotational speed is 1000 rpm to 6000 rpm, optionally 1000 rpm to 2000 rpm, and spin-coating is performed at the first rotational speed for 8 s to 12 s;
in the step of increasing the rotational speed from the first rotational speed to the second rotational speed, an acceleration is 200 rpm/s to 2000 rpm/s, optionally 800 rpm/s to 1200 rpm/s; and
the second rotational speed is 3000 rpm to 4500 rpm, optionally 3800 rpm to 4200 rpm, and spin-coating is performed at the second rotational speed for 18 s to 22 s.

26. A power consuming apparatus, comprising at least one of the perovskite-based tandem solar cell according to any one of claims 1 to 21 and the perovskite-based tandem solar cell prepared using the preparation method for a perovskite-based tandem solar cell according to any one of claims 22 to 25.
